(19) **Europäisches Patentamt / European Patent Office / Office européen des brevets**

(11) **EP 4 149 118 A1**

(12) ## EUROPEAN PATENT APPLICATION
published in accordance with Art. 153(4) EPC

(43) Date of publication:
**15.03.2023 Bulletin 2023/11**

(21) Application number: **21799530.7**

(22) Date of filing: **19.04.2021**

(51) International Patent Classification (IPC):
**H04R 17/00** *(2006.01)*     **H01L 41/09** *(2006.01)*
**H01L 41/18** *(2006.01)*

(52) Cooperative Patent Classification (CPC):
**H04R 17/005; H10N 30/50; H10N 30/852;
H10N 30/875;** H10N 30/05

(86) International application number:
**PCT/JP2021/015843**

(87) International publication number:
**WO 2021/225071 (11.11.2021 Gazette 2021/45)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.05.2020   JP 2020082135
13.04.2021   JP 2021067879**

(71) Applicant: **FUJIFILM Corporation
Tokyo 106-8620 (JP)**

(72) Inventors:
• **OHARA Naohiro
  Minamiashigara-shi, Kanagawa 250-0193 (JP)**
• **OZAWA Eiki
  Minamiashigara-shi, Kanagawa 250-0193 (JP)**

(74) Representative: **Klunker IP
Patentanwälte PartG mbB
Destouchesstraße 68
80796 München (DE)**

(54) ## PIEZOELECTRIC ELEMENT AND PIEZOELECTRIC SPEAKER

(57)     An object of the present invention is to provide a piezoelectric element capable of improving the sound pressure particularly in a high frequency band by decreasing the impedance in a case of being used as an electroacoustic transducer or the like, and a piezoelectric speaker formed of a piezoelectric film. The object can be achieved by using a piezoelectric film in which a piezoelectric layer containing piezoelectric particles in a polymer matrix is sandwiched between electrode layers, a planar shape is a polygon, the piezoelectric film has a protruding portion protruding from a side of a polygon other that a shortest side, and the protruding portion is provided with connecting portions for connecting an external power supply and an electrode layer or identical connecting portions are provided in the vicinity of end portions on a side other than the shortest side.

FIG. 1

EP 4 149 118 A1

**Description**

**BACKGROUND OF THE INVENTION**

1. Field of the Invention

The present invention relates to a piezoelectric element and a piezoelectric speaker.

2. Description of the Related Art

So-called exciters (excitons), which vibrate articles as vibration plates to produce a sound in a case of being attached to various articles in a contact manner, are used in various applications.

For example, exciters can be attached to conference tables, whiteboards, screens, or the like to produce a sound in place of speakers during presentations, conference calls, and the like in an office. In a case of vehicles such as automobiles, a guide sound, a warning sound, music, and the like can be produced by attaching exciters to consoles, A-pillars, ceilings, or the like. In addition, in a case of automobiles with no engine sound, such as hybrid cars or electric automobiles, a vehicle approach notification sound can be produced from bumper or the like by attaching exciters to bumpers or the like.

As variable elements that generate vibration in such exciters, combinations of coils and magnets, vibration motors such as eccentric motors and linear resonance motors, and the like are known.

These variable elements are difficult to make thin. In particular, vibration motors have drawbacks such as the need to increase the mass in order to increase the vibration force, difficulty in frequency modulation for adjusting the degree of vibration, and the slow response speed.

A piezoelectric element obtained by laminating a plurality of piezoelectric films that are respectively formed by sandwiching a piezoelectric layer between electrode layers has been considered as an exciter capable of solving such a problem.

Suitable examples of such a piezoelectric film include a piezoelectric film (electroacoustic conversion film) described in JP2014-014063A. The piezoelectric film is a film including a piezoelectric layer (polymer-based piezoelectric composite material) formed by dispersing piezoelectric particles in a matrix consisting of a polymer material, electrode layers formed on both surfaces of the piezoelectric layer, and protective layers formed on the surfaces of the electrode layers.

**SUMMARY OF THE INVENTION**

In a piezoelectric element obtained by laminating such piezoelectric films, the piezoelectric element is attached to a vibration plate, and the vibration plate is bent by stretching and contracting the piezoelectric films. In this manner, a sound can be output by vibrating the vibration plate.

The piezoelectric film itself has a low rigidity. However, the rigidity of the entire element can be increased by laminating a plurality of piezoelectric films. Moreover, the laminate formed of piezoelectric films is extremely suitable from the viewpoint that a high electric field strength can be ensured without increasing the driving voltage.

The piezoelectric film described in JP2014-014063A is thin and has satisfactory flexibility and excellent piezoelectric characteristics. Therefore, in a case where a piezoelectric element obtained by laminating such piezoelectric films is used as an exciter, a speaker or the like having flexibility to be carried out by being rolled up can be realized by using, for example, an article having flexibility as a vibration plate.

Meanwhile, in order to output a sound with a satisfactory acoustic quality, it is necessary to improve the sound pressure in response to a wide frequency band. Further, it is necessary to make a sufficient amount of current flow into a piezoelectric layer in order to improve the sound pressure using a piezoelectric element obtained by laminating piezoelectric films.

Here, in order to make a sufficient amount of current flow into a piezoelectric layer, it is necessary to lower the impedance of the piezoelectric element. In a case where the impedance of the piezoelectric element is high, the amount of current flowing into the piezoelectric layer decreases, and the sound pressure in a high frequency band, particularly in a high frequency band of 15 kHz or greater decreases.

Here, according to the examination conducted by the present inventors, particularly in the piezoelectric element formed a piezoelectric film having a piezoelectric layer obtained by dispersing piezoelectric particles in a matrix that contains a polymer material as described in JP2014-014063A, in a case where a position for supplying power to electrode layers from an external power supply is inappropriate, the impedance is increased, and thus a sufficient amount of current cannot be made to flow into the piezoelectric layer.

An object of the present invention is to solve the above-described problems of the related art and to provide a piezoelectric element and a piezoelectric speaker formed of a piezoelectric film, which are capable of improving the sound pressure particularly in a high frequency band in a case of being used as an electroacoustic transducer or the like, by decreasing the impedance in the piezoelectric element formed of a piezoelectric film having a piezoelectric layer obtained by dispersing piezoelectric particles in a matrix that contains a polymer material.

In order to achieve the above-described object, the present invention has the following configurations.

[1] A piezoelectric element which is configured such that a plurality of layers of a piezoelectric film in which a piezoelectric layer containing piezoelectric particles in a matrix containing a polymer material is sandwiched between electrode layers are laminated and that adjacent layers of the piezoelectric film are bonded to each other with a bonding layer, in which a planar shape is a polygon, and the piezoelectric film has a protruding portion protruding from a side of a polygon other than a shortest side, and the protruding portion is provided with connecting portions for connecting an external power supply and the electrode layer.

[2] The piezoelectric element according to [1], in which the piezoelectric element has a plurality of the protruding portions, and the plurality of the protruding portions protrude from an identical side of the polygon.

[3] The piezoelectric element according to [1] or [2], in which the protruding portion protrudes from a longest side of the polygon.

[4] The piezoelectric element according to any one of [1] to [3], in which in a case where a capacitance of the piezoelectric film is defined as C [F], an impedance [$\Omega$] at a frequency F [Hz] is less than or equal to [1/(6.28 $\times$ F $\times$ C)] + 1.

[5] The piezoelectric element according to any one of [1] to [4], in which the plurality of layers of the piezoelectric film are laminated by folding the piezoelectric film once or more times.

[6] The piezoelectric element according to any one of [1] to [5], in which at least one layer of the piezoelectric film has a protective layer laminated on at least one of the electrode layers.

[7] A piezoelectric element comprising: a piezoelectric film in which a piezoelectric layer containing piezoelectric particles in a matrix containing a polymer material is sandwiched between electrode layers, in which a planar shape is a polygon, and the piezoelectric film has connecting portions for connecting an external power supply and the electrode layers at positions within an upper limit separation distance from end portions of a side of the polygon other than a shortest side, and the upper limit separation distance is 1/2.1 of a length of the shortest side of the polygon.

[8] The piezoelectric element according to [7], in which the piezoelectric element has connecting portions at positions within the upper limit separation distance from end portions of an identical side of the polygon.

[9] The piezoelectric element according to [8], in which the piezoelectric element has connecting portions at positions within the upper limit separation distance from end portions of a longest side of the polygon.

[10] The piezoelectric element according to any one of [7] to [9], in which in a case where a capacitance of the piezoelectric film is defined as C [F], an impedance [$\Omega$] at a frequency F [Hz] is less than or equal to [1/(6.28 $\times$ F $\times$ C)] + 1.

[11] The piezoelectric element according to any one of [7] to [10], in which a plurality of layers of the piezoelectric film are laminated.

[12] The piezoelectric element according to [12], in which a plurality of layers of the piezoelectric film are laminated by folding the piezoelectric film once or more times.

[13] The piezoelectric element according to [11] or [12], further comprising: a bonding layer that bonds adjacent layers of the piezoelectric film.

[14] The piezoelectric element according to any one of [7] to [13], in which at least one layer of the piezoelectric film has a protective layer laminated on at least one of the electrode layers.

[15] The piezoelectric element according to any one of [1] to [14], wherein the piezoelectric layer contains piezoelectric particles in a polymer material containing a cyanoethyl group.

[16] The piezoelectric film according to [15], in which the polymer material is cyanoethylated polyvinyl alcohol.

[17] A piezoelectric speaker comprising: a piezoelectric film in which a piezoelectric layer containing piezoelectric particles in a matrix that contains a polymer material is sandwiched between electrode layers and a planar shape is a polygon; a vibration plate; and a bonding layer bonding the piezoelectric film and the vibration plate to each other, in which the piezoelectric film has protruding portions protruding from a side of the polygon other than a shortest side, and connecting portions for connecting an external power supply and the electrode layer are provided in the protruding portions.

According to the present invention, it is possible to improve the sound pressure particularly in a high frequency band in a case of being used as an electroacoustic transducer or the like, by decreasing the impedance in a piezoelectric element and a piezoelectric speaker which are formed of a piezoelectric film having a piezoelectric layer obtained by dispersing piezoelectric particles in a matrix that contains a polymer material.

## BRIEF DESCRIPTION OF THE DRAWINGS

Fig. 1 is a view conceptually illustrating an example of a piezoelectric element according to a first aspect of the present invention.

Fig. 2 is a schematic perspective view illustrating the piezoelectric element illustrated in Fig. 1.

Fig. 3 is a schematic plan view illustrating the piezoelectric element illustrated in Fig. 1.

Fig. 4 is a view conceptually illustrating an example of a piezoelectric film constituting the piezoelectric element illustrated in Fig. 4.

Fig. 5 is a conceptual view for describing an example of a method of preparing a piezoelectric film.

Fig. 6 is a conceptual view for describing an example of a method of preparing a piezoelectric film.

Fig. 7 is a conceptual view for describing an example of a method of preparing a piezoelectric film.

Fig. 8 is a view conceptually illustrating an example of a connecting portion of the piezoelectric element of the present invention.

Fig. 9 is a view conceptually illustrating another example of a connecting portion of the piezoelectric element of the present invention.

Fig. 10 is a view conceptually illustrating still another example of the piezoelectric element of the present invention.

Fig. 11 is a perspective view conceptually illustrating even still another example of the piezoelectric element of the present invention.

Fig. 12 is a perspective view conceptually illustrating even still another example of the piezoelectric element of the present invention.

Fig. 13 is a view conceptually illustrating an example of a piezoelectric element according to a second aspect of the present invention.

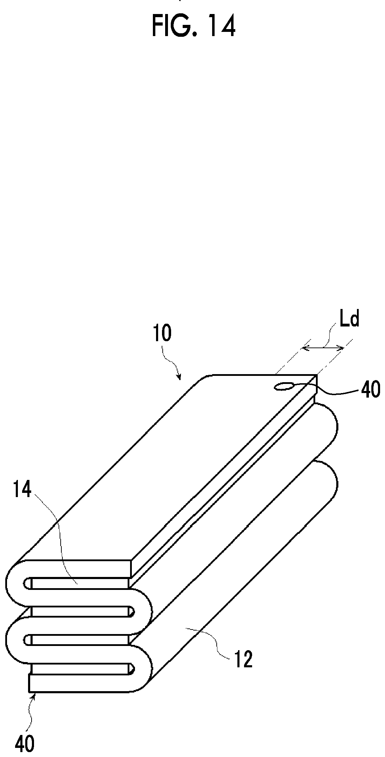

Fig. 14 is a perspective view conceptually illustrating another example of a piezoelectric element according to a second aspect of the present invention.

Fig. 15 is a conceptual view illustrating an example of an electroacoustic transducer using the piezoelectric element of the present invention.

Fig. 16 is a conceptual view illustrating a piezoelectric speaker formed of the piezoelectric element according to the second aspect of the present invention.

Fig. 17 is a partially enlarged view for describing another example of the piezoelectric element of the present invention.

Fig. 18 is a conceptual view for describing an example of the present invention.

Fig. 19 is a conceptual view for describing a comparative example of the present invention.

Fig. 20 is a conceptual view for describing a comparative example of the present invention.

Fig. 21 is a conceptual view for describing an example of the present invention.

Fig. 22 is a conceptual view for describing an example of the present invention.

Fig. 23 is a conceptual view for describing a lead-out wire in the piezoelectric element of the present invention.

Fig. 24 is a view conceptually illustrating another example of a connecting portion of the piezoelectric element of the present invention.

Fig. 25 is a view conceptually illustrating still another example of a connecting portion of the piezoelectric element of the present invention.

Fig. 26 is a view conceptually illustrating even still another example of a connecting portion of the piezoelectric element of the present invention.

Fig. 27 is a view conceptually illustrating even still another example of a connecting portion of the piezoelectric element of the present invention.

Fig. 28 is a view conceptually illustrating even still another example of a connecting portion of the piezoelectric element of the present invention.

Fig. 29 is a view conceptually illustrating even still another example of a connecting portion of the piezoelectric element of the present invention.

Fig. 30 is a view conceptually illustrating even still another example of a connecting portion of the piezoelectric element of the present invention.

Fig. 31 is a view conceptually illustrating an example of a piezoelectric speaker of the present invention.

Fig. 32 is a conceptual view for describing an example of the present invention.

Fig. 33 is a conceptual view for describing an example of the present invention.

Fig. 34 is a conceptual view for describing a comparative example of the present invention.

Fig. 35 is a conceptual view for describing an example of the present invention.

Fig. 36 is a conceptual view for describing a comparative example of the present invention.

Fig. 37 is a conceptual view for describing an example of the present invention.

Fig. 38 is a conceptual view for describing a comparative example of the present invention.

Fig. 39 is a conceptual view for describing another example of a piezoelectric element.

Fig. 40 is a conceptual view for describing still another example of a piezoelectric element.

Fig. 41 is a conceptual view for describing even still another example of a piezoelectric element.

Fig. 42 is a conceptual view for describing even still another example of a piezoelectric element.

Fig. 43 is a conceptual view for describing even still another example of a piezoelectric element.

Fig. 44 is a conceptual view for describing another example of an electroacoustic transducer formed of a piezoelectric element.

Fig. 45 is a conceptual view for describing still another example of an electroacoustic transducer formed of a piezoelectric element.

Fig. 46 is a conceptual view for describing even still another example of an electroacoustic transducer formed of a piezoelectric element.

Fig. 47 is a conceptual view for describing even still another example of an electroacoustic transducer formed of a piezoelectric element.

Fig. 48 is a conceptual view for describing even still another example of an electroacoustic transducer formed of a piezoelectric element.

Fig. 49 is a conceptual view for describing even still another example of an electroacoustic transducer formed of a piezoelectric element.

Fig. 50 is a conceptual view for describing an example of a bonding layer in an electroacoustic transducer formed of a piezoelectric element.

Fig. 51 is a conceptual view for describing another example of a bonding layer in an electroacoustic transducer formed of a piezoelectric element.

Fig. 52 is a conceptual view for describing another example of an electroacoustic transducer formed of a piezoelectric element.

Fig. 53 is a conceptual view for describing still another example of an electroacoustic transducer formed of a piezoelectric element.

Fig. 54 is a conceptual view for describing even still another example of an electroacoustic transducer formed of a piezoelectric element.

Fig. 55 is a conceptual view for describing an example of the present invention.

## DESCRIPTION OF THE PREFERRED EMBODIMENTS

Hereinafter, an piezoelectric element and a piezoelectric speaker according to the embodiment of the present invention will be described in detail based on preferred embodiments illustrated in the accompanying drawings.

Descriptions of the configuration requirements described below may be made based on representative embodiments of the present invention, but the present invention is not limited to such embodiments.

In the present specification, a numerical range shown using "to" indicates a range including numerical values described before and after "to" as a lower limit and an upper limit.

Further, all the drawings described below are conceptual views for describing the present invention. Therefore, the size, the thickness, the positional relationship, and the like of each component differ from the actual ones.

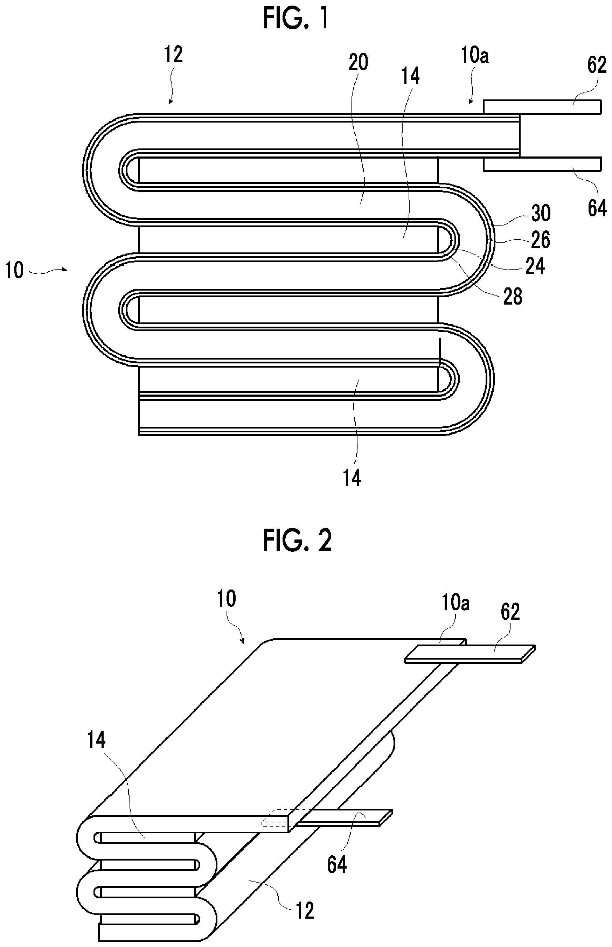

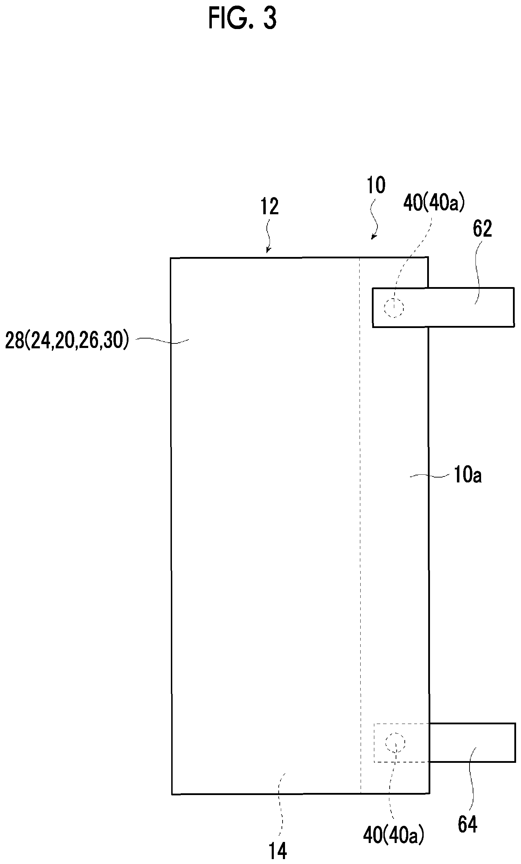

Fig. 1 conceptually illustrates an example of a first aspect of a piezoelectric element of the present invention. Fig. 2 is a perspective view conceptually illustrating the piezoelectric element illustrated in Fig. 1, and Fig. 3 is a plan view conceptually illustrating the piezoelectric element illustrated in Fig. 1.

A piezoelectric element 10 illustrated in Figs. 1 to 3 is obtained by folding one piezoelectric film 12 four times so that five layers of the piezoelectric film 12 are laminated. That is, the piezoelectric element 10 is a laminated piezoelectric element in which five layers of the piezoelectric film 12 are laminated.

In Fig. 2, even though not illustrated for the purpose of simplifying the drawing and clearly illustrating the configuration of the piezoelectric element 10, the piezoelectric film 12 includes electrode layers on both surfaces of a piezoelectric layer 20, and protective layers covering both electrode layers.

As will be described in detail below, the piezoelectric element according to the embodiment of the present invention has a polygonal planar shape.

In a case of a piezoelectric element obtained by laminating a plurality of layers of the piezoelectric film 12 as the piezoelectric element illustrated in Figs. 1 to 3, the planar shape denotes a shape of the piezoelectric element as viewed in a lamination direction of the piezoelectric film 12. Hereinafter, the state viewed in this direction will also be referred to as "plan view".

Therefore, the planar shape of the piezoelectric element 10 is a shape as viewed from above (or from below) in Fig. 1 as in a case of the piezoelectric element 10 illustrated in Figs. 1 to 3, and the shape of the plan view illustrated in Fig. 3 is the planar shape of the piezoelectric element 10. Further, in a case of a piezoelectric element having protruding portions for connecting an external power supply and electrode layers as in the case of the piezoelectric element 10 according to the first aspect of the present invention, the planar shape thereof is a shape excluding protruding portions.

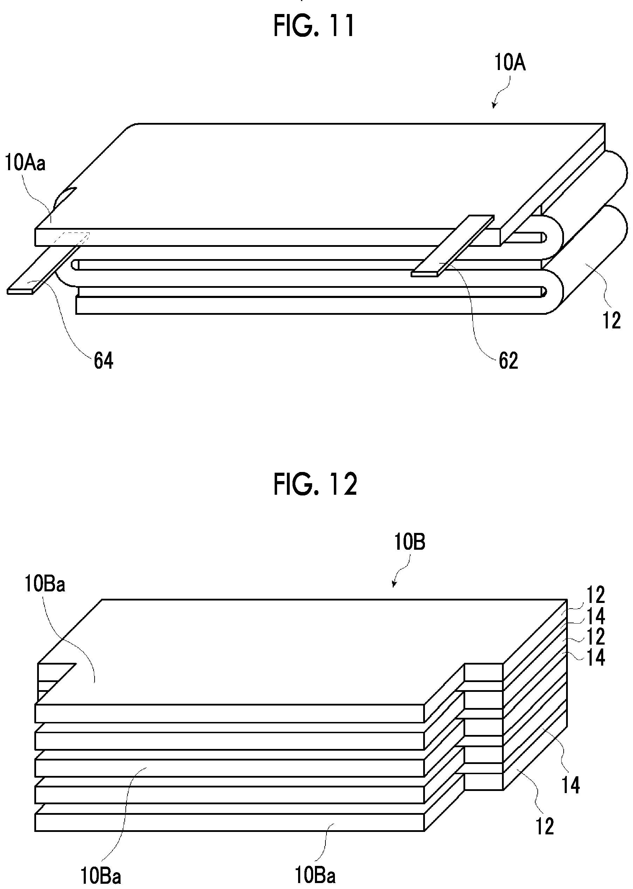

However, in a case of a piezoelectric element having only one layer of a piezoelectric film without laminating the piezoelectric film 12, as in an example of the second aspect described below, the shape of the main surface of the piezoelectric film is the planar shape of the piezoelectric element. Further, even in a case where a plurality of sheets of the piezoelectric films 12 are laminated as in the configuration illustrated in Fig. 12 described below, the shape of the main surface of each piezoelectric film is regarded as the planar shape. In this regard, the same applies to the piezoelectric film 12 of the piezoelectric speaker according to the embodiment of the present invention. Further, the main surface is the maximum surface of a sheet-like material (a film, a plate-like material, or a layer).

The piezoelectric element 10 illustrated in Figs. 1 to 3 has a rectangular (square) planar shape.

In the present invention, the planar shape of the piezoelectric element is not limited to a rectangle, and various polygonal shapes such as a triangle, a pentagon, a hexagon, and the like can be used.

In the first aspect of the piezoelectric element of the present invention, the piezoelectric element has protruding portions having a polygonal shape as the planar shape and protruding from a side other than the shortest side. Since the piezoelectric element 10 has a rectangular planar shape, the piezoelectric element 10 has two long sides with an identical length and two short sides with an identical length. Therefore, the piezoelectric element 10 has protruding portions 10a so as to protrude from the long sides of the rectangle. Since the piezoelectric element 10 is provided with the protruding portions 10a protruding from the long sides of the rectangle and the connecting portions for connecting the external power supply to the protruding portions 10a, the impedance can be decreased, and the sound pressure particularly in a high frequency band can be improved in a case of where the piezoelectric element is used as an electroacoustic transducer or the like. The details thereof will be described below.

The piezoelectric element 10 illustrated in Figs. 1 to 3 is formed by folding the piezoelectric film 12 four times so that five layers of the piezoelectric film 12 are laminated, but the present invention is not limited thereto.

That is, the piezoelectric element according to the embodiment of the present invention may be formed by folding the piezoelectric film 12 three or less times so that two to four layers of the piezoelectric film 12 are laminated. Alternatively, the piezoelectric element according to the embodiment of the present invention may be formed by folding the piezoelectric film 12 five or more times so that six or more layers of the piezoelectric film 12 are laminated.

It is preferable that the piezoelectric element according to the embodiment of the present invention is formed by folding the piezoelectric film 12 twice or more times so that three or more layers of the piezoelectric film 12 are laminated.

Further, the piezoelectric element according to the embodiment of the present invention may be formed by folding the piezoelectric film 12 once or more times and laminating a plurality of layers of the piezoelectric film 12.

Further, the configuration of the piezoelectric element according to the embodiment of the present invention in which a plurality of the piezoelectric film 12 are laminated is not limited to the configuration in which the piezoelectric film 12 is folded and laminated.

That is, both the first aspect and the second aspect of the piezoelectric element according to the embodiment of the present invention may be configurations in which a plurality of layers of cut sheet-like piezoelectric films 12 are laminated so that a plurality of layers of the piezoelectric films 12 are laminated.

Further, the piezoelectric element according to the second aspect of the present invention described below, which does not have protruding portions provided to have connecting portions for connection with an external power supply, may be formed of one sheet of piezoelectric film that is not laminated. The details thereof will be described below.

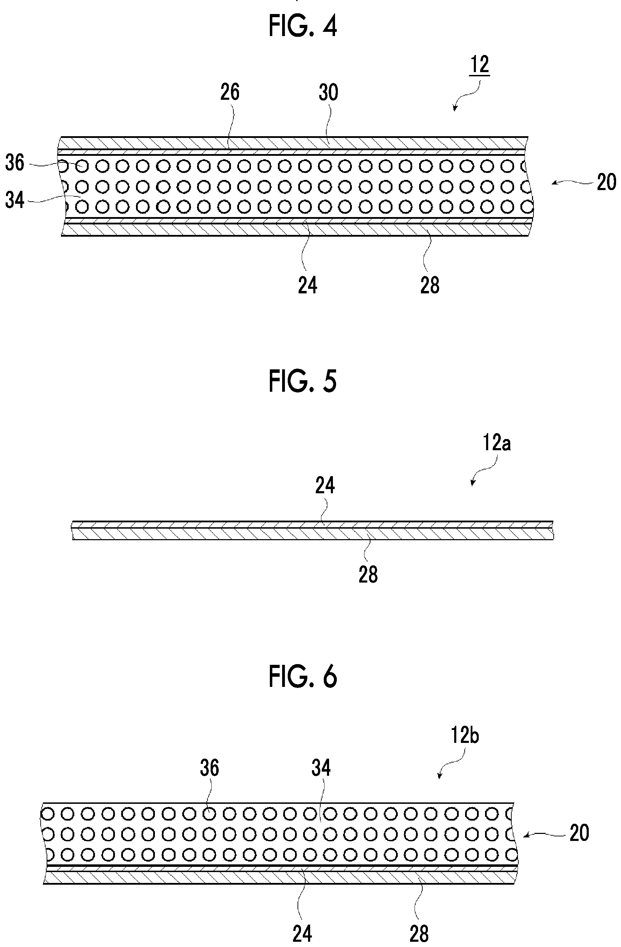

Fig. 4 is a cross-sectional view conceptually illustrating the piezoelectric film 12.

As illustrated in Fig. 4, the piezoelectric film 12 includes a piezoelectric layer 20 which is a sheet-like material having piezoelectric properties, a lower thin film electrode 24 laminated on one surface of the piezoelectric layer 20, a first protective layer 28 laminated on the first thin film electrode 24, a second thin film electrode 26 laminated on the other surface of the piezoelectric layer 20, and a second protective layer 30 laminated on the second thin film electrode 26. As will be described below, the piezoelectric film 12 is polarized in a thickness direction.

Further, the piezoelectric layer 20, the first thin film electrode 24, the second thin film electrode 26, the first protective layer 28, and the second protective layer 30 The two protective layers 30 are not illustrated separately for the purpose of simplifying the drawing and clearly illustrating the configuration of the piezoelectric element 10.

The piezoelectric layer 20 in the piezoelectric film 12 consists of a polymer-based piezoelectric composite material formed by dispersing piezoelectric particles 36 in a matrix 34 containing a polymer material as conceptually illustrated in Fig. 4. The matrix 34 preferably contains a polymer material having a viscoelasticity at room temperature and more preferably consists of a polymer material having a viscoelasticity at room temperature. That is, it is preferable that the matrix 34 is a viscoelastic matrix that has a viscoelasticity at room temperature.

Further, in the present invention, the term "room temperature" denotes a temperature range of approximately 0°C to 50°C.

Here, it is preferable that the polymer-based piezoelectric composite material (piezoelectric layer 20) satisfies the following requirements.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relieved. Therefore, the polymer-based piezoelectric composite material is required to have a suitably large loss tangent.

That is, the flexible polymer-based piezoelectric composite material used as an exciter and an electroacoustic conversion film is required to exhibit a behavior of being rigid with respect to a vibration of 20 Hz to 20 kHz and being flexible with respect to a vibration of less than or equal to a few Hz. In addition, the loss tangent of a polymer-based piezoelectric composite material is required to be suitably large with respect to the vibration of all frequencies of 20 kHz or less.

Furthermore, it is preferable that the spring constant can be easily adjusted by laminating the polymer-based piezoelectric composite material on a mating material (vibration plate) to be attached according to the rigidity of the mating material. Here, the energy efficiency can increase as the thickness of the bonding layer 14 decreases. The term rigidity denotes, for example, the hardness, the stiffness, and the spring constant.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

The polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature as a matrix of the polymer-based piezoelectric composite material (piezoelectric layer 20). In particular, from the viewpoint that such a behavior is suitably exhibited, it is preferable that a polymer material in which the glass transition temperature at a frequency of 1 Hz is at room temperature, that is, in a range of 0°C to 50°C is used for a matrix of the polymer-based piezoelectric composite material.

Further, the polymer material having a glass transition point at room temperature is, that is, a polymer material having a viscoelasticity at room temperature.

As the polymer material having a viscoelasticity at room temperature, various known materials can be used. It is preferable that a polymer material in which the maximal value of a loss tangent Tan $\delta$ at a frequency of 1 Hz according to a dynamic viscoelasticity test at room temperature, that is, in a range of 0°C to 50° is 0.5 or greater is used as the polymer material.

In this manner, in a case where the polymer-based piezoelectric composite material is slowly bent due to an external force, stress concentration on the interface between the polymer matrix and the piezoelectric particles at the maximum bending moment portion is relieved, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative dielectric constant of the polymer material is 10 or less at 25°C.

Examples of the polymer material having a viscoelasticity at room temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material.

Further, these polymer materials may be used alone or in combination (mixture) of a plurality of kinds thereof.

In the matrix 34 for which such a polymer material having a viscoelasticity at room temperature is used, a plurality of polymer materials may be used in combination as necessary.

That is, for the purpose of adjusting dielectric properties, mechanical properties, and the like, other dielectric polymer materials may be added to the matrix 34 in addition to the polymer material having a viscoelasticity at room temperature, such as cyanoethylated PVA, as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, the number of kinds of the dielectric polymer materials to be added to the matrix 34 of the piezoelectric layer 20 in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 34 in addition to the dielectric polymer materials.

Further, for the purpose of improving the pressure sensitive adhesiveness, a viscosity imparting agent such as rosin ester, rosin, terpene, terpene phenol, or a petroleum resin may be added.

The addition amount of materials to be added to the matrix 34 of the piezoelectric layer 20 other than the polymer material having a viscoelasticity at room temperature such as cyanoethylated PVA is not particularly limited, but is preferably set to 30% by mass or less in terms of the proportion of the materials in the matrix 34.

In this manner, the characteristics of the polymer material to be added can be exhibited without impairing the viscoelasticity relieving mechanism in the matrix 34, and thus preferable results, for example, an increase in the dielectric constant, improvement of the heat resistance, and improvement of the adhesiveness between the piezoelectric particles 36 and the electrode layer can be obtained.

Known particles can be used as the piezoelectric particles 36, but it is preferable that the piezoelectric particles 36 consist of ceramic particles having a perovskite type or wurtzite type crystal structure.

As the ceramics particles forming the piezoelectric particles 36, for example, lead zirconate titanate (PZT), lead lanthanum zirconate titanate (PLZT), barium titanate ($BaTiO_3$), zinc oxide (ZnO), and a solid solution (BFBT) of barium titanate and bismuth ferrite (BiFes) are exemplified.

The particle diameter of such piezoelectric particles 36 is not limited, and may be appropriately selected depending on the size of the piezoelectric film 12, the applications of the piezoelectric element 10, and the like. The particle diameter of the piezoelectric particles 36 is preferably in a range of 1 to 10 $\mu$m.

By setting the particle diameter of the piezoelectric particles 36 to be in the above-described range, preferable results in terms of achieving both excellent piezoelectric characteristics and flexibility of the piezoelectric film 12 can be obtained.

In Fig. 4, the piezoelectric particles 36 in the piezoelectric layer 20 are uniformly dispersed in the matrix 34 with regularity, but the present invention is not limited thereto.

That is, the piezoelectric particles 36 in the piezoelectric layer 20 may be irregularly dispersed in the matrix 34 as long as the piezoelectric particles 36 are preferably uniformly dispersed therein.

Further, the particle diameter of the piezoelectric particles 36 may or may not be uniform.

In the piezoelectric film 12, the ratio between the amount of the matrix 34 and the amount of the piezoelectric particles 36 in the piezoelectric layer 20 is not limited and may be appropriately set according to the size and the thickness of the piezoelectric film 12 in the plane direction, the applications of the piezoelectric element 10, the characteristics required for the piezoelectric film 12, and the like.

The volume fraction of the piezoelectric particles 36 in the piezoelectric layer 20 is preferably in a range of 30% to 80%, more preferably 50% or greater, and still more preferably in a range of 50% to 80%.

By setting the ratio between the amount of the matrix 34 and the amount of the piezoelectric particles 36 to be in the above-described ranges, preferable results in terms of achieving both of excellent piezoelectric characteristics and flexibility can be obtained.

In the piezoelectric film 12, the thickness of the piezoelectric layer 20 is not particularly limited and may be appropriately set according to the applications of the piezoelectric element 10, the number of times of lamination of the piezoelectric film in the piezoelectric element 10, and the characteristics required for the piezoelectric film 12, and the like.

It is advantageous that the thickness of the piezoelectric layer 20 increases in terms of the rigidity such as the strength of stiffness of a so-called sheet-like material, but the voltage (potential difference) required to stretch and contract the piezoelectric film 12 by the same amount increases.

The thickness of the piezoelectric layer 20 is preferably in a range of 8 to 300 $\mu$m, more preferably in a range of 8 to 200 $\mu$m, still more preferably in a range of 10 to 150 $\mu$m, and particularly preferably in a range of 15 to 100 $\mu$m.

By setting the thickness of the piezoelectric layer 20 to be in the above-described range, preferable results in terms of achieving both ensuring of the rigidity and moderate elasticity can be obtained.

It is preferable that the piezoelectric layer 20 is subjected to a polarization treatment (poling) in the thickness direction. The polarization treatment will be described in detail later.

As illustrated in Fig. 4, the piezoelectric film 12 of the illustrated example has a configuration in which the first thin film electrode 24 is provided on one surface of the piezoelectric layer 20, the first protective layer 28 is provided on the surface thereof, the second thin film electrode 26 is provided on the other surface of the piezoelectric layer 20, and the second protective layer 30 is provided on the surface thereof. Here, the first thin film electrode 24 and the second thin film electrode 26 form an electrode pair.

Further, in addition to the above-described layers, the piezoelectric film 12 may have an insulating layer which covers a region where the piezoelectric layer 20 is exposed for preventing a short circuit or the like.

That is, the piezoelectric film 12 has a configuration in which both surfaces of the piezoelectric layer 20 are sandwiched between the electrode pair, that is, the first thin film electrode 24 and the second thin film electrode 26, and the laminate is further sandwiched between the first protective layer 28 and the second protective layer 30.

As described above, in the piezoelectric film 12, the region sandwiched between the first thin film electrode 24 and the second thin film electrode 26 is stretched and contracted according to an applied voltage.

In the present invention, the terms "first" and "second" in the first thin film electrode 24 and the first protective layer 28, and the second thin film electrode 26 and the second protective layer 30 are provided based on the accompanying drawings for convenience in order to describe the piezoelectric film 12. Therefore, the terms "first" and "second" in the piezoelectric film 12 have no technical meaning and are irrelevant to the actual use state.

The first protective layer 28 and the second protective layer 30 in the piezoelectric film 12 have a function of covering the first thin film electrode 24 and the second thin film electrode 26 and applying moderate rigidity and mechanical strength to the piezoelectric layer 20. That is, the piezoelectric layer 20 consisting of the matrix 34 and the piezoelectric particles 36 in the piezoelectric film 12 exhibits extremely excellent flexibility under bending deformation at a slow vibration, but may have insufficient rigidity or mechanical strength depending on the applications. As a compensation for this, the piezoelectric film 12 is provided with the first protective layer 28 and the second protective layer 30.

Further, the first protective layer 28 and the second protective layer 30 of the piezoelectric film 12 are not essential configuration requirements in the piezoelectric element of the present invention. Therefore, the piezoelectric film 12 may have any one of the first protective layer 28 or the second protective layer 30 or may have no protective layer.

However, from the viewpoints of the strength of the piezoelectric film 12 (piezoelectric element), the protection of the thin film electrodes and the piezoelectric layer, and the like, the piezoelectric film 12 has preferably at least one protective layer and preferably both the first protective layer 28 and the second protective layer 30.

The first protective layer 28 and the second protective layer 30 are not limited, and various sheet-like materials can be used, and suitable examples thereof include various resin films.

Among these, from the viewpoints of excellent mechanical characteristics and heat resistance, a resin film consisting of polyethylene terephthalate (PET), polypropylene (PP), polystyrene (PS), polycarbonate (PC), polyphenylene sulfide (PPS), polymethylmethacrylate (PMMA), polyetherimide (PEI), polyimide (PI), polyethylene naphthalate (PEN), triacetyl cellulose (TAC), and a cyclic olefin-based resin is suitably used.

The thickness of the first protective layer 28 and the second protective layer 30 is not limited. In addition, the thicknesses of the first protective layer 28 and the second protective layer 30 are basically the same as each other, but may be different from each other.

Here, in a case where the rigidity of the first protective layer 28 and the second protective layer 30 is extremely high, not only is the stretch and contraction of the piezoelectric layer 20 constrained, but also the flexibility is impaired. Therefore, it is advantageous that the thickness of the first protective layer 28 and the thickness of the second protective layer 30 decrease except for the case where the mechanical strength or satisfactory handleability as a sheet-like material is required.

In a case where the thickness of the first protective layer 28 and the second protective layer 30 in the piezoelectric film 12 is two times or less the thickness of the piezoelectric layer 20, preferable results in terms of achieving both ensuring of the rigidity and moderate elasticity can be obtained.

For example, in a case where the thickness of the piezoelectric layer 20 is 50 $\mu$m and the first protective layer 28 and the second protective layer 30 consist of PET, the thickness of the first protective layer 28 and the second protective layer 30 is preferably 100 $\mu$m or less, more preferably 50 $\mu$m or less, and still more preferably 25 $\mu$m or less.

In the piezoelectric film 12, the first thin film electrode 24 is formed between the piezoelectric layer 20 and the first protective layer 28, and the second thin film electrode 26 is formed between the piezoelectric layer 20 and the second protective layer 30. In the description below, the first thin film electrode 24 will also be referred to as the first electrode 24 and the second thin film electrode 26 will also be referred to as the second electrode 26.

The first electrode 24 and the second electrode 26 are provided to apply a voltage to the piezoelectric layer 20 (piezoelectric film 12).

In the present invention, the material for forming the first electrode 24 and the second electrode 26 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Among these, copper, aluminum, gold, silver, platinum, and indium tin oxide are suitable as the first electrode 24 and the second electrode 26.

In addition, the method of forming the first electrode 24 and the second electrode 26 is also not limited, and various known methods, for example, a film forming method such as a vapor-phase deposition method (vacuum film forming method) such as vacuum vapor deposition or sputtering, a film forming method using plating, and a method of bonding a foil formed of the materials described above can be used.

Among these, particularly from the viewpoint of ensuring the flexibility of the piezoelectric film 12, a thin film made of copper, aluminum, or the like formed by vacuum vapor deposition is suitably used as the first electrode 24 and the second electrode 26. Among these, particularly a thin film made of copper formed by vacuum vapor deposition is suitably used.

The thickness of the first electrode 24 and the thickness of the second electrode 26 are not limited. In addition, the thicknesses of the first electrode 24 and the second electrode 26 are basically the same as each other, but may be different from each other.

Here, similarly to the first protective layer 28 and the second protective layer 30 described above, in a case where the rigidity of the first electrode 24 and the second electrode 26 is extremely high, not only is the stretch and contraction of the piezoelectric layer 20 constrained, but also the flexibility is impaired. Therefore, it is advantageous that the thicknesses of the first electrode 24 and the second electrode 26 decrease in a case where the electrical resistance is not excessively high.

It is suitable that the product of the thickness and the Young's modulus of the first electrode 24 and the second electrode 26 of the piezoelectric film 12 is less than the product of the thickness and the Young's modulus of the first protective layer 28 and the second protective layer 30 from the viewpoint that the flexibility is not considerably impaired.

A combination of the first protective layer 28 and the second protective layer 30 which are formed of PET and a combination of the first electrode 24 and the second electrode 26 which are formed of copper may be considered as an example, In this combination, PET has a Young's modulus of approximately 6.2 GPa and copper has a Young's modulus of approximately 130 GPa. Therefore, in this case, in a case where the thickness of the first protective layer 28 and the second protective layer 30 is set to 25 $\mu$m, the thickness of the first electrode 24 and the second electrode 26 is preferably 1.2 $\mu$m or less, more preferably 0.3 $\mu$m or less, and still more preferably 0.1 $\mu$m or less.

As described above, the piezoelectric film 12 has a configuration in which the piezoelectric layer 20 formed by dispersing the piezoelectric particles 36 in the matrix 34 that contains the polymer material having a viscoelasticity at room temperature is sandwiched between the first electrode 24 and the second electrode 26 and this laminate is sandwiched between the first protective layer 28 and the second protective layer 30.

It is preferable that, in such a piezoelectric film 12, the maximal value of the loss tangent (tan $\delta$) at a frequency of 1 Hz according to dynamic viscoelasticity measurement is present at room temperature and more preferable that the maximal value at which the loss tangent is 0.1 or greater is present at room temperature.

In this manner, even in a case where the piezoelectric film 12 is subjected to bending deformation at a relatively slow vibration of less than or equal to a few Hz from the outside, since the strain energy can be effectively diffused to the outside as heat, occurrence of cracks on the interface between the polymer matrix and the piezoelectric particles can be prevented.

In the piezoelectric film 12, it is preferable that the storage elastic modulus (E') at a frequency of 1 Hz according to the dynamic viscoelasticity measurement is 10 to 30 GPa at 0°C and 1 to 10 GPa at 50°C.

In this manner, the piezoelectric film 12 may have large frequency dispersion in the storage elastic modulus (E') at room temperature. That is, the electroacoustic conversion film 10 can exhibit a behavior of being rigid with respect to a vibration of 20 Hz to 20 kHz and being flexible with respect to a vibration of less than or equal to a few Hz.

In the piezoelectric film 12, it is preferable that the product of the thickness and the storage elastic modulus (E') at a frequency of 1 Hz according to the dynamic viscoelasticity measurement is in a range of $1.0 \times 10^6$ to $2.0 \times 10^6$ N/m at 0°C and in a range of $1.0 \times 10^5$ to $1.0 \times 10^6$ N/m at 50°C.

In this manner, the piezoelectric film 12 may have moderate rigidity and mechanical strength within a range not impairing the flexibility and the acoustic characteristics.

Further, in the piezoelectric film 12, it is preferable that the loss tangent (Tan $\delta$) at a frequency of 1 kHz at 25°C is 0.05 or greater in a master curve obtained from the dynamic viscoelasticity measurement.

In this manner, the frequency of a speaker formed of the piezoelectric film 12 is smooth as the frequency characteristic thereof, and thus a change in acoustic quality in a case where the lowest resonance frequency $f_0$ is changed according to a change in the curvature of the speaker can be decreased.

Next, an example of the method of producing the piezoelectric film 12 illustrated in Fig. 4 will be described with reference to the conceptual views of Figs. 5 to 7.

First, as illustrated in Fig. 5, a sheet-like material 12a in which the first electrode 24 is formed on the first protective layer 28 is prepared. The sheet-like material 12a may be prepared by forming a copper thin film or the like as the first electrode 24 on the surface of the first protective layer 28 by carrying out vacuum vapor deposition, sputtering, plating, or the like.

In a case where the first protective layer 28 is extremely thin and thus the handleability is degraded, the first protective layer 28 with a separator (temporary support) may be used as necessary. Further, a PET having a thickness of 25 $\mu$m to 100 $\mu$m or the like can be used as the separator. The separator may be removed after thermal compression bonding of the second electrode 26 and the second protective layer 30 and before lamination of any member on the first protective layer 28.

Meanwhile, the coating material is prepared by dissolving a polymer material having a viscoelasticity at room temperature, such as cyanoethylated PVA, in an organic solvent, adding the piezoelectric particles 36 such as PZT particles thereto, and stirring the solution for dispersion. In the following description, the polymer material having a viscoelasticity at room temperature, such as cyanoethylated PVA, will also be referred to as "viscoelastic material".

The organic solvent is not limited, and various organic solvents such as dimethylformamide (DMF), methyl ethyl ketone, and cyclohexanone can be used.

In a case where the sheet-like material 12a is prepared and the coating material is prepared, the coating material is cast (applied) onto the sheet-like material 12a, and the organic solvent is evaporated and dried. In this manner, as illustrated in Fig. 6, a laminate 12b in which the first electrode 24 is provided on the first protective layer 28 and the piezoelectric layer 20 is formed on the first electrode 24 is prepared. Further, the first electrode 24 denotes an electrode on the base material side in a case where the piezoelectric layer 20 is applied, and does not denote the vertical positional relationship in the laminate.

A casting method of the coating material is not particularly limited, and all known coating methods (coating devices) such as a slide coater and a doctor knife can be used.

Further, in a case where the viscoelastic material is a material that can be heated and melted, such as cyanoethylated PVA, a laminate 12b may be prepared by the following method. First, the viscoelastic material is heated and melted to prepare a melt obtained by adding the piezoelectric particles 36 to the melt to be dispersed therein. The melt is extruded on the sheet-like material 12a illustrated in Fig. 5 in a sheet shape by carrying out extrusion molding or the like, and the laminate is cooled. In this manner, as illustrated in Fig. 6, the laminate 12b in which the first electrode 24 is provided on the first protective layer 28 and the piezoelectric layer 20 is formed on the first electrode 24 can be prepared.

As described above, in the piezoelectric film 12, a polymer piezoelectric material such as PVDF may be added to the matrix 34 in addition to the viscoelastic material such as cyanoethylated PVA.

In a case where the polymer piezoelectric material is added to the matrix 34, the polymer piezoelectric material to be added to the coating material may be dissolved. Alternatively, the polymer piezoelectric material to be added may be added to the heated and melted viscoelastic material so that the polymer piezoelectric material is heated and melted.

In a case where the laminate 12b in which the first electrode 24 is provided on the first protective layer 28 and the piezoelectric layer 20 is formed on the first electrode 24 is prepared, the piezoelectric layer 20 is subjected to a polarization treatment (poling).

A method of performing the polarization treatment on the piezoelectric layer 20 is not limited, and a known method can be used. For example, electric field poling in which a DC electric field is directly applied to a target to be subjected to the polarization treatment is exemplified. Further, in a case of performing electric field poling, the electric field poling treatment may be performed using the first electrode 24 and the second electrode 26 by forming the first electrode 24 before the polarization treatment.

Further, in a case where the piezoelectric film 12 according to the embodiment of the present invention is produced, it is preferable that the polarization treatment is performed in the thickness direction of the piezoelectric layer 20 instead of the plane direction.

Before the polarization treatment, a calender treatment may be performed to smoothen the surface of the piezoelectric layer 20 using a heating roller or the like. By performing the calender treatment, a thermal compression bonding step described below can be smoothly performed.

In this manner, while the piezoelectric layer 20 of the laminate 12b is subjected to the polarization treatment, a sheet-like material 12c in which the second electrode 26 is formed on the second protective layer 30 is prepared. The sheet-like material 12c may be prepared by forming a copper thin film or the like as the second electrode 26 on the surface of the second protective layer 30 using vacuum vapor deposition, sputtering, plating, or the like.

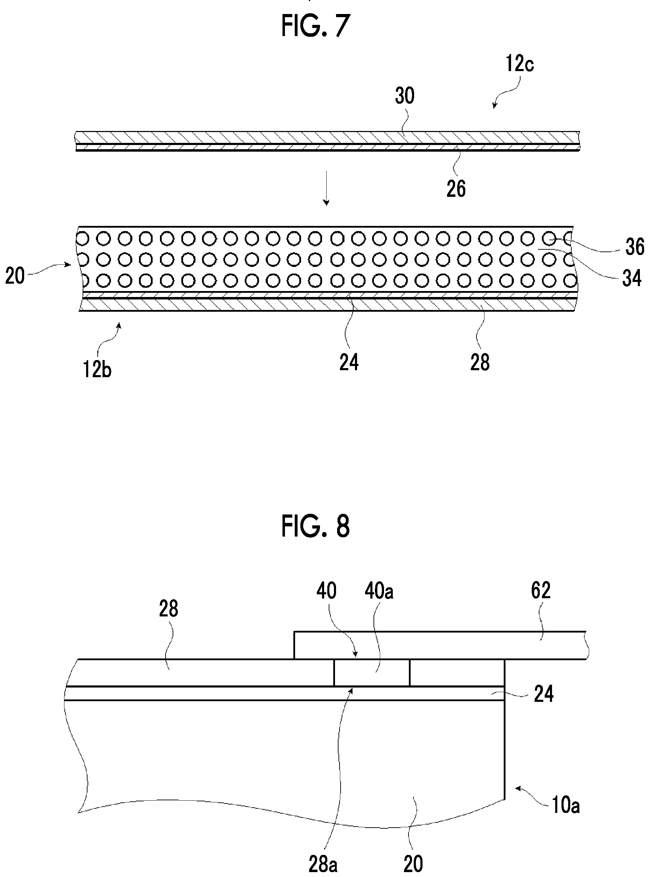

Next, as illustrated in Fig. 7, the sheet-like material 12c is laminated on the laminate 12b in which the polarization treatment performed on the piezoelectric layer 20 is completed in a state where the second electrode 26 is directed toward the piezoelectric layer 20.

Further, a laminate of the laminate 12b and the sheet-like material 12c is subjected to the thermal compression bonding using a heating press device, a pair of heating rollers, or the like such that the second protective layer 30 and the first protective layer 28 are sandwiched between the laminate 12b and the sheet-like material 12c, thereby preparing the piezoelectric film 12.

The piezoelectric element 10 according to the embodiment of the present invention is folded so that a plurality of layers of the piezoelectric film 12 are laminated. The piezoelectric element 10 has a configuration in which adjacent layers of the piezoelectric film 12 laminated by folding the piezoelectric film 12 are bonded with the bonding layer 14 (bonding agent).

In the present invention, various known layers can be used as the bonding layer 14 as long as the adjacent layers of the piezoelectric film 12 can be bonded to each other.

Therefore, the bonding layer 14 may be a layer consisting of an adhesive, a layer consisting of a pressure sensitive adhesive, or a layer consisting of a material having characteristics of both an adhesive and a pressure sensitive adhesive. The adhesive is a bonding agent that has fluidity in a case of bonding layers and enters a solid state. The pressure sensitive adhesive is a bonding agent which is a gel-like (rubber-like) soft solid in a case of bonding layers and whose gel-like state does not change thereafter.

Here, the piezoelectric element 10 according to the embodiment of the present invention generates a sound by allowing a plurality of laminated layers of the piezoelectric film 12 to be stretched and contracted to vibrate the vibration plate 46 as described below. Therefore, in the piezoelectric element 10 according to the embodiment of the present invention, it is preferable that the stretching and contracting of each piezoelectric film 12 is directly transmitted. In a case where a substance having a viscosity that relieves vibration is present between the layers of the piezoelectric film 12, the efficiency of transmitting the stretching and contracting energy of the piezoelectric film 12 is lowered, and the driving efficiency of the piezoelectric element 10 is also degraded.

In consideration of this point, it is preferable that the bonding layer 14 is an adhesive layer consisting of an adhesive from which a solid and hard bonding layer 14 is obtained, rather than a pressure sensitive adhesive layer consisting of a pressure sensitive adhesive. As a more preferable bonding layer 14, specifically, a bonding layer consisting of a thermoplastic type adhesive such as a polyester-based adhesive or a styrene-butadiene rubber (SBR)-based adhesive is suitably exemplified.

Adhesion, which is different from pressure sensitive adhesion, is useful in a case where a high adhesion temperature is required. Further, the thermoplastic type adhesive has characteristics of "a relatively low temperature, a short time, and strong adhesion", which is suitable.

In the piezoelectric element 10 according to the embodiment of the present invention, the thickness of the bonding layer 14 is not limited, and the thickness thereof that enables exhibition of a sufficient magnitude of bonding strength (adhesive strength or pressure sensitive adhesive strength) may be appropriately set according to the material for forming the bonding layer 14.

Here, in a case where the bonding layer 14 of the piezoelectric element 10 according to the embodiment of the present invention is thin, the effect of transmitting the stretching and contracting energy (vibration energy) of the piezoelectric layer 20 increases, and the energy efficiency increases. In addition, in a case where the bonding layer 14 is thick and has high rigidity, there is also a possibility that the stretching and contracting of the piezoelectric film 12 may be constrained. Further, as described above, the piezoelectric element 10 according to the embodiment of the present invention is formed such that electrode layers having the same polarity face each other in adjacent layers of the piezoelectric film 12, and thus there is no risk of a short circuit. Therefore, the bonding layer 14 can be made thinner in the piezoelectric element 10 according to the embodiment of the present invention.

In consideration of this point, it is preferable that the bonding layer 14 is thinner than the piezoelectric layer 20. That is, it is preferable that the bonding layer 14 in the piezoelectric element 10 according to the embodiment of the present invention is hard and thin.

Specifically, the thickness of the bonding layer 14 is preferably in a range of 0.1 to 50 $\mu$m, more preferably in a range of 0.1 to 30 $\mu$m, and still more preferably in a range of 0.1 to 10 $\mu$m in terms of thickness after the bonding.

In the laminated piezoelectric element 10 according to the embodiment of the present invention, in a case where the spring constant of the bonding layer 14 is high, there is a possibility that the stretching and contracting of the piezoelectric film 12 may be constrained. Therefore, it is preferable that the spring constant of the bonding layer 14 is less than or equal to the spring constant of the piezoelectric film 12. Further, the spring constant is obtained by "thickness $\times$ Young's modulus".

Specifically, the product of the thickness of the bonding layer 14 and the storage elastic modulus (E') at a frequency of 1 Hz according to the dynamic viscoelasticity measurement is preferably $2.0 \times 10^6$ N/m or less at 0°C and $1.0 \times 10^6$ N/m or less at 50°C.

It is preferable that the internal loss of the bonding layer at a frequency of 1 Hz according to the dynamic viscoelasticity measurement is 1.0 or less at 25°C in the case of the bonding layer 14 consisting of a pressure sensitive adhesive and is 0.1 or less at 25°C in the case of the bonding layer 14 consisting of an adhesive.

As described above, the piezoelectric element according to the first aspect of the present invention has a polygonal planar shape, has protruding portions provided to protrude from sides other than the shortest side of the polygon, and has connecting portions for connection with an external power supply.

In addition, in the piezoelectric element according to the first aspect of the present invention, the protruding portion is a portion that protrudes from a polygonal planar shape such as a triangle or a rectangle. In the piezoelectric element according to the first aspect of the present invention, the adjacent layers of the piezoelectric film 12 are laminated and bonded such that basically the entire surface is bonded via the bonding layer 14. That is, the protruding portion is a region where the piezoelectric film 12 is not bonded via the bonding layer 14.

The piezoelectric element 10 of the illustrated example is formed by folding and laminating the rectangular piezoelectric film 12 so that the layers of the piezoelectric film are superimposed, and the planar shape is a rectangle. Therefore, the planar shape has two long sides and two short sides. Therefore, in the piezoelectric element 10, the protruding portion 10a is provided so as to protrude from the long side of the rectangle.

The piezoelectric element 10 is laminated by folding the piezoelectric film 12 such that the folded portion is the long side of the rectangle which is the planar shape. In other words, the piezoelectric element 10 is laminated by folding the piezoelectric film 12 such that the ridge line formed by folding the piezoelectric film is the long side of the rectangle which is the planar shape.

In the piezoelectric element 10, the protruding portion 10a protruding from the long side by extending the piezoelectric film 12 from the outside of the rectangle to protrude from the rectangle which is the planar shape of the piezoelectric element 10, that is, the bonding layer 14, is provided on the uppermost layer of the piezoelectric film 12 to be laminated in the figure.

The piezoelectric element 10 is provided with the connecting portion 40 for connecting the lead-out wire 62 and a lead-out wire 64 to external electrode, on the protruding portion 10a.

In the piezoelectric element 10 of the illustrated example, a through-hole 28a is formed in the first protective layer 28 of the protruding portion 10a, as conceptually illustrated in Fig. 8 by exemplifying the first electrode 24 side. The method of forming the through-holes 28a is not limited, and known methods such as laser processing, removal by dissolution using a solvent, and mechanical processing such as mechanical polishing may be employed depending on the material for forming the first protective layer 28.

The through-hole 28a is filled with a conductive material 40a to form a connecting portion 40 for connecting the first electrode 24 with the external power supply. The conductive material 40a is not limited, and various known conductive materials can be used. Examples thereof include conductive metal paste such as silver paste, conductive carbon paste, and conductive nano-ink.

The lead-out wire 64 to be connected to the external power supply is fixed so as to be in contact with the conductive material 40a of the connecting portion 40, and the external power supply and the first electrode 24 are connected to each other.

In the piezoelectric element 10 according to the embodiment of the present invention, the connecting portion 40 for connecting the lead-out wire 62 and the lead-out wire 64 to be connected to the external electrode is provided on the protruding portion 10a provided to protrude from the long side of the rectangle.

With such a configuration, a piezoelectric element formed of the piezoelectric film 12 having the piezoelectric layer 20 obtained by dispersing the piezoelectric particles 36 in the matrix 34 containing a polymer material, in which the sound pressure particularly in a high frequency band in a case of being used as an electroacoustic transducer or the like can be improved by decreasing the impedance is realized.

As described above, it is necessary to improve the sound pressure in a corresponding wide frequency band in order to output a high-quality sound. Further, in a case where a piezoelectric element obtained by laminating the piezoelectric film is used as an exciter, it is necessary to allow a sufficient amount of current to flow into the piezoelectric layer in order to improve the sound pressure.

In order to allow a sufficient amount of current to flow into the piezoelectric layer, it is necessary to lower the impedance (resistance) of the piezoelectric element. In a case where the impedance of the piezoelectric element is high, the amount of current flowing into the piezoelectric layer decreases, and the sound pressure in a high frequency band, particularly in a high frequency band of 15 kHz or greater decreases.

However, in the piezoelectric element formed of the piezoelectric film 12 having a piezoelectric layer obtained by dispersing the piezoelectric particles in the matrix that contains a polymer material, the impedance is increased and a sufficient amount of current is unlikely to flow into the piezoelectric layer in a case where the position for power supply from the external power supply to the electrode layer is inappropriate.

In the piezoelectric element formed of the piezoelectric film 12, the supplied electricity for driving is transmitted to the entire surface of the piezoelectric film 12 from the connecting portion between the electrode layer and the external power supply. In this case, in a case where the area of the position where the connecting portion is formed, that is, the width of the electricity supply position is small, transmission in a manner that the electricity widely spreads cannot be made. As a result, in a case where the width of the position for supplying the electricity is small, the electricity is unlikely to be transmitted to the entire surface of the piezoelectric film 12, and as a result, the impedance is increased.

Meanwhile, in the piezoelectric element 10 according to the embodiment of the present invention, the piezoelectric element 10 having a rectangular planar shape is provided with the protruding portions 10a protruding from the long sides, and the connecting portions 40 for connection with the external power supply are provided on the protruding portions 10a.

That is, in the piezoelectric element 10, the electricity for driving is supplied from the long sides (sides other than the shortest side) of the piezoelectric film 12 in the piezoelectric element having a rectangular planar shape.

As described above, in the piezoelectric element 10, the supplied electricity is transmitted to the entire surface of the piezoelectric film 12 from the connecting portions 40 connecting the first electrode 24 and the second electrode 26 to the external power supply. Here, in the piezoelectric element 10 in which the connecting portions 40 are provided on the protruding portions 10a protruding from the long sides of the rectangle, the area of the position where the protruding portions 10a provided with the connecting portions 40 are formed, that is, the width of the position to which electricity is supplied is large. Therefore, since the electricity can be transmitted such that the electricity widely spreads in the plane direction of the piezoelectric film 12, the electricity can be easily transmitted over the entire surface of the piezoelectric film 12, and thus the impedance is decreased.

As a result, according to the piezoelectric element 10 of the present invention, for example, in a case where the piezoelectric element 10 is used as an exciter, the sound pressure particularly in a high frequency band is improved, and thus a sound with a high sound pressure and a high sound quality can be output over a wide frequency band.

The same effect also applies to the second aspect of the piezoelectric element of the present invention described below and the piezoelectric film of the piezoelectric speaker of the present invention.

As described above, it is preferable that the piezoelectric element 10 according to the embodiment of the present invention has a low impedance.

Specifically, in a case where the capacitance of the piezoelectric film 12 is defined as C [F], the impedance [$\Omega$] at the frequency F [Hz] is preferably [$1/(6.28 \times F \times C)$] + 1 or less.

The impedance of the piezoelectric element 10 according to the embodiment of the present invention is more preferably [$1/(6.28 \times F \times C)$] or less.

The impedance of the piezoelectric element satisfies this condition preferably in a frequency range of 2 to 20 kHz and more preferably in a frequency range of 2 to 10 kHz.

In a case where the above-described conditions are satisfied, the impedance is reduced, and a high sound pressure can be obtained in a wide frequency band, particularly, in a high frequency band in a case where the piezoelectric element 10 is used as an exciter, an electroacoustic transducer, or the like. Therefore, a high-quality sound can be output.

The description of the impedance is the same for the piezoelectric element according to the second aspect of the present invention described below and the piezoelectric film in the piezoelectric speaker according to the embodiment of the present invention.

In the piezoelectric element 10 according to the embodiment of the present invention, the method of connecting the electrodes and the lead-out wires in the protruding portions 10a is not limited, and various known methods other than the method illustrated in Fig. 8 can be used.

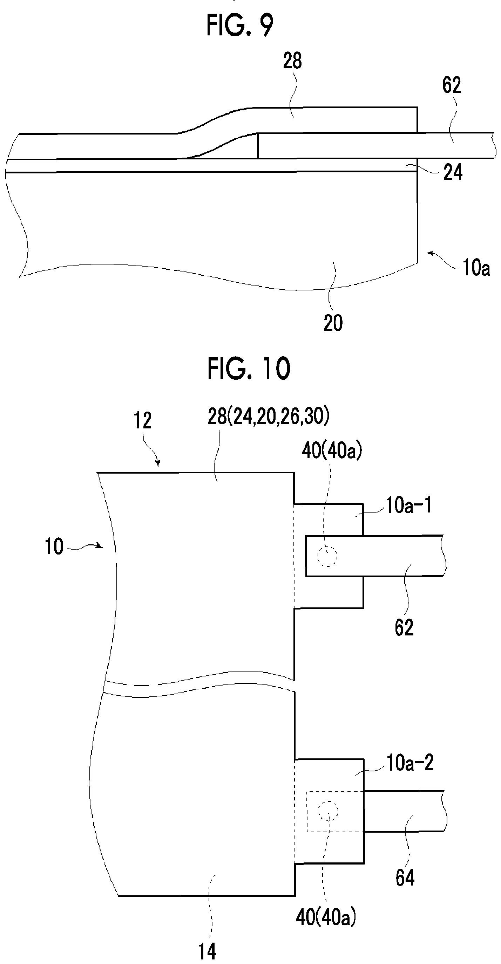

As an example, Fig. 9 shows a method of conceptually illustrating the first electrode 24 side. That is, the connecting portion connected with the external electrode may be formed by partially peeling an end portion of the first protective layer 28 at the protruding portion 10a and inserting and fixing the lead-out wire 62 between the first electrode 24 and the first protective layer 28.

Moreover, as the configuration of the connecting portion and the method of forming the connecting portion, those described in JP2016-015354A can also be suitably used.

In the piezoelectric element 10, the positional relationship between the connecting portion 40 of the first electrode 24 and the connecting portion 40 of the second electrode 26 in the protruding portion 10a in the plane direction of the piezoelectric film is also not limited.

That is, the connecting portion 40 of the first electrode 24 and the connecting portion 40 of the second electrode 26 may be close to each other in the plane direction, separated from each other, or superimposed with each other as long as the connecting portions are formed on the protruding portions. The plane direction is the plane direction in the planar shape of the piezoelectric element 10. In addition, the connecting portion 40 may be positioned at an end portion, in the center, or in the middle between the end portion and the center in the long side direction of the rectangle which is the planar shape of the piezoelectric element 10.

Therefore, the connecting portion 40 of the first electrode 24 and the connecting portion 40 of the second electrode 26 may be provided such that one connecting portion is positioned in the vicinity of one end portion and the other connecting portion is positioned in the vicinity of the other end portion, for example, in the long side direction of the rectangular planar shape of the piezoelectric element 10. Alternatively, one of two connecting portions 40 may be provided in the vicinity of one end portion and the other connecting portion may be positioned in the central portion in the longitudinal direction of the rectangle. Alternatively, both two connecting portions 40 may be provided in the vicinity of one end portion in the longitudinal direction of the rectangle. Alternatively, both two connecting portions 40 may be provided in the central portion in the longitudinal direction of the rectangle.

The same applies to the piezoelectric element according to the second aspect of the present invention described below and the piezoelectric film in the piezoelectric speaker according to the embodiment.

In the piezoelectric element 10 in the illustrated example, the connecting portion 40 of the first electrode 24 and the connecting portion 40 of the second electrode 26 are provided on one protruding portion 10a, but the present invention is not limited thereto.

That is, in the piezoelectric element 10 of the present invention, a plurality of protruding portions may be provided as long as the protruding portions protrude from the long side of the rectangle which is the planar shape.

For example, as conceptually illustrated in Fig. 10, two protruding portions, a first protruding portion 10a-1 and a second protruding portion 10a-2, may be provided by protruding from the long side of the rectangle. Here, as an example, the connecting portion 40 for connection with the first electrode 24 (lead-out wire 62) may be provided on the first protruding portion 10a-1, and the connecting portion 40 for connection with the second electrode 26 (lead-out wire 64) may be provided on the second protruding portion 10a-2. In Fig. 10, the longitudinal direction in the figure is the long side direction of the rectangle which is the planar shape of the piezoelectric element, and the lateral direction in the figure is a short side direction of the rectangle.

It is preferable that the length of the side on which the protruding portions are provided in the extension direction is long regardless of whether one side is provided with one protruding portion or a plurality of protruding portions. In the following description, the length of the protruding portion in the extension direction of the side on which the protruding portion is provided is also referred to as "width of the protruding portion".

Specifically, in a case where the length of the side on which the protruding portion is provided is defined as L and the width of the protruding portion is defined as La, the width La of the protruding portion is preferably 10% or greater of the length L of the side, more preferably 50% or greater thereof, still more preferably 70% or greater thereof, particularly preferably 90% or greater, and most preferably the same as or greater than the length L of the side.

Further, in the piezoelectric element 10 of the illustrated example, the protruding portion 10a is provided at one end portion of the piezoelectric film 12 in the folding direction so as to protrude from the long side of the rectangle.

However, the present invention is not limited thereto, and the protruding portions are provided at both end portions of the piezoelectric film 12 to be laminated by being folded in the folding direction so as to protrude from the long sides of the rectangle which is the planar shape. That is, in the piezoelectric film 12 to be laminated by being folded, protruding portions are provided on the uppermost piezoelectric film 12 in the figure and the lowermost piezoelectric film 12 in the figure.

Here, as an example, the connecting portion 40 for connection with the first electrode 24 (lead-out wire 62) is provided on the uppermost protruding portion, and the connecting portion 40 for connection with the second electrode 26 (lead-out wire 64) is provided in the lowermost protruding portion.

That is, in the piezoelectric element obtained by laminating a plurality of layers by means of folding one sheet of the piezoelectric film 12, various aspects can be used for the attachment position of the lead-out wire according to the number of laminated piezoelectric films 12. Further, the same applies to the configuration in which the protruding portions 10a are provided on any of the long side or the short side and the configuration in which no protruding portions are provided.

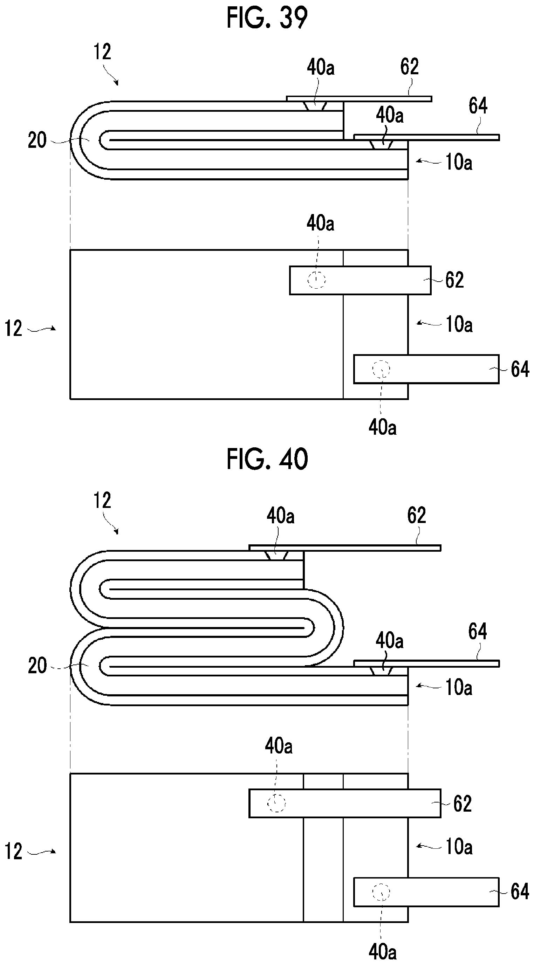

An example is shown in conceptual views of Figs. 39 to 43. In Figs. 39 to 43, in order to simplify the drawing and clearly illustrate the configuration, the electrode and the protective layer are integrated with each other, and the bonding layer 14 for bonding adjacent layers of the piezoelectric film is not illustrated.

In a case where the number of laminated layers of the piezoelectric film 12 is an even number, a configuration other than the configuration in which connecting portions for connecting the first electrode and the second electrode to an external device are provided on the protruding portion 10a can be used. That is, in the case where the number of laminated layers of the piezoelectric film 12 is an even number, a configuration other than the configuration in which both the lead-out wire 62 and the lead-out wire 64 are provided on the protruding portion 10a can be used.

For example, as illustrated in Fig. 39 where the number of laminated layers of the piezoelectric film 12 is 2 and as illustrated in Fig. 40 where the number of laminated layers of the piezoelectric film 12 is 4, the lead-out wire 62 may be connected without providing the protruding portion 10a on the uppermost layer and the lead-out wire 64 may be connected by providing the protruding portion 10a on the lowermost layer.

Further, even in a case where the number of laminated layers of the piezoelectric film 12 is an odd number, a configuration other than the configuration in which connecting portions for connecting the first electrode and the second electrode to an external device are provided on the protruding portion 10a can be used. That is, in the case where the number of laminated layers of the piezoelectric film 12 is an odd number, a configuration other than the configuration in which both the lead-out wire 62 and the lead-out wire 64 are provided on the protruding portion 10a can be used.

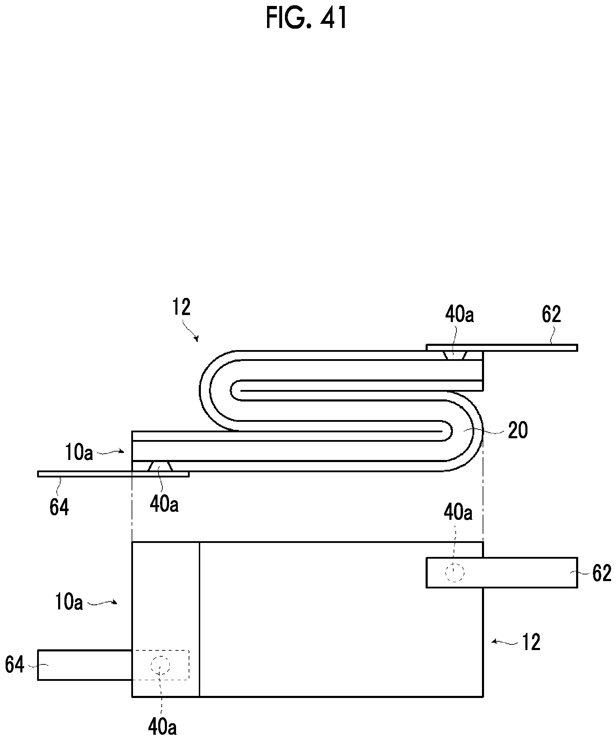

For example, as illustrated in Fig. 41 where the number of laminated layers of the piezoelectric film 12 is 3, the lead-out wire 62 may be connected without providing the protruding portion 10a on the uppermost layer and the lead-out wire 64 may be connected by providing the protruding portion 10a on the lowermost layer.

In the case where the number of laminated layers of the piezoelectric film 12 is an odd number, the lead-out wires are led out in opposite directions in a case where lead-out wires are provided on the uppermost layer and the lowermost layer as illustrated in Fig. 41.

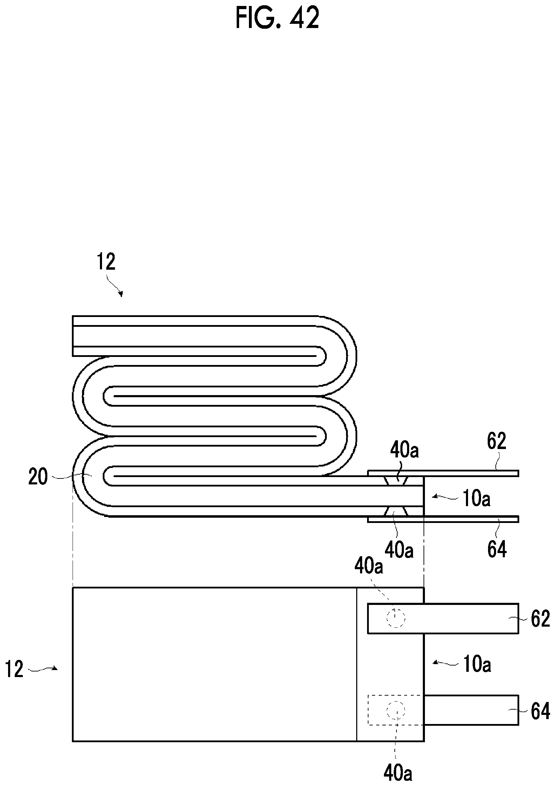

Further, in the piezoelectric element 10 of Fig. 1, the protruding portion 10a is provided on the uppermost layer in the figure, but the present invention is not limited thereto. For example, as illustrated in Fig. 42, the protruding portion 10a is provided on the lowermost layer in the figure, and the connecting portion for connecting the first electrode and the second electrode with an external device, that is, the lead-out wire 62 and the lead-out wire 64 may be provided on the lowermost layer.

That is, in the piezoelectric element obtained by laminating the piezoelectric film 12, the position of the protruding portion 10a in the vertical direction and the horizontal direction during use is not limited. The same applies to the cases where the number of laminated layers of the piezoelectric film 12 is an odd number and the case where the number thereof is an even number.

In addition, even in a configuration with no protruding portions described below, connecting portions for connecting the first electrode and the second electrode with an external device, that is, the lead-out wire 62 and the lead-out wire 64 can be provided according to the number of laminated layers of the piezoelectric film 12.

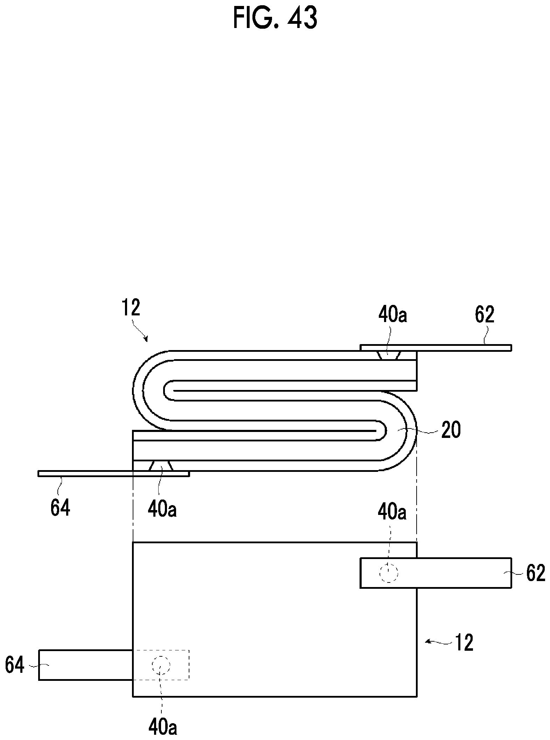

The configuration with no protruding portions can be suitably used in a case where the number of laminated layers of the piezoelectric film 12 is an odd number. For example, in a case where the number of laminated layers of the piezoelectric film 12 is an odd number as illustrated in Fig. 43 where the number of laminated layers of the piezoelectric film 12 is 3, a configuration in which the lead-out wire 62 is provided on the uppermost layer and the lead-out wire 64 is provided on the lowermost layer is exemplified.

In the piezoelectric element 10 illustrated in Figs. 1 to 3, the protruding portion 10a protruding the long side of the rectangular planar shape is provided by extending the piezoelectric film 12 in the folding direction, but the present invention is not limited thereto.

As the configuration in which the piezoelectric film 12 is laminated by being folded, for example, a configuration in which the piezoelectric film 12 is folded such that that the folded portion is a short side of the rectangle which is the planar shape as in a case of a piezoelectric element 10A conceptually illustrated in Fig. 11. That is, in this case, the piezoelectric element 10A is laminated by folding the piezoelectric film 12 such that the ridge line formed by folding the piezoelectric film is a short side of the rectangle which is the planar shape.

In such a piezoelectric element 10A, in a case where the piezoelectric film 12 is allowed to protrude from the rectangle which is the planar shape by extending the piezoelectric film 12 in the folding direction, the protruding portion protrudes from the short side of the rectangle.

Therefore, in this case, as conceptually illustrated in Fig. 11, the protruding portion 10Aa in which the piezoelectric film 12 protrudes from the long side of the rectangle is provided so as to be orthogonal to the folding direction of the piezoelectric film 12, and the connecting portion 40 for connection with the first electrode 24 (lead-out wire 62) and the connecting portion 40 for connection with the second electrode 26 (lead-out wire 64) may be provided on the protruding portion 10Aa.

In this case, the protruding portion 10Aa is not limited to the configuration in which the protruding portion is provided on the piezoelectric film 12 that is the end portion in the lamination direction. That is, as illustrated in Fig. 11, in the configuration in which the protruding portion 10Aa is provided so as to be orthogonal to the piezoelectric film 12 in the folding direction, the protruding portion 10Aa may be provided on the intermediate layers of the piezoelectric film 12, such as the second and third layers in the lamination direction.

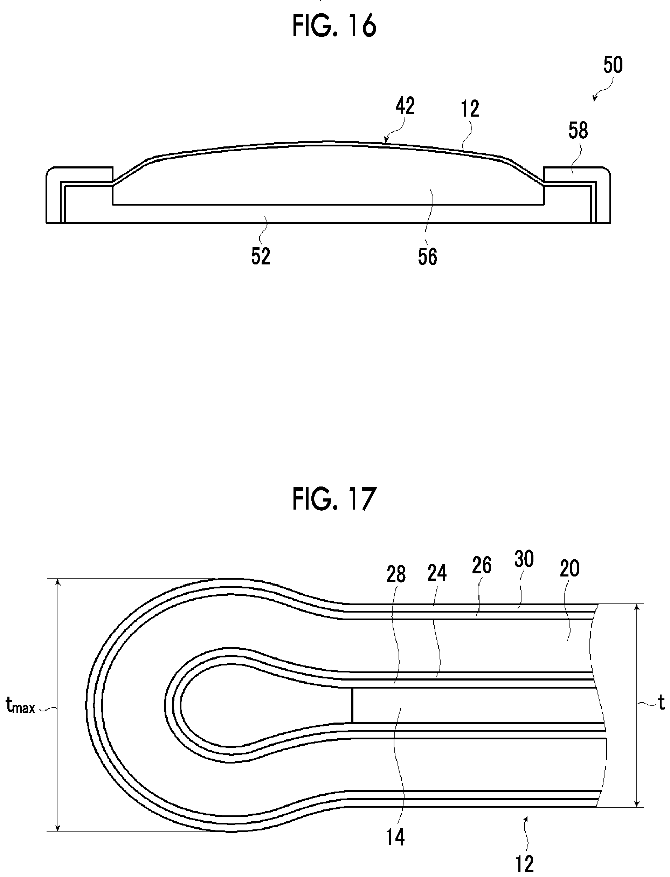

In the piezoelectric element in which a plurality of layers of piezoelectric film 12 are laminated by folding one piezoelectric film 12 as the case of the piezoelectric element 10, the thickness of the folded portion of the piezoelectric film 12 may be greater than the thickness of the laminate of two adjacent layers of the piezoelectric film 12, as conceptually illustrated in Fig. 17. Further, the thickness of the laminate of two adjacent layers of the piezoelectric film 12 also includes the thickness of the bonding layer 14.

Here, the thickness of the folded portion of the piezoelectric film 12 is not limited. As illustrated in Fig. 17, in a case where the thickness of the laminate of two adjacent layers of the piezoelectric film 12 is defined as t, and the maximum thickness of the folded portion of the piezoelectric film 12 is defined as $t_{max}$, the maximum thickness $t_{max}$ is preferably less than or equal to $5 \times 10^5$ times the thickness t. That is, an expression "$t_{max} \leq t \times (5 \times 10^5)$" is preferable. For example, in a case where the thickness t of the laminate of two adjacent layers of the piezoelectric element is 50 $\mu$m, the maximum thickness $t_{max}$ of the folded portion is preferably 2.5 mm or less.

Here, the folded portion of the piezoelectric film 12 may be a void as illustrated in Fig. 17, may be filled with the bonding layer 14 (bonding agent), or may be filled with a material having a lower elastic modulus than that of the bonding agent which is the bonding layer 14.

The piezoelectric element described above has a configuration in which a plurality of layers of the piezoelectric film are laminated by folding one sheet of the piezoelectric film 12. However, the first aspect of the piezoelectric element according to the embodiment of the present invention is not limited to this configuration.

That is, as in a case of a piezoelectric element 10B conceptually illustrated in Fig. 12, the first aspect of the present invention may be a configuration in which a plurality of cut sheet-like piezoelectric films 12 are laminated and the piezoelectric films 12 adjacent to each other in the lamination direction are bonded with the bonding layer 14.

In the first aspect of the piezoelectric element of the present invention, in a case where a plurality of cut sheet-like piezoelectric films 12 are laminated, electricity is supplied to each piezoelectric film 12 to drive the film. Therefore, in the configuration in which the cut sheet-like piezoelectric films 12 are laminated, the shape of the main surface of each piezoelectric film 12 is regarded as the planar shape of the piezoelectric element.

That is, in the configuration in which rectangular piezoelectric films 12 are laminated as in the case of the piezoelectric element 10B illustrated in Fig. 12, the protruding portion 10Ba may be provided so as to protrude from the long side of the piezoelectric film 12 by considering the shape of the main surface of the piezoelectric film 12 as the planar shape of the piezoelectric element 10B.

The piezoelectric element according to the embodiment of the present invention described above has a rectangular planar shape. Therefore, only two long sides and two short sides are present in the planar shape, and the protruding portion that forms a connecting portion for connection with an external power supply is provided to protrude from a long side.

However, in the piezoelectric element of the present invention, the planar shape is not limited to a rectangle, and a triangular or pentagonal or higher polygonal shape, and a square other than a rectangle such as a trapezoid can also be used.

Here, three or more different lengths of the sides may be present depending on the planar shape of the piezoelectric element. For example, all lengths of three sides of a triangle may be different in a piezoelectric element having a triangular planar shape.

In the first aspect of the piezoelectric element according to the embodiment of the present invention, in a case where three or more different lengths are present in a polygonal planar shape, the protruding portion may be provided so as to protrude from the sides other than the shortest side.

Therefore, a protruding portion may be provided from one side of the polygon other than the shortest side to form the connecting portion 40 for connection with the first electrode 24, and a protruding portion may be provided from another side of the polygon other than the shortest side to form the connecting portion 40 for connection with the second electrode 26. For example, in a case where the lengths of three sides are different from each other, the connecting portion 40 for connection with the first electrode 24 (lead-out wire 62) may be formed to protrude from the longest side, a protruding portion may be formed on the second longest side, and the connecting portion 40 for connection with the second electrode 26 (lead-out wire 64) may be formed.

However, in a case where a plurality of protruding portions are provided in the piezoelectric element according to the first aspect of the present invention, the protruding portions are preferably provided on the same side of the polygon and all protruding portions are preferably provided on the longest side.

It is preferable that a plurality of protruding portions are provided on the same side from the viewpoint that connection with an external power supply can be easily made, routing of a wire for connection with an external power supply can be easily carried out, the piezoelectric element is easily prepared, and the planar size of the piezoelectric element can be reduced.

The same applies to the connecting portion of the piezoelectric element according to the second aspect of the present invention described below and to the protruding portion and the connecting portion of the piezoelectric film of the piezoelectric speaker according to the embodiment of the present invention described below.

That is, in the piezoelectric element according to the second aspect of the present invention, the connecting portion may be provided in the same manner as the connecting portion of the protruding portion in the piezoelectric element according to the first aspect, at a position within an upper limit separation distance from an end portion on a side other than the shortest side of the polygon as described below. Further, in the piezoelectric speaker according to the embodiment of the present invention, a protruding portion may be provided on a side other than the shortest side of the polygon of the piezoelectric film, and the connecting portion section may be provided on the protruding portion in conformity with the piezoelectric element according to the first aspect.

In the first aspect of the piezoelectric element of the present invention described above, a plurality of layers of the piezoelectric film 12 are laminated and bonded with the bonding layer 14, the protruding portion is provided to protrude from a side other than the shortest side of the polygonal planar shape, and the connecting portion for connection with an external power supply is provided on the protruding portion.

Meanwhile, the second aspect of the piezoelectric element of the present invention is a piezoelectric element having the same piezoelectric film 12 as described above, and the piezoelectric element has the connecting portion for connecting an external power supply and an electrode layer at a position within the upper limit separation distance from an end portion of the piezoelectric film 12 other than the shortest side of the polygonal planar shape. Further, in the second aspect of the piezoelectric element of the present invention, the upper limit separation distance is 1(1/2.1)/2.1 of the length of the shortest side of the polygonal planar shape. In the second aspect of the piezoelectric element of the present invention, the upper limit separation distance is preferably 2(2/5)/5 of the length of the shortest side of the polygonal planar shape and more preferably 1(1/5)/5 of the length of the shortest side thereof.

The piezoelectric element according to the second aspect of the present invention may have only one sheet of the piezoelectric film 12 that is not laminated.

Alternatively, the piezoelectric element according to the second aspect of the present invention may be formed by folding one sheet of the piezoelectric film 12 so that a plurality of layers of the piezoelectric film are laminated as in the piezoelectric element 10 illustrated in Figs. 1 to 3.

Alternatively, the piezoelectric element according to the second aspect of the present invention may be formed by laminating a plurality of cut sheet-like piezoelectric films 12 as in the piezoelectric element 10B illustrated in Fig. 12.

In the second aspect of the piezoelectric element of the present invention, in a case where a plurality of layers of the piezoelectric film 12 are laminated, the bonding layer 14 for bonding the adjacent layers of the piezoelectric film 12 in the thickness direction is not a configuration requirement. Therefore, in a case where the piezoelectric element according to the second embodiment of the present invention has a configuration in which a plurality of layers of the piezoelectric film 12 are laminated, the laminated layers may be fixed in the laminated state using known fastening members such as bolts, nuts, frames, and members for holding a sheet-like material.

However, in a case where the bonding layer 14 is not provided, each layer of the piezoelectric film 12 independently stretches and contracts. As described above, in a case where the individual layers of the piezoelectric film 12 independently stretch and contract, the driving efficiency of the laminated piezoelectric element decreases, the degree of stretching and contracting of the entire laminated piezoelectric element decreases, and there is a possibility that an abutting vibration plate or the like cannot be sufficiently vibrated.

From this viewpoint, even in the second aspect of the piezoelectric element of the present invention, it is preferable that the configuration in which a plurality of layers of the piezoelectric film 12 are laminated includes the bonding layer 14 for bonding the adjacent layers of the piezoelectric film 12 as in the piezoelectric element of the first aspect.

The piezoelectric element according to the second aspect of the present invention also has a polygonal planar shape.

In the present invention, the planar shape of the piezoelectric element is the shape as the piezoelectric element is viewed in the lamination direction of the piezoelectric film 12 in the configuration in which a plurality of layers of the piezoelectric film 12 are laminated as described above. Further, in a case where the piezoelectric element is formed of one sheet of the piezoelectric film 12 that is not laminated and in a case of a configuration in which a plurality of cut-sheet-like piezoelectric films 12 are laminated, the shape of the main surface of each piezoelectric film is regarded as the planar shape of the piezoelectric element.

In the second aspect of the piezoelectric element of the present invention, the connecting portion for connecting an external power supply with an electrode layer is provided at a position within the upper limit separation distance from an end portion of the piezoelectric film 12 other than the shortest side of the polygonal planar shape.

Further, in the second aspect of the piezoelectric element of the present invention, the upper limit separation distance is 1/2.1 of the length of the shortest side of the polygon.

Further, in the second aspect of the piezoelectric element of the present invention, the position of the connecting portion closest to an end portion of a side of the polygonal planar shape may be positioned within the upper limit separation distance.

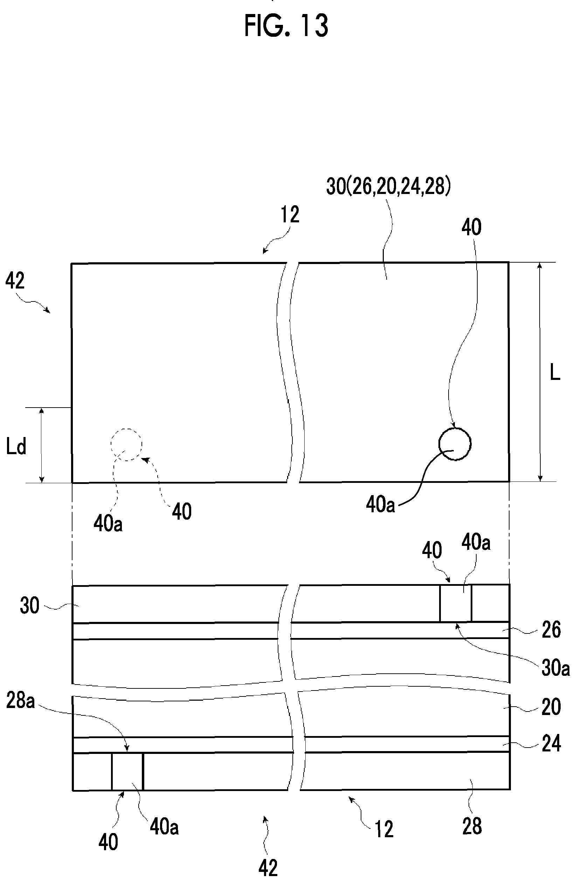

Fig. 13 describes the second aspect of the piezoelectric element of the present invention using the piezoelectric element 42 having one sheet of the rectangular piezoelectric film 12 that is not laminated. In Fig. 13, the upper view is a plan view, and the lower view is a cross-sectional view in the thickness direction. In the cross-sectional view, hatching is omitted in order to clearly show the configuration. Further, the piezoelectric element 42 illustrated in Fig. 13 includes the same members as those of the piezoelectric element 10 and the like, and thus the description thereof will be made by focusing on different points.

The piezoelectric element 42 illustrated in Fig. 13 has one sheet of the rectangular piezoelectric film 12 that is not laminated. Therefore, in the piezoelectric element 42, the planar shape is a rectangle, and the shortest side is the short side of the rectangle.

Therefore, in the piezoelectric element 42, in a case where the shortest side of the polygonal planar shape, that is, the length of the short side of the rectangle is defined as L, the upper limit separation distance Ld is represented by "Ld = L/2.1". As described above, the upper limit separation distance Ld is represented by preferably "Ld = 2L/5" and more preferably "Ld = L/5".

In the second aspect of the piezoelectric element of the present invention, the connecting portion for connecting an external power supply with an electrode layer is provided at a position within the upper limit separation distance Ld from an end portion of the long side.

In the piezoelectric element illustrated in Fig. 13, the connecting portion 40 similar to that in Fig. 8 is provided at a position within the upper limit separation distance Ld (Ld=L/2.1) from an end portion of one long side of the rectangle.

That is, the through-hole 28a is formed in the first protective layer 28 and the through-hole 30a is formed in the second protective layer 30 respectively at a position within the upper limit separation distance Ld from an end portion of one long side of the rectangle.

The through-hole 28a and the through-hole 30a are filled with the conductive material 40a such as silver paste and used as the connecting portion 40 for connecting an external power supply to the first electrode 24 and the connecting portion 40 for connecting an external power supply to the second electrode 26. Although not illustrated in Fig. 13, for example, the lead-out wire 62 and the lead-out wire 64 for connection with external electrodes are connected to both the connecting portions 40 in the same manner as in the above-described example.

Since the second aspect of the piezoelectric element of the present invention has such a configuration, the impedance is reduced by supplying the power from the long side of the rectangle in the piezoelectric element 42 having a rectangular planar shape, as in the first aspect of the piezoelectric element described above. As a result, even in the second aspect, in a case where the piezoelectric element is used as an electroacoustic transducer, an exciter, or the like, the sound pressure is improved particularly in a high frequency band, and a high-quality sound with a high sound pressure can be output over a wide frequency band.

In the second aspect of the piezoelectric element of the present invention, the connecting portion for connection with an external power supply is not limited to the connecting portion 40 illustrated in Fig. 8, and various known configurations such as the configuration illustrated in Fig. 9 can be used, similar to the case of the first aspect described above. In addition, in the configuration illustrated in Fig. 9, the contact portion with the lead-out wire in the electrode layer is the connecting portion.

Even in the second aspect of the piezoelectric element of the present invention similarly to the first aspect of the piezoelectric element of the present invention described above, the positional relationship between the connecting portion 40 of the first electrode 24 and the connecting portion 40 of the second electrode 26 in the plane direction of the piezoelectric film is also not limited. In the piezoelectric element 42 illustrated in Fig. 12, the connecting portion 40 of the first electrode 24 and the connecting portion 40 of the second electrode 26 may be provided at positions within the upper limit separation distance from end portions of different long sides of the rectangle.

Further, in the second aspect of the piezoelectric element of the present invention, the planar shape is not limited to a rectangle, and various shapes can be used, and the connecting portions 40 may be provided respectively at a position within the upper limit separation distance from an end portion on a side other than the shortest side of a polygon as described above. In this case, the connecting portions 40 are provided preferably on the same side of the polygon and more preferably on the longest side, similarly to the case of the protruding portion of the first aspect.

In the second aspect of the piezoelectric element of the present invention, the connecting portions 40 may be provided on individual layers of the piezoelectric film 12 as described above, in the configuration in which a plurality of layers of the piezoelectric film 12 are laminated as illustrated in Fig. 12.

In the piezoelectric element of the present invention, in a case where a plurality of layers of the piezoelectric film 12 are laminated, the piezoelectric film 12 having the protruding portion corresponding to the first aspect and the piezoelectric film 12 having no protruding portion corresponding to the second aspect may be mixedly present. That is, in the piezoelectric element of the present invention, in a case where a plurality of layers of the piezoelectric film 12 are laminated, at least one layer may have the protruding portions in the first aspect, and at least one layer may have the connecting portions at a position within the upper limit separation distance from an end portion of a side other than the shortest side.

Further, in the piezoelectric element of the present invention, in a case where a plurality of layers of the piezoelectric film are laminated, the configuration in which a plurality of layers of the piezoelectric film 12 are laminated may be obtained by folding one sheet of the piezoelectric film 12 and laminating the folded layers or laminating cut sheet-like piezoelectric films 12.

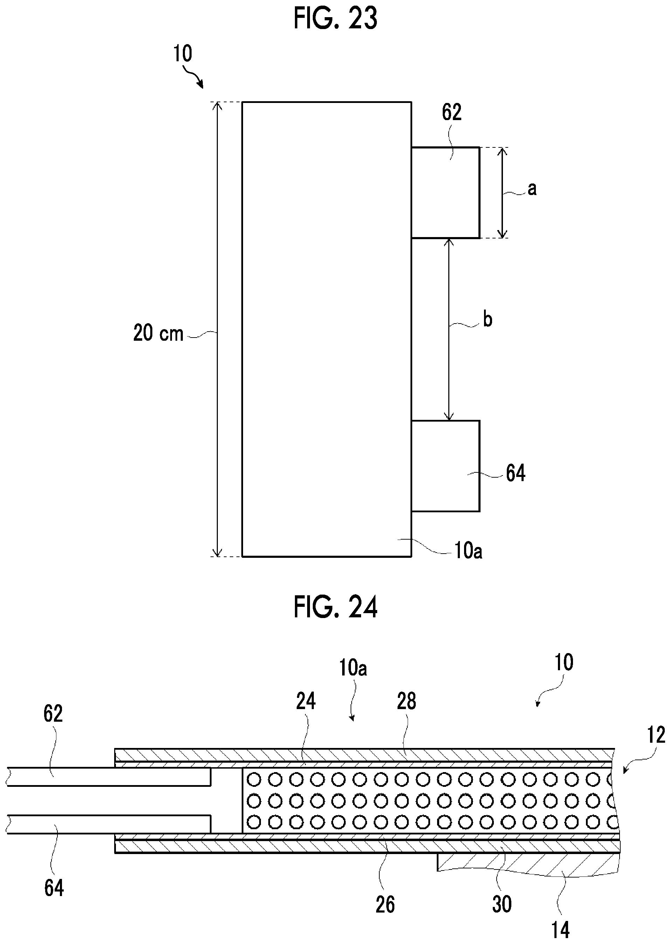

Further, in the second embodiment of the piezoelectric element of the present invention, in a case where one sheet of the piezoelectric film 12 is folded and a plurality of layers of the piezoelectric film 12 are laminated as illustrated in Fig. 1, for example, the connecting portions 40 may be provided at a position within the upper limit separation distance Ld with respect to the length L of the short side from an end portion of the long side of the rectangular planar shape on the uppermost layer and the lowermost layer of the piezoelectric film 12, as conceptually illustrated in Fig. 24. As described above, this configuration is suitable in a case where the number of laminated layers of the piezoelectric film is an odd number.

Product information may be displayed on a part of the piezoelectric element of the present invention and the piezoelectric speaker of the present invention described below, as necessary.

All positions can be used as the display position for the product information as long as the positions are visible positions on the outer surface of the piezoelectric element.

Examples of the display position for the information include a main surface of the piezoelectric element, a main surface of the piezoelectric film 12, a side surface of the laminate of the piezoelectric film 12, and a protruding portion of the piezoelectric element according to the first aspect of the present invention. Further, a side surface of the laminate is a surface orthogonal to the lamination direction. The main surface may be any of the two surfaces.

Further, the product information may be displayed on the lead-out wire connected to the connecting portion of the piezoelectric element, or may be displayed on the cover material when the lead-out wire is provided with a cover material or the like for protecting the lead-out wire from corrosion.

In a case where the piezoelectric element is covered with a protective film such as a moisture-proof film, a protective plate, a housing, or the like, information may be displayed on these members.

A plurality of display positions for the information may be used in combination.

A known method can be used as information display means. Examples thereof include a drawing (printing) method using printing means such as ink jet, a marking method such as laser processing or mechanical grinding, a bonding method for sheet-like materials such as sheets, a typical printing method such as intaglio printing and letterpress printing, and combinations thereof.

The notation method (expression method) for information is not limited, and a known method can be used. Examples thereof include letters, numbers, symbols, patterns, one-dimensional or two-dimensional barcodes, and combinations thereof. Further, examples of the two-dimensional barcode includes various known two-dimensional barcodes such as QR (Quick Response) code (registered trademark), Micro QR code (registered trademark), SP code, Veri Code, Maxi Code, CP (Computer Purpose) code, Date Matrix, Date Matrix ECC200, Code 1, Aztec code, Intacta code, Card e, Chameleon code, and Semacode.

Alternatively, storage means readable by radio waves, such as an RFID tag using a UHF band, an HF band, or the like, or an RFID tag with a memory function, may be bonded to the piezoelectric element in place of the notation of the information.

The content of the information is not limited, and various pieces of information can be used.

Examples of the information include an identification number (identification code) that is unique to an individual such as a serial number, a lot number, or a product number and that can be linked to individual information owned by the manufacture of the piezoelectric element, information of date of manufacture/date of processing, the production machine, the material, and the production conditions, information on the number of a item in a raw material unit and a production/processing date unit, application information, customer information, inspection history/inspection data such as inspection date and time, and type of inspection such as energization inspection, manufacturer company information such as a company name and a company logo, a product brand name, production control information, production environment information, and test history information. Further, the product brand name includes the product logo.

Various means for preventing falsification may be provided for the piezoelectric element of the present invention and the piezoelectric speaker of the present invention described below.

For example, in a case of the piezoelectric element formed by laminating a plurality of layers of the piezoelectric film 12, it is preferable that degradation of the performance can be determined by peeling adjacent layers of the piezoelectric film 12.

Examples of such means for prevention falsification include a falsification preventive seal which is provided between adjacent layers of the piezoelectric film 12 and peeled off in a case where the adjacent layers of the piezoelectric film are peeled off and in which characters such as "peeled", "invalid", and "VOID", symbols, patterns, and the like remain on the main surface of the piezoelectric film 12 and/or the main surface of the bonding layer 14, a strip-like falsification preventive seal which is bonded across a plurality of layers of the piezoelectric film and is broken and does not return in a case of peeling the piezoelectric film 12, and means for allowing adjacent layers of the piezoelectric film 12 not to be bonded again in a case where adjacent layers of the piezoelectric film 12 are peeled off.

As the falsification preventive seal, various known falsification preventive seals such as the falsification preventive seals described in JP1995-199813A (JP-H7-199813A) and JP2006-23348A can be used.

In such a piezoelectric element of the present invention, a piezoelectric element having a configuration in which a plurality of layers of the piezoelectric film 12 are laminated is used as an exciter for vibrating a vibration plate and generating a sound from the vibration plate.

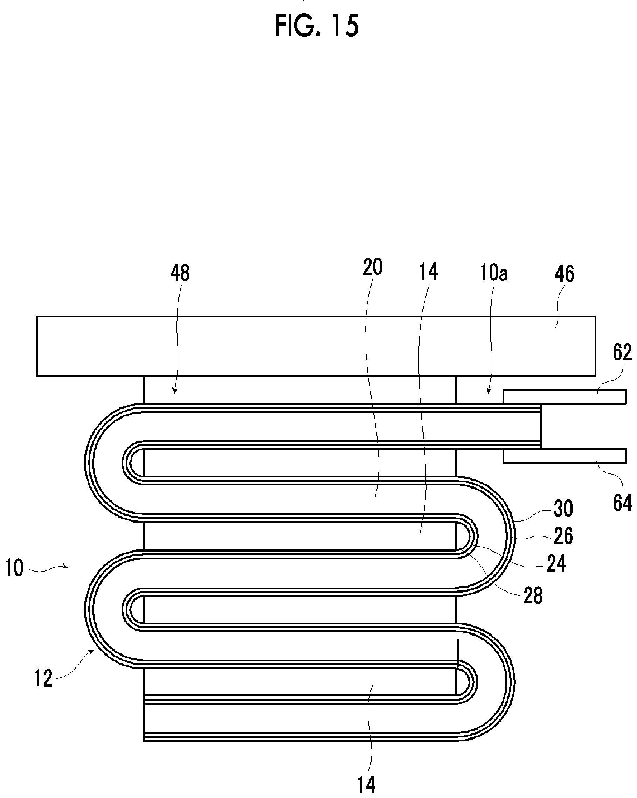

As an example, as conceptually illustrated in Fig. 15 using the piezoelectric element 10 described above as an example, the piezoelectric element according to the embodiment of the present invention is used as an exciter bonded to the vibration plate 46 with a bonding layer 48 to generate a sound from the vibration plate 46. That is, Fig. 15 illustrates an example of an electroacoustic transducer formed of the piezoelectric element 10 according to the embodiment of the present invention.

As described above, in the piezoelectric element 10 according to the embodiment of the present invention, the piezoelectric layer 20 constituting the piezoelectric film 12 in which a plurality of layers are laminated is formed by dispersing the piezoelectric particles 36 in the matrix 34. In addition, the first electrode 24 and the second electrode 26 are provided to sandwich the piezoelectric layer 20 therebetween in the thickness direction.

In a case where a voltage is applied to the first electrode 24 and the second electrode 26 of the piezoelectric film 12 having the piezoelectric layer 20, the piezoelectric particles 36 stretch and contract in the polarization direction according to the applied voltage. As a result, the piezoelectric film 12 (piezoelectric layer 20) contracts in the thickness direction. At the same time, the piezoelectric film 12 stretches and contracts in the plane direction due to the Poisson's ratio.

The degree of stretch and contraction is approximately in a range of 0.01% to 0.1%.

As described above, the thickness of the piezoelectric layer 20 is preferably approximately 8 to 300 $\mu$m. Therefore, the degree of stretch and contraction in the thickness direction is as extremely small as approximately 0.3 $\mu$m at the maximum.

On the contrary, the piezoelectric film 12, that is, the piezoelectric layer 20, has a size much larger than the thickness in the plane direction. Therefore, for example, in a case where the length of the piezoelectric film 12 is 20 cm, the piezoelectric film 12 stretches and contracts by a maximum of approximately 0.2 mm by the application of a voltage.

As described above, the vibration plate 46 is bonded to the piezoelectric element 10 with the bonding layer 48. Therefore, the stretching and contracting of the piezoelectric film 12 causes the vibration plate 46 to bend, and as a result, the vibration plate 46 vibrates in the thickness direction.

The vibration plate 46 generates a sound using the vibration in the thickness direction. That is, the vibration plate 46 vibrates according to the magnitude of the voltage (driving voltage) applied to the piezoelectric film 12, and generates a sound according to the driving voltage applied to the piezoelectric film 12.

Further, it is known that in a case where a typical piezoelectric film consisting of a polymer material such as PVDF is subjected to a stretching treatment in a uniaxial direction after the polarization treatment, the molecular chains are aligned with respect to the stretching direction, and as a result, excellent piezoelectric characteristics are obtained in the stretching direction. Therefore, a typical piezoelectric film has in-plane anisotropy as a piezoelectric characteristic and has anisotropy in the amount of stretch and contraction in the plane direction in a case where a voltage is applied.

Meanwhile, in the piezoelectric element 10 according to the embodiment of the present invention, the piezoelectric film 12 having the piezoelectric layer 20 formed of a polymer-based piezoelectric composite material obtained by dispersing the piezoelectric particles 36 in the matrix 34 has excellent piezoelectric characteristics without performing the stretching treatment after the polarization treatment. Therefore, the piezoelectric film 12 has no in-plane anisotropy as a piezoelectric characteristic, and stretches and contracts isotropically in all directions in the in-plane direction. That is, in the piezoelectric element 10 according to the embodiment of the present invention, the piezoelectric film 12 isotropically stretches and contracts two-dimensionally. According to the piezoelectric element 10 in which such a piezoelectric film 12 that isotropically stretch and contract two-dimensionally is laminated, compared to a case where typical piezoelectric films formed of PVDF or the like that stretch and contract greatly in only one direction are laminated, the vibration plate 46 can be vibrated with a large force, and a louder and more beautiful sound can be generated.

As described above, the piezoelectric element 10 is obtained by folding such a piezoelectric film 12 and laminating a plurality of layers of the piezoelectric film 12. The piezoelectric element 10 in the illustrated example is formed by further bonding adjacent layer of the piezoelectric film 12 with the bonding layer 14 as a preferable aspect.

Therefore, even in a case where the rigidity of each piezoelectric film 12 is low and the stretching and contracting force thereof is small, the rigidity is increased by laminating the piezoelectric film 12, and the stretching and contracting force as the piezoelectric element 10 is increased. As a result, in the piezoelectric element 10 according to the embodiment of the present invention, even in a case where the vibration plate 46 has a certain degree of rigidity, the vibration plate 46 is sufficiently bent with a large force and the vibration plate 46 can be sufficiently vibrated in the thickness direction, whereby the vibration plate 46 can generate a sound.

Further, in a case where the thickness of the piezoelectric layer 20 increases, the stretching and contracting force of the piezoelectric film 12 increases, but the driving voltage required for stretching and contracting the film is increased by the same amount. Here, as described above, in the piezoelectric element 10 according to the embodiment of the present invention, since the maximum thickness of the piezoelectric layer 20 is preferably approximately 300 $\mu$m, the piezoelectric film 12 can be sufficiently stretched and contracted even in a case where the voltage applied to each piezoelectric film 12 is small.

In the electroacoustic transducer formed of the piezoelectric element 10 according to the embodiment of the present invention as an exciter, the bonding layer 48 for bonding the piezoelectric element 10 and the vibration plate 46 is not limited, and various known pressure sensitive adhesive adhesives and adhesives can be used.

Examples thereof are the same as those for the bonding layer 14 described above. The preferable bonding layer 48 (bonding agent) is also the same as the bonding layer 14.

In the electroacoustic transducer formed of the piezoelectric element according to the embodiment of the present invention as an exciter, the vibration plate 46 is also not limited, and various articles can be used.

Examples of the vibration plate 46 include plate materials such as plates made of resins and glass plates, advertisement/notice media such as signboards, office equipment and furniture such as tables, whiteboards, and projection screens, display devices such as organic electroluminescence (organic light emitting diode (OLED)) display and liquid crystal displays, vehicle members such as consoles, A-pillars, ceilings, and bumpers such as automobiles, and building materials such as walls of houses.

In the electroacoustic transducer formed of the piezoelectric element 10 according to the embodiment of the present invention as an exciter, it is preferable that the vibration plate 46 to which the piezoelectric element 10 is bonded has flexibility and more preferable that the vibration plate 46 can be wound.

As the vibration plate 46 having flexibility, various sheet-like materials having flexibility such as resin films (plastic films) can be used. As the vibration plate 46 having flexibility, a panel-like display device having flexibility such as a flexible display panel is particularly suitably exemplified. Moreover, it is more preferable that the display device can be also wound.

The piezoelectric element 10 according to the embodiment of the present invention is not limited, and it is preferable that the vibration plate 46 and the piezoelectric element, that is, the exciter are bonded to each other by avoiding the lead-out wires as illustrated in Fig. 15 in a case where the piezoelectric element formed by laminating the piezoelectric film 12 is used as an exciter.

In other words, in the case where the piezoelectric element formed by laminating the piezoelectric film 12 is used as an exciter, it is preferable that the bonding layer 48 for bonding the piezoelectric element (exciter) and the vibration plate 46 is provided by avoiding the lead-out wires. That is, it is preferable that the bonding layer 48 is not bonded to the lead-out wires.

Further, in a case where the piezoelectric element formed by laminating the piezoelectric film 12 has the protruding portion 10a for connecting the lead-out wire with the electrode layer, it is preferable that the protruding portion 10a as well as the lead-out wire are not bonded to the vibration plate 46. That is, in a case where the piezoelectric element formed by laminating the piezoelectric film 12 has the protruding portion 10a for connecting the lead-out wire with the electrode layer, it is preferable that the bonding layer 48 is not provided even on the protruding portion.

In a case where the piezoelectric element is used as an exciter, it may be necessary to peel the piezoelectric element and the vibration plate 46 off from each other for the various purposes such as adjustment, repair, and re-bonding. For example, as described in examples below, copper foil tape or the like is used for the lead-out wire, and the mechanical strength is not high in many cases.

Therefore, in a case where the lead-out wire is bonded to the vibration plate 46, the lead-out wire is highly likely to be damaged during bonding of the vibration plate 46 and the piezoelectric element to each other. Further, it is extremely difficult to peel the vibration plate 46 and the piezoelectric element off from each other without damaging the lead-out wire.

Moreover, in the piezoelectric element, the vibration plate 46 is vibrated mainly by the laminated portion formed by laminating the piezoelectric film 12. Here, in a case where the lead-out wire is bonded to the vibration plate 46, only this portion having the lead-out wire is different from other regions in terms of the number of vibrations, and thus the sound output may be adversely affected.

Further, in a case where the piezoelectric element has the protruding portion 10a, the piezoelectric film 12 is not laminated on the protruding portion 10a. Therefore, in a case where the protruding portion 10a is bonded to the vibration plate 46, similarly, the laminated portion of the protruding portion 10a and the piezoelectric film 12 is different from other regions in terms of the number of vibrations, and thus the sound output may be adversely affected.

A method of bonding the entire surface of the piezoelectric element to the vibration plate 46 to control the vibration of the vibration plate 46 as a whole may be considered. However, in this case, the problem that occurs in a case of peeling the vibration plate 46 and the piezoelectric element off from each other cannot be avoided.

In addition, as described above, the connecting portion between the connection line with the external device and the lead-out wire, and the connecting portion between the lead-out wire and the electrode layer are positions where the flow of electricity, that is, the electrical resistance greatly changes, and heat is likely to be generated.

In such a place, that is, the lead-out wire is bonded to the vibration plate 46, the heat cannot be efficiently dissipated, and high-temperature heat may be generated.

Meanwhile, in the piezoelectric element formed by laminating the piezoelectric film 12, it is preferable that the lead-out wire and the vibration plate 46 are not bonded to each other. Further, in a case where the protruding portion 10a is provided, it is more preferable that the protruding portion 10a and the vibration plate 46 are not bonded to each other.

In this manner, the piezoelectric element and the vibration plate 46 can be easily peeled off from each other without damaging the lead-out wires, a suitable sound output can be made by preventing adverse effects caused by regions with different numbers of vibrations, and heat generation in the lead-out wires and in the periphery of the lead-out wires can be suppressed.

Further, the same applies to the configuration in which the protruding portions 10a are provided on any of the long side or the short side and the configuration in which no protruding portions are provided.

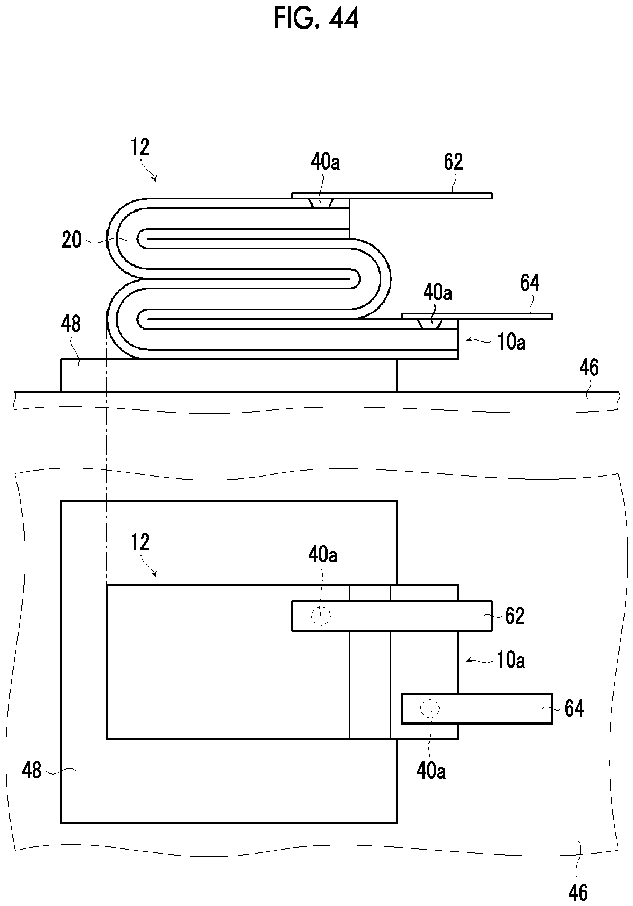

Hereinafter, Figs. 44 to 49 and 52 to 54 are conceptual views illustrating an example. In Figs. 44 to 49 and the like, in order to simplify the drawings and clearly show the configuration, the electrode and the protective layer are integrated with each other, and the bonding layer 14 for bonding adjacent layers of the piezoelectric film 12 is not illustrated.

Further, since the bonding layer 14 is not illustrated in Fig. 44 and the subsequent views, the portion protruding from an end portion of the folded portion of the piezoelectric film 12 is illustrated as the protruding portion 10a for convenience.

First, in a case where the protruding portion 10a is on a side close to the vibration plate 16, it is preferable that the vibration plate 16 and the piezoelectric element (piezoelectric film 12) are bonded to each other without providing the bonding layer 48 on the protruding portion 10a as illustrated in Fig. 44.

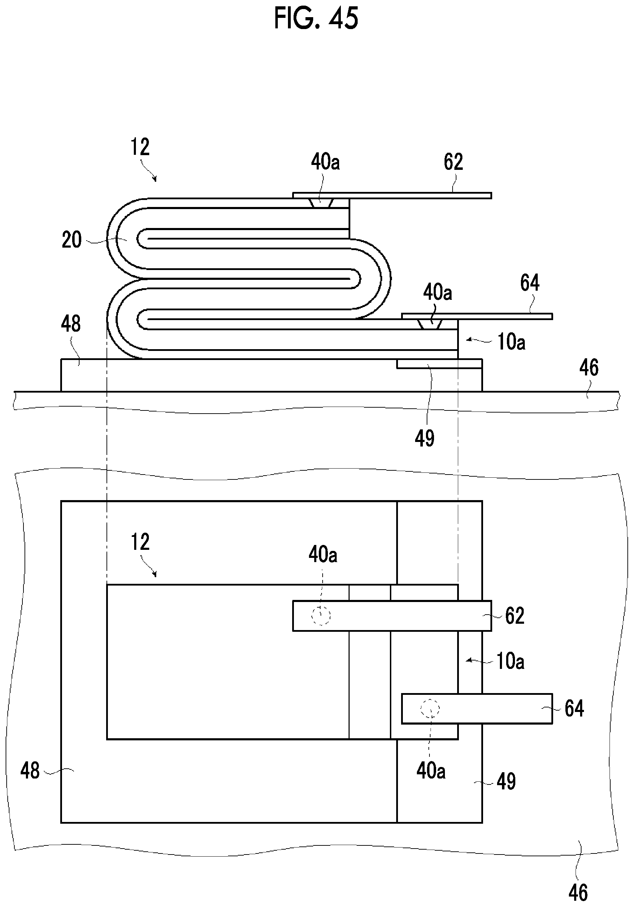

Alternatively, as illustrated in Fig. 45, the bonding layer 48 may be provided to cover the entire surface of the planar shape of the piezoelectric element in plan view, and a non-bonding layer 49 having no bonding properties may be provided between the protruding portion 10a and the bonding layer 48. In addition, the expression "having no bonding properties" denotes that the layer does not have any of the pressure sensitive adhesiveness or the adhesiveness.

Fig. 45 illustrates the non-bonding layer 49 in a state of being embedded in the bonding layer 48. However, the configuration having the non-bonding layer 49 is not limited thereto, and the bonding layer 48 may have steps and/or inclined parts caused by the non-bonding layer 49. In this regard, the same applies to the examples shown below.

The case where the protruding portion 10a is on the side close to the vibration plate 16 is, in other words, a case where the layer of the piezoelectric film 12 bonded to the vibration plate 16 has the protruding portion 10a.

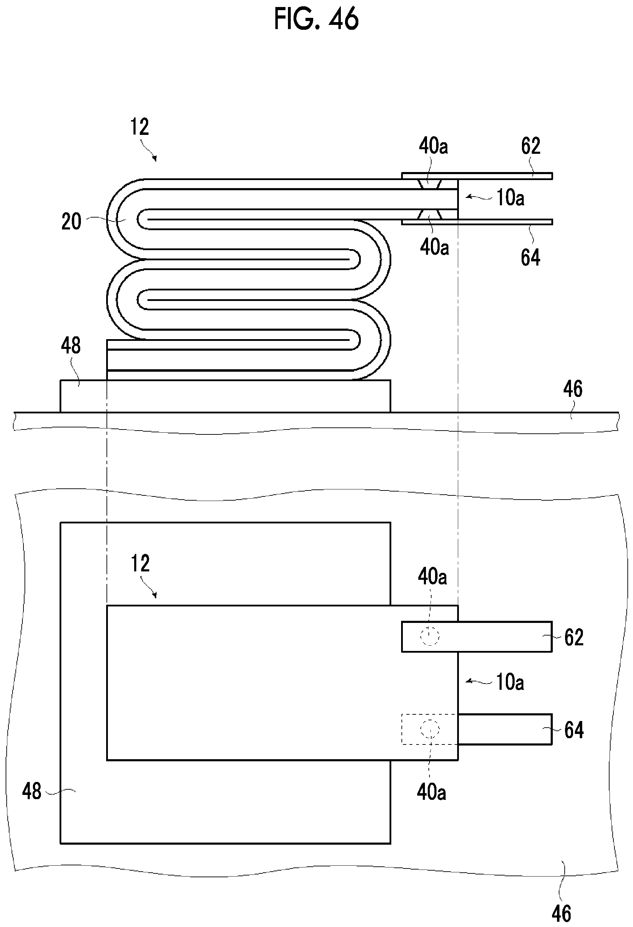

On the contrary, in a case where the protruding portion 10a is on a side far from the vibration plate 16, it is preferable that the bonding layer 48 is provided in a region that does not overlap the protruding portion 10a in the planar shape, that is, in plan view, and the vibration plate 16 and the piezoelectric element (piezoelectric film 12) are bonded to each other as illustrated in Fig. 46.

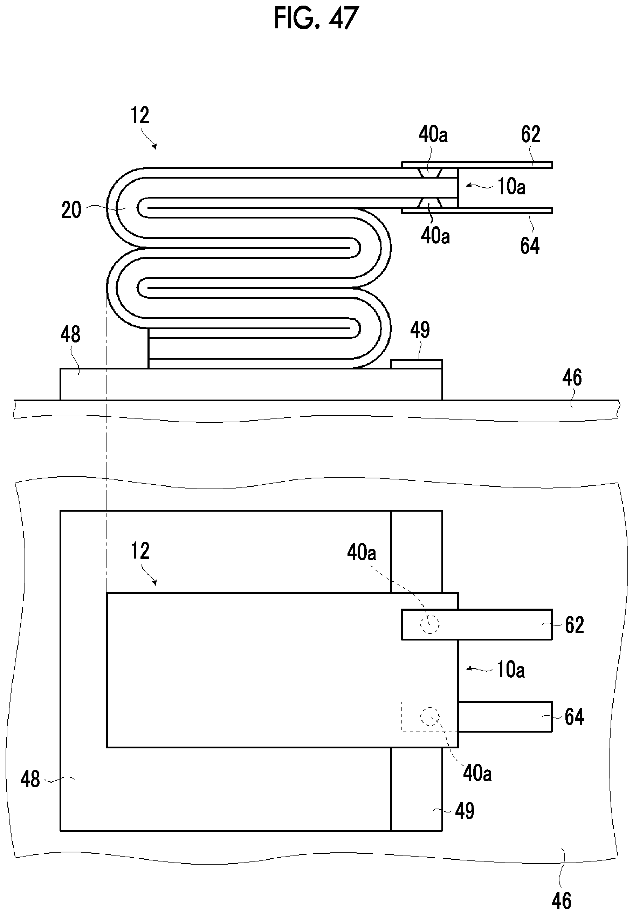

Alternatively, as illustrated in Fig. 47, the bonding layer 48 may be provided to cover the entire surface of the planar shape of the piezoelectric element in plan view, and the non-bonding layer 49 having no bonding properties may be provided on a region where the protruding portion 10a and the bonding layer 48 overlap each other.

In addition, the case where the protruding portion 10a is on a side far from the vibration plate 16 is a case where the protruding portion 10a is provided on a layer farthest from the layer of the piezoelectric film 12 bonded to the vibration plate 16 in the lamination direction.

Even in a case where the protruding portion 10a is provided as illustrated in Figs. 44 to 47, the bonding layer 48 is provided in a region other than the lead-out wire of the protruding portion 10a without providing the bonding layer 48 only on the lead-out wire so that the protruding portion may be bonded to the vibration plate 16.

However, the protruding portion 10a is formed of a single layer and, as described above, the number of vibrations is different from that of the laminated portion in a case where driving power is supplied. Therefore, in a case where the piezoelectric element has the protruding portion 10a, it is preferable that the protruding portion 10a is not bonded to the vibration plate 46.

Similarly, even in a case where the protruding portion 10a is not provided, it is preferable that the bonding layer 48 is not provided on the lead-out wire.

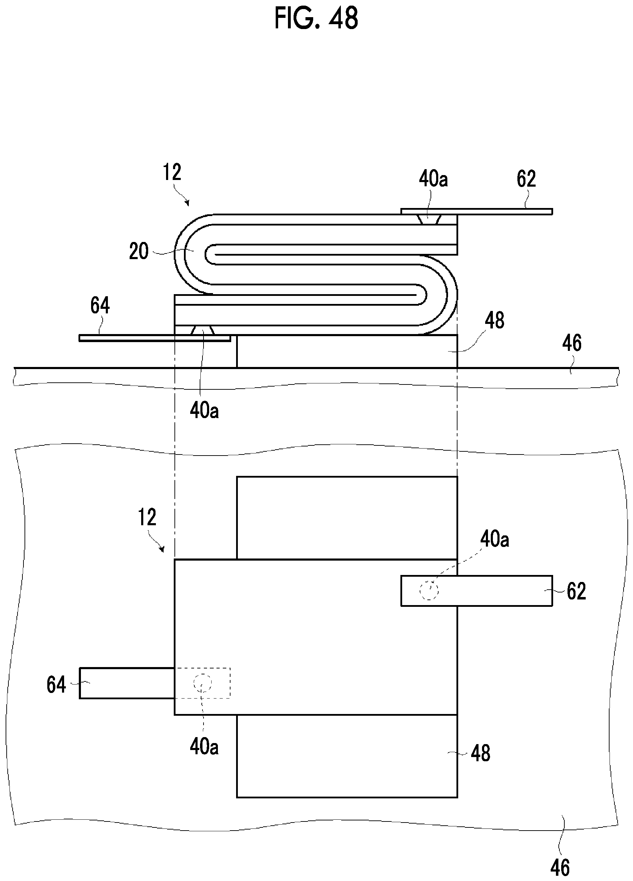

For example, as shown in Fig. 48, it is preferable that a strip-like region without the bonding layer 48 is provided so as to correspond to the region where the lead-out wire 64 is present and that the vibration plate 16 and the piezoelectric element (piezoelectric film 12) are bonded to each other with the bonding layer 48.

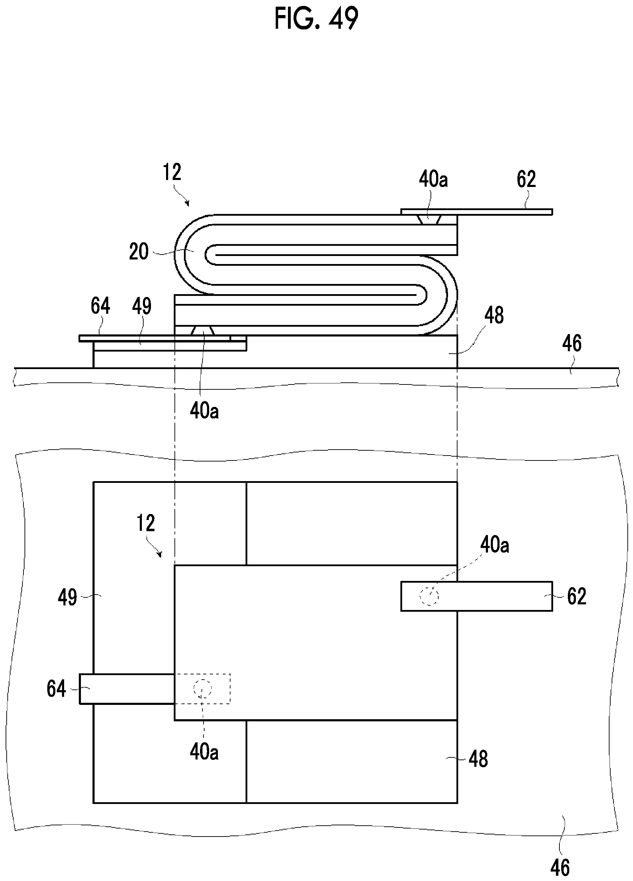

Alternatively, as illustrated in Fig. 49, the bonding layer 48 may be provided so as to cover the entire surface of the planar shape of the piezoelectric element in plan view, and the non-bonding layer 49 having no bonding properties may be provided in a region where the lead-out wire 64 and the bonding layer 48 overlap each other.

The bonding of the vibration plate 46 with the bonding layer 48 in a case where the piezoelectric element does not have a jetting portion is not limited to the configuration in which the bonding layer 48 is not provided in a strip-like region with respect to a region where the lead-out wire is provided, as illustrated in Figs. 48 and 49.

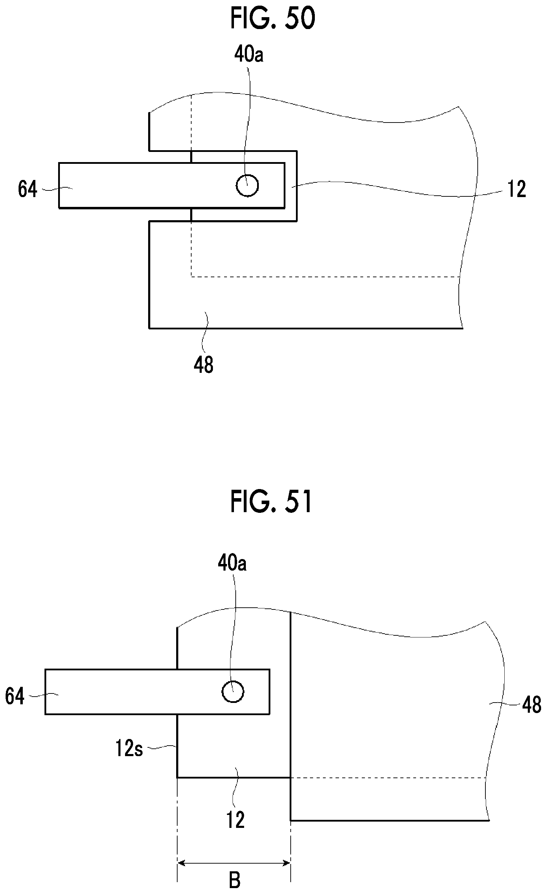

For example, as conceptually illustrated in Fig. 50, the bonding layer 48 may not be provided only in a region where the lead-out wire 64 of the piezoelectric element (piezoelectric film 12) is not present. Alternatively, the bonding layer 48 may be provided so as to bond the entire surface of the piezoelectric element, and the non-bonding layer 49 may be provided only in a region of the lead-out wire 64 of the piezoelectric element (piezoelectric film 12).

Alternatively, similarly to Figs. 48 and 49, as conceptually illustrated in Fig. 51, in the piezoelectric element (piezoelectric film 12), the bonding layer 48 may not be provided in a strip-like region B where the lead-out wire 64 is present, which corresponds to a side 12s from which the lead-out wire 64 protrudes and is parallel to the side 12s. Alternatively, the bonding layer 48 may be provided so as to be bonded to the entire surface of the piezoelectric element, and the non-bonding layer 49 may be provided in a strip shape so as to include the region B and cover the bonding layer 48 on a side where the lead-out wire 64 protrudes from the piezoelectric element (piezoelectric film 12).

As described above, the connecting portion between the connection line with the external device and the lead-out wire and the connecting portion between the lead-out wire and the electrode layer are positions where the electrical resistance greatly changes and heat is easily generated.

Correspondingly, in the piezoelectric element formed by laminating the piezoelectric film 12, a heat dissipation plate 47 may be provided at a portion where the lead-out wire is disposed, such as the protruding portion 10a.

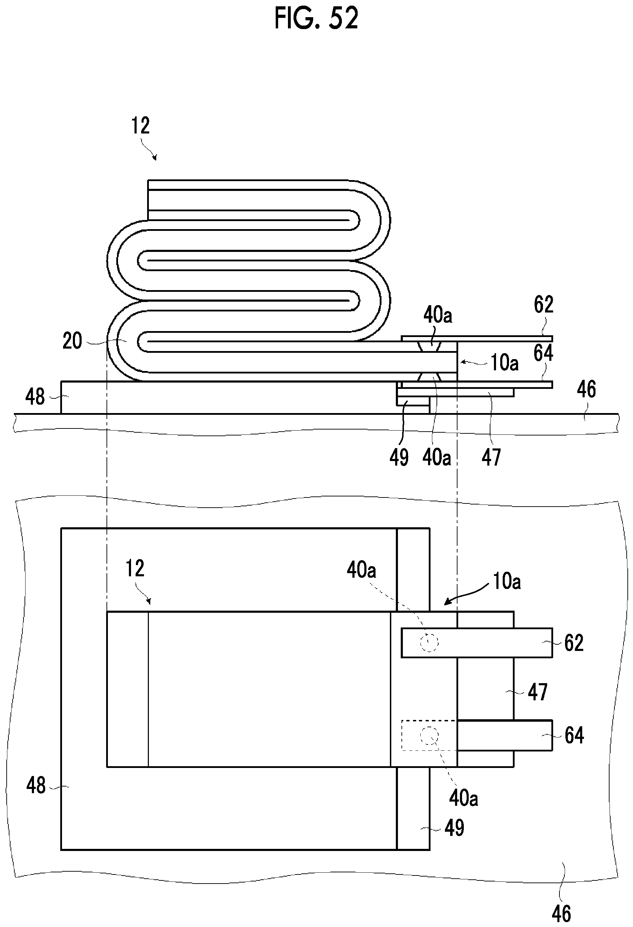

For example, in a case where the bonding layer 48 is provided on the lower surface of the piezoelectric element in the figure, that is, on the side of the protruding portion 10a illustrated in Fig. 42 so that the protruding portion is bonded to the vibration plate 46, the non-bonding layer 49 may be provided between the protruding portion 10a and the bonding layer 48, and the heat dissipation plate 47 may be provided between the non-bonding layer 49 and the lead-out wire 64 as illustrated in Fig. 52.

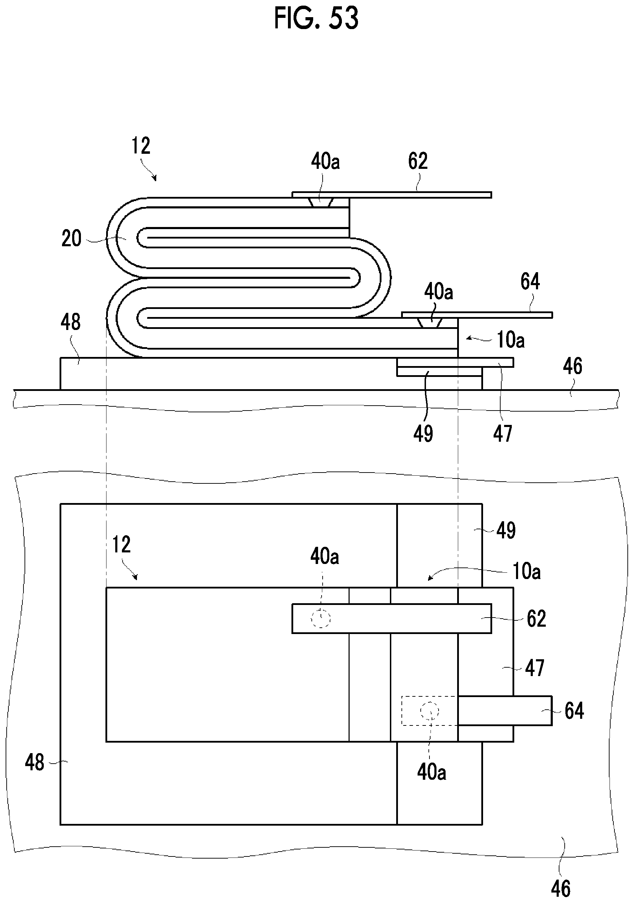

Further, in a case of the configuration in which the protruding portion illustrated in Fig. 45 is provided on a side close to the vibration plate 46, the heat dissipation plate 47 may be provided between the non-bonding layer 49 provided to correspond to the protruding portion 10a and the protruding portion 10a as illustrated in Fig. 53.

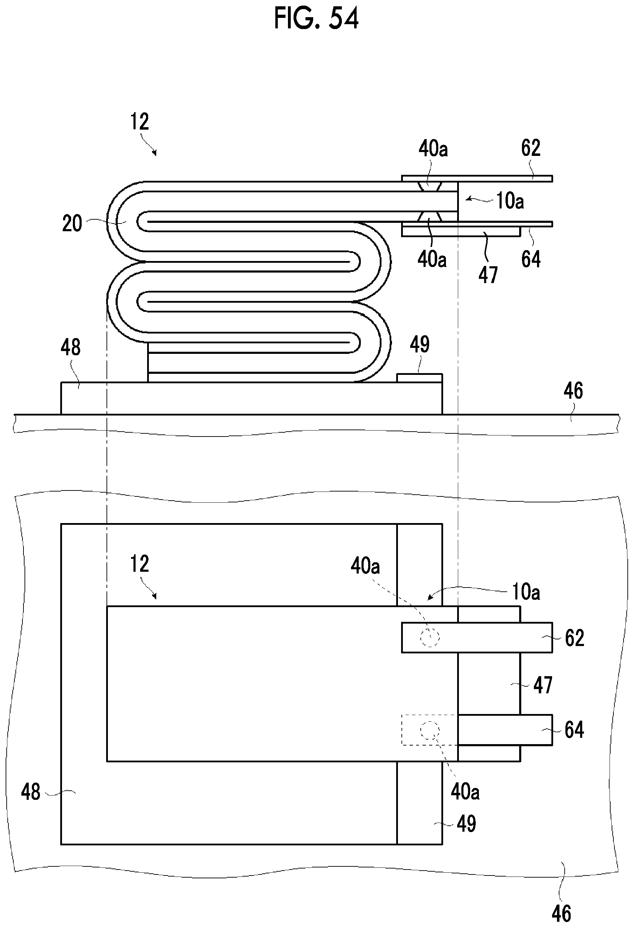

Further, in a case of the configuration in which the protruding portion 10a illustrated in Fig. 47 is provided on a side far from the vibration plate 46, the heat dissipation plate 47 may be provided on the protruding portion 10a by covering the lead-out wire 64 as illustrated in Fig. 54.

The heat dissipation plate 47 is not limited, and various known plate materials (sheet-like materials) that have been used as heat dissipation plates (heat dissipation sheets) can be used as long as the plate-like members are heat-dissipating, that is, have thermal conductivity, such as graphite sheets and heat dissipation sheets including heat dissipation fillers with high thermal conductivity. Further, examples of the heat dissipation filler with high thermal conductivity include alumina.

Further, it is preferable that the heat dissipation plate 47 has flexibility.

In this regard, the same applies to the piezoelectric speaker according to the embodiment of the present invention described below.

A piezoelectric speaker according to the embodiment of the present invention includes the piezoelectric film and the vibration plate described above, and the piezoelectric film and the vibration plate are bonded to each other with the bonding layer described above.

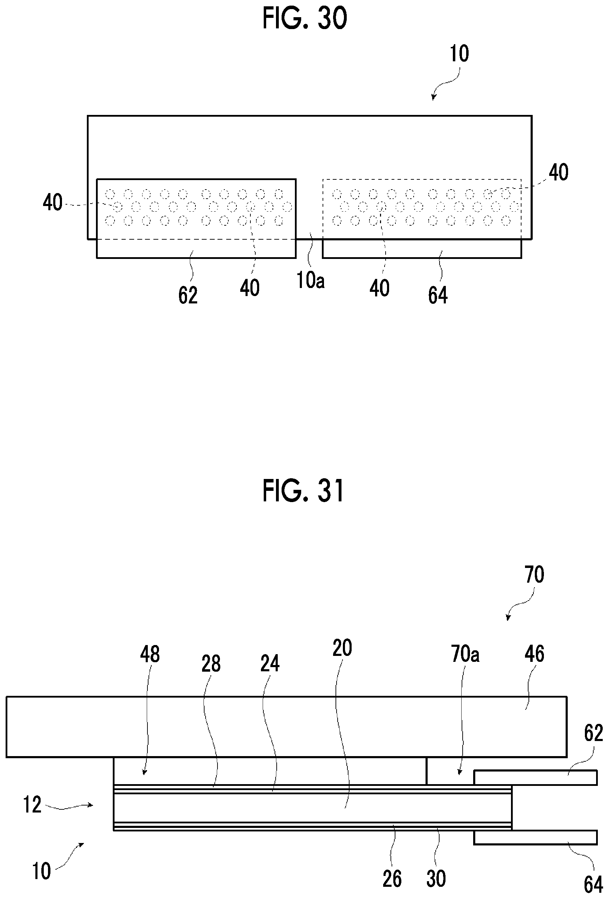

Fig. 31 conceptually illustrates an example of the piezoelectric speaker according to the embodiment of the present invention.

Further, the piezoelectric speaker illustrated in Fig. 31 is formed of the same members as the electroacoustic transducer formed of the piezoelectric element 10 according to the embodiment of the present invention illustrated in Fig. 15 as an exciter, and thus the same members are denoted by the same reference numerals, and the description below will be made by focusing on different points.

The piezoelectric element according to the embodiment of the present invention used as an exciter described above is formed by laminating a plurality of layers of the piezoelectric film 12. Meanwhile, a piezoelectric speaker 70 according to the embodiment of the present invention, illustrated in Fig. 31, includes one sheet of the piezoelectric film 12 that is not laminated, the vibration plate 46, and the bonding layer 48 for bonding the piezoelectric film 12 and the vibration plate 46 to each other. The piezoelectric film 12, the vibration plate 46, and the bonding layer 48 are the same as described above.

Further, in the piezoelectric speaker 70 according to the embodiment of the present invention, the piezoelectric film 12 has a polygonal planar shape similarly to the piezoelectric element according to the first aspect of the present invention described above and a protruding portion 70a provided to protrude from a side other than the shortest side of the polygon. The piezoelectric speaker 70 according to the embodiment of the present invention has a connecting portion for connecting an external power supply with the protruding portion 70a, similarly to the piezoelectric element according to the first aspect of the present invention.

For example, in a case where the piezoelectric film 12 is rectangular, the protruding portion 70a is formed to protrude from the long side of the rectangle, and the connecting portion is provided on the protruding portion 70a.

The protruding portion is a portion that protrudes from a polygonal planar shape such as a triangle or a rectangle. In the piezoelectric speaker according to the embodiment of the present invention, basically the entire surface of the portion acting as an exciter is bonded with the bonding layer 48. That is, in the piezoelectric speaker 70 according to the embodiment of the present invention, the protruding portion is a region of the piezoelectric film 12 that is not bonded with the bonding layer 48.

In addition, the piezoelectric speaker 70 according to the embodiment of the present invention has only one layer of the piezoelectric film 12. In this case, the planar shape of the piezoelectric film 12 is the shape of the main surface of the piezoelectric film 12 as described above.

Even in the piezoelectric speaker 70 according to the embodiment of the present invention, similarly to the piezoelectric element according to the first aspect of the present invention described above, a connecting portion for connecting an external power supply with an electrode layer may be provided on the protruding portion 70a of the piezoelectric film 12. For example, similarly to the example illustrated in Fig. 8, a through-hole is provided in the protective layer of the protruding portion 70a, the through-hole is filled with a conductive material, and the lead-out wire 62 and the lead-out wire 64 are connected to each other. Alternatively, as in the example illustrated in Fig. 9, the protective layer of the protruding portion 70a is peeled off, and the lead-out wire 62 and the lead-out wire 64 are inserted between the protective layer and the electrode.

As described above, the piezoelectric film 12 is thin and has satisfactory flexibility, and even one sheet of the piezoelectric film 12 can sufficiently vibrate the vibration plate 46 so that a suitable sound can be output depending on the rigidity of the piezoelectric film 12 and the rigidity of the vibration plate 46.

In the piezoelectric speaker according to the embodiment of the present invention, the connecting portion for connection with the external power supply is not limited to the connecting portion illustrated in Figs. 8 and 9, and connecting portions with various known configurations can be used similarly to the piezoelectric element according to the embodiment of the present invention described above.

Even in the piezoelectric speaker according to the embodiment of the present invention similarly to the piezoelectric element according to the embodiment of the present invention described above, the positional relationship between the connecting portion 40 of the first electrode 24 and the connecting portion 40 of the second electrode 26 in the plane direction of the piezoelectric film is not limited.

Further, even in the piezoelectric film 12 of the piezoelectric speaker according to the embodiment of the present invention, the planar shape is not limited to a rectangle, and various shapes can be used, and the protruding portion and the connecting portion may be provided on a side other than the shortest side of the polygon as described above. In this case, the protruding portions are provided preferably on the same side of the polygon and more preferably on the longest side similarly to the protruding portions according to the first aspect of the piezoelectric element of the present invention as described above.

Meanwhile, in the piezoelectric element of the present invention, a piezoelectric element formed of only one sheet of the piezoelectric film that is not laminated can be used as an electroacoustic conversion film such as a piezoelectric speaker that outputs a sound by vibrating itself.

Fig. 16 conceptually illustrates an example of a flat plate type piezoelectric speaker formed of the piezoelectric element 42 having only one sheet of the piezoelectric film 12 that is not laminated as described above.

A piezoelectric speaker 50 is a flat plate type piezoelectric speaker formed of the piezoelectric element 42 (piezoelectric film 12) according to the embodiment of the present invention as a vibration plate that converts an electrical signal into vibration energy. Further, the piezoelectric speaker 50 can also be used as a microphone, a sensor, or the like. Further, this piezoelectric speaker can also be used as a vibration sensor.

The piezoelectric speaker 50 is configured to include the piezoelectric element 42, a case 52, a viscoelastic support 56, and a frame 58.

The case 52 is a thin housing formed of plastic or the like and having one surface that is open. Examples of the shape of the housing include a rectangular parallelepiped shape, a cubic shape, and a cylindrical shape.

Further, the frame 58 is a frame material that has, in the center thereof, a through-hole having the same shape as the open surface of the case 52 and engages with the open surface side of the case 52.

The viscoelastic support 56 is a support used for efficiently converting the stretch and contraction movement of the piezoelectric element 42 into a forward and rearward movement by means of having appropriate viscosity and elasticity, supporting the piezoelectric element 42, and applying a constant mechanical bias to any place of the piezoelectric film. Examples of the viscoelastic support 56 include wool felt, nonwoven fabric such as wool felt containing PET, and glass wool. Further, the forward and rearward movement of the film is a movement of the film in a direction perpendicular to the surface.

The piezoelectric speaker 50 accommodates the viscoelastic support 56 in the case 52 to cover the case 52 and the viscoelastic support 56 with the piezoelectric element 42. Further, the piezoelectric speaker is configured by fixing the frame 58 to the case 52 in a state in which the periphery of the piezoelectric element 42 is pressed against the upper end surface of the case 52 by the frame 58.

Here, in the piezoelectric speaker 50, the viscoelastic support 56 has a shape in which the height (thickness) is greater than the height of the inner surface of the case 52.

Therefore, in the piezoelectric speaker 50, the viscoelastic support 56 is held in a state of being thinned by the viscoelastic support 56 being pressed downward by the piezoelectric element 42 at the peripheral portion of the viscoelastic support 56. Similarly, in the peripheral portion of the viscoelastic support 56, the curvature of the piezoelectric element 42 suddenly fluctuates, and a rising portion that decreases in height toward the periphery of the viscoelastic support 56 is formed in the piezoelectric element 42. Further, the central region of the piezoelectric element 42 is pressed by the viscoelastic support 56 having a square columnar shape and has a (approximately) planar shape.

In the piezoelectric speaker 50, in a case where the piezoelectric element 42 is stretched in the plane direction due to the application of a driving voltage to the first electrode 24 and the second electrode 26, the rising portion of the piezoelectric element 42 changes the angle in a rising direction due to the action of the viscoelastic support 56 in order to absorb the stretched part. As a result, the piezoelectric element 42 having the planar portion moves upward.

On the contrary, in a case where the piezoelectric element 42 contracts in the plane direction due to the application of the driving voltage to the second electrode 26 and the first electrode 24, the rising portion of the piezoelectric element 42 changes the angle in a falling direction, that is, a direction approaching the flat surface in order to absorb the contracted part. As a result, the piezoelectric element 42 having the planar portion moves downward.

The piezoelectric speaker 50 generates a sound by the vibration of the piezoelectric element 42.

In the piezoelectric element 42 according to the embodiment of the present invention, the conversion from the stretching and contracting movement to vibration can also be achieved by maintaining the piezoelectric element 42 in a curved state.

Therefore, the piezoelectric element 42 according to the embodiment of the present invention can function as a piezoelectric speaker having flexibility, a vibration sensor, or the like by being simply maintained in a curved state instead of the piezoelectric speaker 50 having rigidity in a flat plate shape, as illustrated in Fig. 16.

The piezoelectric speaker formed of the piezoelectric element 42 can be stored in a bag or the like by, for example, being rolled or folded using the satisfactory flexibility. Therefore, with the piezoelectric element 42 according to the embodiment of the present invention, a piezoelectric speaker that can be easily carried even in a case where the piezoelectric speaker has a certain size can be realized.

Further, as described above, the piezoelectric element 42 has excellent elasticity and excellent flexibility, and has no in-plane anisotropy as a piezoelectric characteristic. Therefore, in the piezoelectric element 42, a change in acoustic quality regardless of the direction in which the element is bent is small, and a change in acoustic quality with respect to the change in curvature is also small. Accordingly, the piezoelectric speaker formed of the piezoelectric element 42 has a high degree of freedom of the installation place and can be attached to various products as described above. For example, a so-called wearable speaker can be realized by attaching the piezoelectric element 42 to clothing such as a suit and portable items such as a bag in a curved state.

Further, the piezoelectric element according to the embodiment of the present invention can be used for various applications, such as a configuration in which a plurality of layers of the piezoelectric film are laminated, a configuration in which only one sheet of the piezoelectric film that is not laminated is provided, and a vibration sensor that vibrates or stretches and contracts to output electricity.

More specifically, the piezoelectric element according to the embodiment of the present invention can be suitably used as, for example, various sensors, acoustic devices, ultrasonic transducers, actuators, damping materials, and vibration power generators.

Examples of sensors include ultrasonic sensors, pressure sensors, tactile sensors, strain sensors, and vibration sensors.

Examples of acoustic devices include microphones, pickups, speakers, and exciters. More specifically, examples of the applications thereof include noise cancellers, artificial vocal cords, buzzers for preventing insects and pests from entering, furniture, wallpaper, signage, and the like.

Examples of ultrasonic transducers include ultrasonic probes and hydrophones. Examples of actuators include actuators used for prevention of water droplet adhesion, transport, stirring, polishing, haptics, and the like. Examples of the haptics include automobiles, smartphones, and games.

Examples of the damping materials include dampening materials (dampers) used for containers, vehicles, buildings, and sports equipment such as skis and rackets.

Further, examples of the vibration power generators include vibration power generators used by being applied to roads, floors, mattresses, chairs, shoes, tires, wheels, and computer keyboards.

As described above, in the piezoelectric element and the piezoelectric speaker according to the embodiment of the present invention, the configuration of the connecting portion is not limited to the examples illustrated in Figs. 8 and 9.

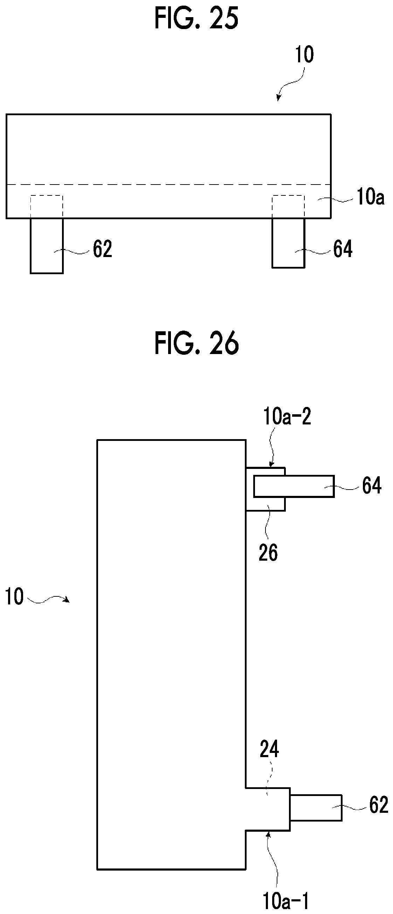

As another preferable example, as illustrated in Figs. 24 and 25, the first electrode 24 and the second electrode 26 are exposed and used as a connecting portion without providing the piezoelectric layer 20 at an end portion of the piezoelectric film 12 at a position where the connecting portion such as the protruding portion 10a is formed. That is, the electrode layer is exposed, and the lead-out wire 62 and the lead-out wire 64 may be respectively connected to the exposed first electrode 24 and the exposed second electrode 26.

Similarly to the example illustrated in Fig. 9, the contact portion between the electrode layer and the lead-out wire is the connecting portion in the present invention even in the present example.

In addition, in the configuration in which the first electrode 24 and the second electrode 26 are exposed and used as the connecting portions without providing the piezoelectric layer 20 at an end portion of the piezoelectric film 12, it is preferable that an insulating layer is provided between the lead-out wire 62 and the exposed first electrode 24 and between the lead-out wire 64 and the exposed second electrode 26.

Here, the connecting portions for connecting the lead-out wire 62 and the lead-out wire 64 with the first electrode 24 and the second electrode 26 of the piezoelectric element 10 (piezoelectric film 12) are portions where the current density rises rapidly and are likely to generate heat.

Therefore, it is preferable that the area of the contact portion where the lead-out wire and the connecting portion contact with each other is large. That is, as illustrated in Fig. 9, Fig. 24, and Fig. 25, in a case where the lead-out wires and the electrode layers are connecting portions that are directly in contact with each other, it is preferable that the contact area between the electrode layers and the lead-out wires is large. Further, in a case of the connecting portion 40 for connecting the lead-out wire with the electrode layer via the conductive material 40a as illustrated in Figs. 3, 8, and 13, it is preferable that the contact area between the conductive material 40a, that is, the through-hole and the lead-out wire A is large.

In the following description, the area of the contact portion where the lead-out wire and the connecting portion are in contact is also simply referred to as "contact area between the lead-out wire and the connecting portion".

By widening the contact area between the lead-out wire and the connecting portion, heat is dispersed to prevent the lead-out wire 62 and the piezoelectric film 12 from being partially heated to a high temperature.

It is preferable that the contact area between the lead-out wire and the connecting portion is large, but the present invention is not limited thereto.

Here, it is preferable that the contact area between the lead-out wire and the connecting portion is set according to the area of the piezoelectric film 12. The preferable contact area between the lead-out wire and the connecting portion is affected by the driving voltage, the thickness of the electrode layer, the resistance of the conductive material 40a, and the like, and the contact area between the lead-out wire and the connecting portion is, for example, 0.03% or greater of the area of the piezoelectric film 12. By setting the contact area between the lead-out wire and the connecting portion to 0.03% or greater of the area of the piezoelectric film 12, the heat is suitably dispersed to suitably prevent the lead-out wire 62 and the piezoelectric film 12 from being partially heated to a high temperature.

The contact area between the lead-out wire and the connecting portion is more preferably 0.2% or greater and still more preferably 0.6% or greater of the area of the piezoelectric film 12.

Further, the area of the piezoelectric film 12 is specifically the area of any one main surface (maximum surface) between the front surface and the rear surface of the piezoelectric film 12. Further, it is preferable that the contact area between the lead-out wire and the connecting portion is increased in proportion to the area of the piezoelectric film 12 according to the area of the piezoelectric film 12.

Further, the area of the piezoelectric film 12 is the area of the piezoelectric film 12 in a state where the piezoelectric film 12 is not folded, that is, the piezoelectric film 12 has spread in a case of the piezoelectric element 10 formed by folding the piezoelectric film 12 and laminating the folded layers of the piezoelectric film 12 as illustrated in Fig. 1. Further, the area of the piezoelectric film 12 is an area of each piezoelectric film in a case of the piezoelectric element formed by laminating a plurality of sheets of cut sheet-like piezoelectric films 12 as illustrated in Fig. 12, a case of the piezoelectric element having only one sheet of the piezoelectric film 12 as illustrated in Fig. 13, and a case of the piezoelectric speaker according to the embodiment of the present invention.

The contact area between the lead-out wire and the connecting portion is the contact area between the electrode layer and the lead-out wire in a case of the connecting portion in which the lead-out wire and the electrode layer are directly in contact with each other as illustrated in Figs. 9, 24, and 25. In addition, in the case of the connecting portion 40 that connects the lead-out wire with the electrode layer via the conductive material 40a illustrated in Figs. 3, 8, and 13, the contact area between the lead-out wire and the connecting portion 40 is the contact area between the through-hole and the lead-out wire. Here, in a case where a plurality of connecting portions 40 are provided as described below, the total contact area between all through-holes and the lead-out wires is defined as the contact area between the lead-out wire and the connecting portion.

In the examples illustrated in Figs. 9, 24, and 25, in a case where the width of the lead-out wire 62 and the lead-out wire 64 is large, the contact area between the connecting portion and the lead-out wire, that is, the contact area between the electrode layer and the lead-out wire also increases.

However, as conceptually illustrated in Fig. 26, even in a case where the first electrode 24 and the second electrode 26 are exposed without providing the piezoelectric layer 20, the width of the lead-out wire is restricted by the width of the protruding portion in a case where a protruding portion 10a-1 and a protruding portion 10a-2 are provided and the lead-out wire 62 and the lead-out wire 64 are provided here. Therefore, in a case where the protruding portion is provided, it cannot necessarily be said that the contact area between the electrode layer and the lead-out wire is increased due to an increase in width of the lead-out wire 62 and the lead-out wire 64. That is, in a case where a protruding portion is provided and a connecting portion is formed in the protruding portion to connect the lead-out wire, the width of the protruding portion is also important.

In addition, as described above, the width of the protruding portion is the length of the side on which the protruding portion is formed in the extension direction.

Even in consideration of this point, as described above, in a case where the length of the side on which the protruding portion is provided is defined as L and the width of the protruding portion is defined as La, the width La of the protruding portion is preferably 10% or greater, more preferably 50% or greater, still more preferably 70% or greater, particularly preferably 90% or greater of the length L of the side, and most preferably the same as or greater than or equal to the length L of the side.

The thickness of the piezoelectric layer 20 of the piezoelectric film 12 is preferably in a range of 10 to 300 $\mu$m, which is extremely small. Therefore, it is preferable that the lead-out wires are provided at different positions in the plane direction of the piezoelectric film 12 in order to prevent a short circuit. That is, it is preferable that the lead-out wire 62 and the lead-out wire 64 are offset in the plane direction of the piezoelectric film 12.

In addition, in the laminated piezoelectric element formed by folding and laminating the piezoelectric film, it is preferable that the lead-out wires serving as heat generating portions are separated from each other as much as possible in the width direction of the lead-out wires. That is, it is preferable that an interval b between the lead-out wire 62 and the lead-out wire 64 in the width direction is large as conceptually illustrated in Fig. 23.

Further, the width of the lead-out wire is the length of the side on which the lead-out wire is provided in the extension direction, similarly to the width of the protruding portion described above.

As described above, the piezoelectric element and the piezoelectric speaker (piezoelectric film) according to the embodiment of the present invention are provided with connecting portions corresponding to the side other than the shortest side of the polygon in the planar shape. For example, in a case where the planar shape of the piezoelectric element (piezoelectric film) is rectangular, connecting portions are provided on the corresponding long side to allow the current to flow from the long side, and the lead-out wires are connected.

Therefore, in the piezoelectric element according to the embodiment of the present invention, the width of the lead-out wires and the interval between the lead-out wires in the width direction can be widened, and heat generation can be suitably suppressed.

In the piezoelectric element and the piezoelectric speaker according to the embodiment of the present invention, the width of the lead-out wire is not limited, but it is preferable that the width thereof is large from the viewpoint of easily increasing the contact area the lead-out wire and the connecting portion.

In the piezoelectric element according to the embodiment of the present invention, it is preferable that the current density of the lead-out wires is set to 1 A/cm or less in order to suppress heat generation in the lead-out wires. The current density of the lead-out wire is a value obtained by dividing the current value [A] of the current flowing into the lead-out wire by the width [cm] of the lead-out wire.

In the piezoelectric element and the piezoelectric speaker according to the embodiment of the present invention, the width of the lead-out wire is preferably 10% or greater (1/10 or greater), more preferably 20% or greater, and still more preferably 30% or greater of the length of the side corresponding to the connecting portion provided on the piezoelectric element, that is, the length of the side on which the lead-out wire is provided. For example, as illustrated in Fig. 23, in a case where the length of the side on which the lead-out wire 64 is provided is 20 cm in the piezoelectric element, the width a of the lead-out wire 62 and the lead-out wire 64 is set to preferably 2 cm or greater.

Since the capacitance of the piezoelectric film 12 increases (the impedance decreases) as the size of the piezoelectric film 12 increases, the amount of current flowing into the piezoelectric film 12 with respect to the same applied voltage increases. However, the current density of the lead-out wire can be stably set to 1 A/cm or less by setting the width of the lead-out wire to 10% or greater of the side on which the lead-out wire is provided.

Further, the current density obtained by dividing the amount of current flowing into the lead-out wire by the cross-sectional area of the lead-out wire can be set to $1 \times 10^5 A/cm^2$ or less, which is preferable, by setting the thickness of the electrode layer to 0.1 $\mu$m or greater.

In the piezoelectric element and the piezoelectric speaker according to the embodiment of the present invention, the interval between the lead-out wires in the width direction is not limited, but it is preferable that the interval thereof increases as described above.

The interval between the lead-out wires in the width direction is preferably 25% or greater (1/4 or more), more preferably 30% or greater, and still more preferably 40% or greater of the length of the side on which the lead-out wires are provided. That is, in the example illustrated in Fig. 23, since the length of the side on which the lead-out wire is provided in the piezoelectric element is 20 cm, it is preferable that the interval b between the lead-out wire 62 and the lead-out wire 64 in the width direction is set to 5 cm or greater.

Further, Fig. 23 exemplifies the connecting portion illustrated in Figs. 9, 24 and 25, and the same applies to the connecting portion 40 obtained by filling the through-hole with the conductive material 40a illustrated in Figs. 3, 8, and 13.

In the connecting portion 40, the conductive material 40a includes metal paste such as the silver paste described above, a non-conductive paste-like material, and a material containing a conductive material as a filler such as flakes and particles.

As described above, in the connecting portion 40 obtained by providing a through-hole in the protective layer and filling the through-hole with the conductive material 40a, a plurality of connecting portions may be provided for one lead-out wire.

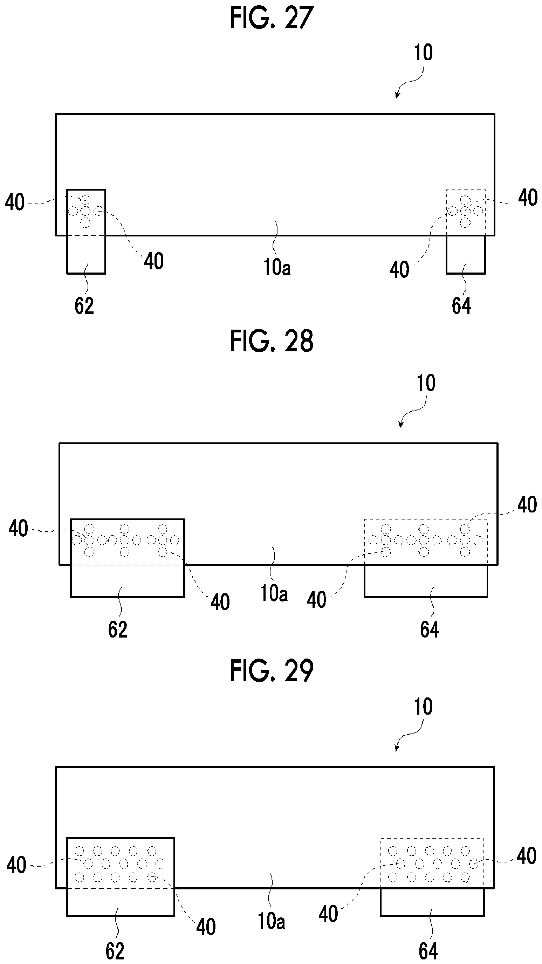

For example, as conceptually illustrated in Fig. 27, five connecting portions 40 may be provided for each of the lead-out wire 62 and the lead-out wire 64.

Here, in the piezoelectric element according to the embodiment of the present invention, it is preferable that the contact area between the connecting portion 40 (through-hole) and the lead-out wire increases. Further, from the viewpoint of suppressing heat generation, it is preferable that the width of the lead-out wire increases. Correspondingly, as conceptually illustrated in Fig. 28, it is preferable that the five connecting portions in Fig. 27 are aligned in the width direction of the lead-out wire to increase the contact area between the connecting portion 40 and the lead-out wire and to increase the width of the lead-out wire.

Further, as conceptually illustrated in Fig. 29, even in a case of the width of the same lead-out wire, it is more preferable to increase the number of connecting portions 40 to increase the contact area between the connecting portion 40 and the lead-out wire.

Further, as conceptually illustrated in Fig. 30, it is still more preferable that the width of the lead-out wire is increased as much as possible and as many connecting portions 40 as possible are provided in a portion the lead-out wire and the piezoelectric element (protruding portion 10a) overlap each other so that the lead-out wire 62 and the lead-out wire 64 do not overlap each other in the plane direction of the piezoelectric film 12.

The examples illustrated in Figs. 27 to 30 are examples in which the piezoelectric element 10 has the protruding portion 10a, and the same applies to the configuration in which the connecting portion 40 is formed without providing the protruding portion, similarly to the piezoelectric element illustrated in Fig. 13.

Hereinbefore, the piezoelectric element and the piezoelectric speaker according to the embodiment of the present invention have been described in detail, but the present invention is not limited to the above-described examples, and various improvements or modifications may be made within a range not departing from the scope of the present invention.

Examples

Hereinafter, the present invention will be described in more detail with reference to specific examples of the present invention.

[Preparation of piezoelectric film]

A piezoelectric film illustrated in Fig. 4 was prepared by the method illustrated in Figs. 5 to 7 described above.

First, cyanoethylated PVA (CR-V, manufactured by Shin-Etsu Chemical Co., Ltd.) was dissolved in methyl ethyl ketone (MEK) at the following compositional ratio. Thereafter, PZT particles were added to the solution at the following compositional ratio and dispersed using a propeller mixer (rotation speed of 2000 rpm), thereby preparing a coating material for forming a piezoelectric layer.

- PZT Particles: 1000 parts by mass
- Cyanoethylated PVA: 100 parts by mass
- MEK: 600 parts by mass

In addition, PZT particles obtained by sintering commercially available PZT raw material powder at 1000°C to 1200°C and crushing and classifying the sintered powder to have an average particle diameter of 3.5 $\mu$m were used as the PZT particles.

Further, a sheet-like material illustrated in Fig. 5 was prepared by vacuum vapor deposition of a copper thin film having a thickness of 0.1 $\mu$m on a PET film having a width of 23 cm and a thickness of 4 $\mu$m. That is, in the present example, the second electrode layer and the first electrode layer are copper vapor deposition thin films having a thickness of 0.1 m, and the second protective layer and the first protective layer are PET films having a thickness of 4 $\mu$m.

In order to obtain satisfactory handleability during the process, a film with a separator (temporary support PET) having a thickness of 50 $\mu$m was used as the PET film, and the separator of each protective layer was removed after the thermal compression bonding of the thin film electrodes and the protective layers.

The first electrode (copper-deposited thin film) of the sheet-like material was coated with the coating material for forming the piezoelectric layer prepared in advance using a slide coater. Further, the first electrode was coated such that the film thickness of the coating film after being dried reached 40 $\mu$m.

Next, a material obtained by coating the sheet-like material with the coating material was heated and dried on a hot plate at 120°C to evaporate MEK. In this manner, a laminate in which the first electrode made of copper was provided on the first protective layer made of PET and the piezoelectric layer having a thickness of 40 $\mu$m was formed thereon was prepared as illustrated in Fig. 6.

Next, the piezoelectric layer of the laminate was subjected to a polarization treatment according to the above-described method. The polarization treatment was performed so that the polarization direction was the thickness direction of the piezoelectric layer.

As illustrated in Fig. 7, the same sheet-like material formed by vacuum vapor deposition of a copper thin film on a PET film was laminated on the laminate that had been subjected to the polarization treatment.

Next, the piezoelectric film as illustrated in Fig. 4 was prepared by performing thermal compression bonding on the laminate of the laminate and the sheet-shaped material at 120°C using a laminator device, bonding the piezoelectric layer to the second electrode and the first electrode, and sandwiching the piezoelectric layer between the second electrode and the first electrode so that the laminate was sandwiched between the second protective layer and the first protective layer.

[Example 1]

The prepared piezoelectric film was cut into a size of 20 × 27 cm.

This piezoelectric film was folded four times in a direction of 27 cm at intervals of 5 cm. Further, the adjacent layers of the piezoelectric film were bonded to each other with a bonding layer in the region where the piezoelectric film was laminated. An adhesive sheet with a thickness of 25 μm (LIOELM TSU0041SI, manufactured by Toyochem Co., Ltd.) was used as the bonding layer. The same material was used as the bonding layer in other examples.

In this manner, a laminate as illustrated in Figs. 1 to 3, in which the piezoelectric film was folded and five layers of the piezoelectric film were laminated and a protruding portion protruding from a long side by 2 cm in a rectangular planar shape with a size of 5 × 20 cm, was prepared. Therefore, in the present example, the ridge line formed by folding the film coincides with the long side of the rectangular planar shape.

A through-hole having a diameter of 5 mm was formed by a carbon dioxide laser on both sides of the protective layer of the protruding portion of the prepared laminate. Next, a piezoelectric element as illustrated in Figs. 1 to 3 was prepared by filling the through-hole with silver paste to form a connecting portion for connecting the first electrode and the second electrode with the external power supply. The connecting portion was positioned such that the center of the circle was separated by 9 cm from an end portion of the rectangle in the longitudinal direction and by 1 cm from an end portion in the lateral direction. The interval between the connecting portions of the rectangle in the longitudinal direction was 2 cm.

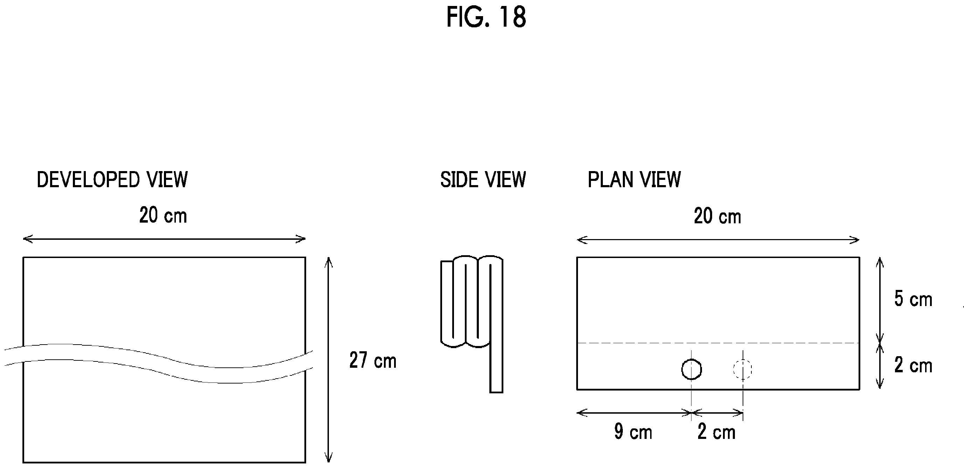

Fig. 18 conceptually illustrates a plan view and a side view of the shape (developed view) of the cut piezoelectric film and the prepared piezoelectric element.

Copper foil tape was bonded to the connecting portion as a lead-out wire.

[Comparative Example 1]

The produced piezoelectric film was cut into a size of 102 × 5 cm.

This piezoelectric film was folded four times in a direction of 102 cm at intervals of 20 cm. The adjacent layers of the piezoelectric film were bonded to each other with a bonding layer in the region where the piezoelectric film was laminated.

In this manner, a laminate in which the piezoelectric film was folded and five layers of the piezoelectric film were laminated and a protruding portion protruding from a short side by 2 cm in a rectangular planar shape with a size of 5 × 20 cm was prepared. Therefore, in the present example, the ridge line formed by folding the film coincides with the short side of the rectangular planar shape.

A connecting portion for connecting the first electrode and the second electrode with the external power supply was formed on both surfaces of the protective layer of the protruding portion of the prepared laminate in the same manner as in Example 1, thereby preparing a piezoelectric element. The connecting portion was positioned such that the center of the circle was separated by 1 cm from an end portion of the rectangle in the lateral direction and by 1 cm from an end portion in the longitudinal direction.

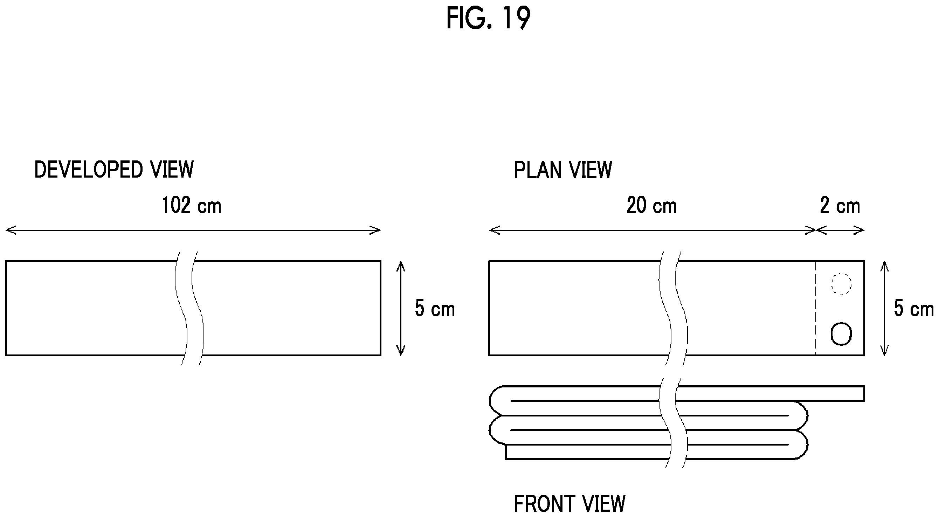

Fig. 19 conceptually illustrates a plan view and a side view of the shape (developed view) of the cut piezoelectric film and the prepared piezoelectric element.

Copper foil tape was bonded to the connecting portion as a lead-out wire.

[Comparative Example 2]

The prepared piezoelectric film was cut into a rectangular shape (main body) of 25 × 20 cm with a shape having a rectangular protruding portion with a size of 2 × 5 cm at an end portion of one long side in the longitudinal direction. The long and short sides of the protruding portion were allowed to coincide with the main body.

This piezoelectric film was folded four times in a direction of 25 cm at intervals of 5 cm. The adjacent layers of the piezoelectric film were bonded to each other with a bonding layer in the region where the piezoelectric film was laminated.

In this manner, a laminate in which the piezoelectric film was folded and five layers of the piezoelectric film were laminated and a protruding portion protruding from a short side by 2 cm in a rectangular planar shape with a size of 5 × 20 cm was prepared. Therefore, in the present example, the ridge line formed by folding the film coincides with the long side of the rectangular planar shape.

A connecting portion for connecting the first electrode and the second electrode with the external power supply was formed on both surfaces of the protective layer of the protruding portion of the prepared laminate in the same manner as in Example 1, thereby preparing a piezoelectric element. The connecting portion was positioned such that the center of the circle was separated by 1 cm from an end portion of the rectangle in the lateral direction and by 1 cm from an end portion in the longitudinal direction.

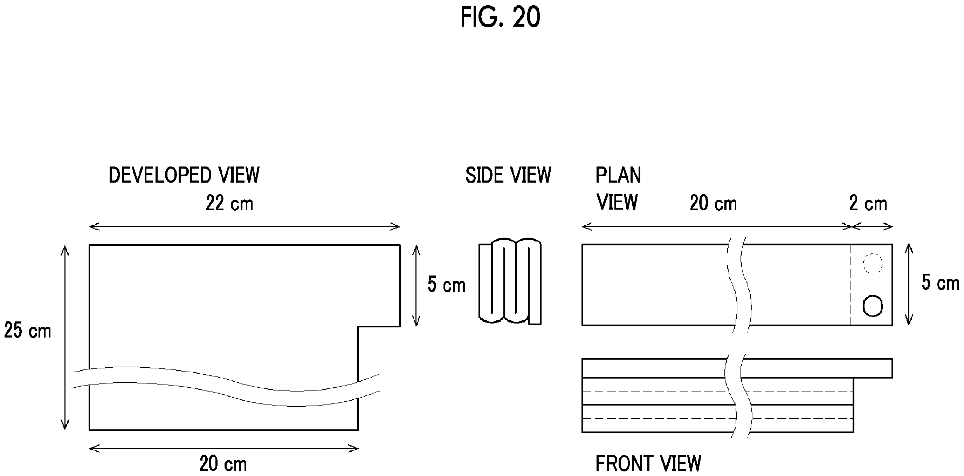

Fig. 20 conceptually illustrates a plan view, a side view, and a front view of the shape (developed view) of the cut piezoelectric film and the prepared piezoelectric element.

Copper foil tape was bonded to the connecting portion as a lead-out wire.

[Example 2]

The prepared piezoelectric film was cut into a rectangular shape (main body) of $5 \times 100$ cm with a shape having a rectangular protruding portion with a size of $2 \times 20$ cm at an end portion of one long side in the longitudinal direction. The long and short sides of the protruding portion were allowed to coincide with the main body.

This piezoelectric film was folded four times in the direction of 100 cm at intervals of 20 cm. The adjacent layers of the piezoelectric film were bonded to each other with a bonding layer in the region where the piezoelectric film was laminated.

In this manner, a laminate in which the piezoelectric film was folded and five layers of the piezoelectric film were laminated and a protruding portion protruding from a long side by 2 cm in a rectangular planar shape with a size of $5 \times 20$ cm was prepared. Therefore, in the present example, the ridge line formed by folding the film coincides with the short side of the rectangular planar shape.

A connecting portion for connecting the first electrode and the second electrode with the external power supply was formed on both surfaces of the protective layer of the protruding portion of the prepared laminate in the same manner as in Example 1, thereby preparing a piezoelectric element. The connecting portion was positioned such that the center of the circle was separated by 9 cm from an end portion of the rectangle in the longitudinal direction and by 1 cm from an end portion in the lateral direction. The interval between the connecting portions of the rectangle in the longitudinal direction was 2 cm.

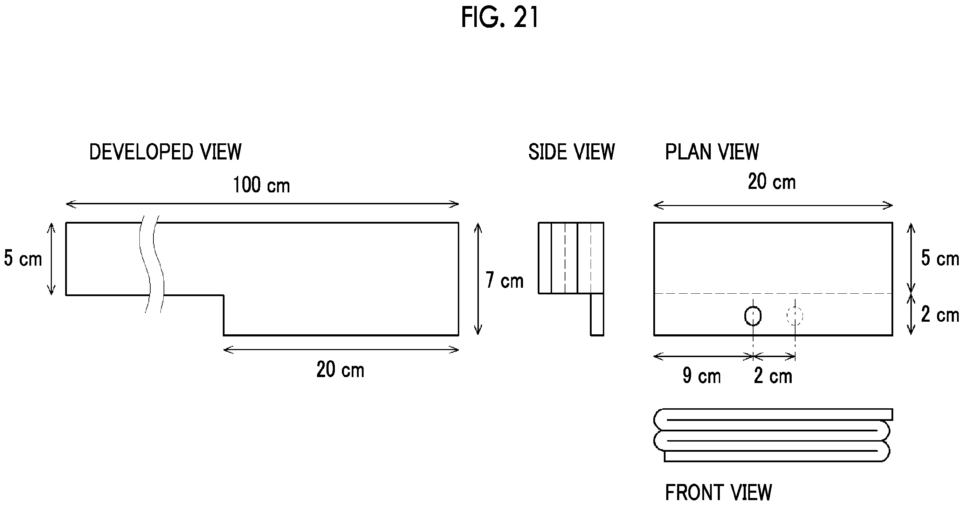

Fig. 21 conceptually illustrates a plan view, a side view, and a front view of the shape (developed view) of the cut piezoelectric film and the prepared piezoelectric element.

Copper foil tape was bonded to the connecting portion as a lead-out wire.

[Example 3]

A piezoelectric element was prepared, a connecting portion was formed on a protruding portion, and copper foil tape was bonded to the connecting portion as a lead-out wire in the same manner as in Example 1 except that the position of the connecting portion forming the protruding portion was changed to a position separated by 1 cm from an end portion in the longitudinal direction in Example 1. The interval between the connecting portions of the rectangle in the longitudinal direction was 18 cm.

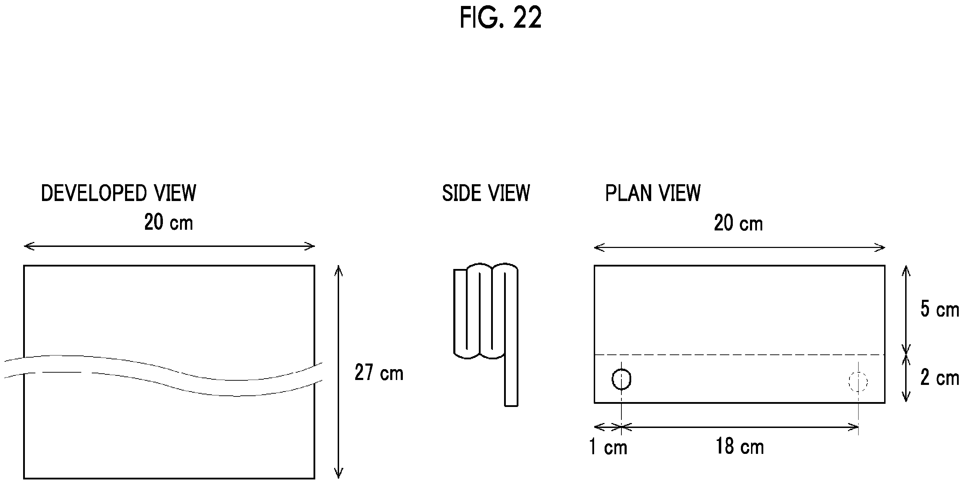

Fig. 22 conceptually illustrates a side view and a front view of the shape (developed view) of the cut piezoelectric film and the prepared piezoelectric element.

[Evaluation]

The impedance, the sound pressure, and the capacitance of the prepared piezoelectric elements were measured.

<Measurement of impedance>

An impedance analyzer was connected to the lead-out wire of the prepared piezoelectric element, and the impedance of each piezoelectric element was measured at frequencies of 2 kHz, 5 kHz, 10 kHz, 15 kHz, and 20 kHz. The measurement voltage was set to 10 Vrms.

The results are listed in Table 1.

[Table 1]

| | Ridge line formed by folding | Protruding portion | Interval between connecting portions | Impedance [Ω] | | | | |
|---|---|---|---|---|---|---|---|---|
| | | | | 2 kHz | 5 kHz | 10 kHz | 15 kHz | 20 kHz |
| Example 1 | Long side | Long side | Narrow | 73 | 31 | 15 | 10 | 8 |
| Comparative Example 1 | Short side | Short side | Narrow | 79 | 34 | 18 | 13 | 11 |
| Comparative Example 2 | Long side | Short side | Narrow | 83 | 35 | 18 | 12 | 9 |
| Example 2 | Short side | Long side | Narrow | 67 | 29 | 15 | 11 | 8 |
| Example 3 | Long side | Long side | Wide | 71 | 30 | 15 | 10 | 7 |

As listed in Table 1, the piezoelectric element of the present invention having a protruding portion protruding from a long side of a rectangular planar shape and having a connecting portion for connection with an external power supply on the protruding portion can suppress the impedance to be lower than that of the piezoelectric element of each comparative example having a protruding portion protruding from a short side of the rectangle.

Moreover, as described in Example 1 and Example 3, the impedance does not change even in a case where the interval between the connecting portions is changed in the present invention.

<Measurement of sound pressure>

A PET film having a thickness of 300 μm and a size of 30 × 70 cm was prepared as a vibration plate.

The prepared piezoelectric element was bonded to the center of this vibration plate by making the longitudinal direction and the lateral direction coincide with each other. The vibration plate and the piezoelectric element were bonded to each other using double-sided tape (No. 5603, manufactured by Nitto Denko Corporation) having a thickness of 30 μm.

The vibration plate with a size of 30 × 70 cm was allowed to stand by supporting the short sides of the vibration plate. A microphone was installed at a position separated by 1 m from the center of the piezoelectric element in the normal direction (direction perpendicular to the PET film) on the side of the vibration plate (PET film), the laminated piezoelectric element was driven, and the sound pressure was measured at frequencies of 2 kHz, 5 kHz, 10 kHz, 15 kHz, and 20 kHz.

The input signal to the laminated piezoelectric element was set as a sweep sine wave (50 Vrms) at 20 to 20 kHz.

The results are listed in Table 2.

[Table 2]

| | Ridge line formed by folding | Protruding portion | Interval between connecting portions | Sound pressure [dB] | | | | |
|---|---|---|---|---|---|---|---|---|
| | | | | 2 kHz | 5 kHz | 10 kHz | 15 kHz | 20 kHz |
| Example 1 | Long side | Long side | Narrow | 86 | 72 | 76 | 83 | 84 |
| Comparative Example 1 | Short side | Short side | Narrow | 86 | 70 | 77 | 75 | 73 |
| Comparative Example 2 | Long side | Short side | Narrow | 85 | 70 | 74 | 77 | 77 |
| Example 2 | Short side | Long side | Narrow | 86 | 74 | 76 | 81 | 80 |
| Example 3 | Long side | Long side | Wide | 86 | 75 | 73 | 84 | 83 |

As listed in Table 2, the piezoelectric element of the present invention having a protruding portion protruding from a long side of a rectangular planar shape and having a connecting portion for connection with an external power supply on the protruding portion can obtain a high sound pressure by vibrating the vibration plate more suitably particularly in a high frequency region of 15 kHz or greater than that of the piezoelectric element of each comparative example having a protruding portion protruding from a short side of the rectangle.

Moreover, as described in Example 1 and Example 3, the sound pressure does not change even in a case where the interval between the connecting portions is changed in the present invention.

<Capacitance>

An LCR meter was connected to the lead-out wires of the piezoelectric elements to measure the capacitance of each piezoelectric element.
The results are listed in Table 3.

[Table 3]

| | Ridge line formed by folding | Protruding portion | Interval between connecting portions | Capacitance [μF] |
|---|---|---|---|---|
| Example 1 | Long side | Long side | Narrow | 1.05 |
| Comparative Example 1 | Short side | Short side | Narrow | 1 |
| Comparative Example 2 | Long side | Short side | Narrow | 1.01 |
| Example 2 | Short side | Long side | Narrow | 1.06 |
| Example 3 | Long side | Long side | Wide | 1.07 |

As listed in Table 3, the piezoelectric element of the present invention having a protruding portion protruding from a long side of a rectangular planar shape and having a connecting portion for connection with an external power supply on the protruding portion can obtain a high sound pressure since the impedance [Ω] at a frequency F[Hz] satisfies "[1/(6.28 × F × C)] + 1" or less.
Table 4 shows specific examples of the measured values [Ω] of the impedance at a frequency of 2 to 20 kHz, the threshold values [Ω] of the impedance at "[1/(6.28 × F × C)] + 1", and the values obtained by subtracting the measured values from the threshold values of the impedance using Example 3 as a representative example. In Example 3, the capacitance of the piezoelectric element was 1.07 μF (see Table 3). Table 4 also shows the measurement results of the sound pressure.
In a case where the value obtained by subtracting the measured value from the threshold value of the impedance is a positive value, the measured value is "[1/(6.28 × F × C)] + 1" or less.

[Table 4]

| | | Frequency | | | | |
|---|---|---|---|---|---|---|
| | | 2 kHz | 5 kHz | 10 kHz | 15 kHz | 20 kHz |
| Impedance | Measured value [Ω] | 71 | 30 | 15 | 10 | 7 |
| | Threshold value [Ω] | 75.4 | 30.8 | 15.9 | 10.9 | 8.4 |
| | Threshold value - measured value [Ω] | 4.4 | 0.8 | 0.9 | 0.9 | 1.4 |
| Sound pressure [dB] | | 86 | 75 | 73 | 84 | 83 |

As listed in Table 4, the impedance of the piezoelectric element of Example 3 over an entire frequency range of 2 to 20 kHz is "[1/(6.28 × F × C)] + 1" or less. As a result, the piezoelectric element of Example 3 outputs a high sound pressure over an entire frequency range of 2 to 20 kHz.
Further, in all the piezoelectric element and the piezoelectric film of the piezoelectric speaker of the present invention and those of Example 4 and the subsequent examples, the impedance [Ω] at a frequency of 2 to 20 kHz was similarly "[1/(6.28 × F × C)] + 1" or less.

[Example 4]

A piezoelectric element was prepared, a connecting portion was formed on a protruding portion, and copper foil tape was bonded to the connecting portion as a lead-out wire in the same manner as in Example 3 except that the piezoelectric film was cut into a size of 20 × 29 cm and protruding portions with a size of 2 cm were formed on the uppermost layer and the lowermost layer of the folded portions in Example 3.

That is, the piezoelectric element has 2 cm protruding portions protruding from both long sides of the rectangular planar shape with a size of 20 × 5 cm.

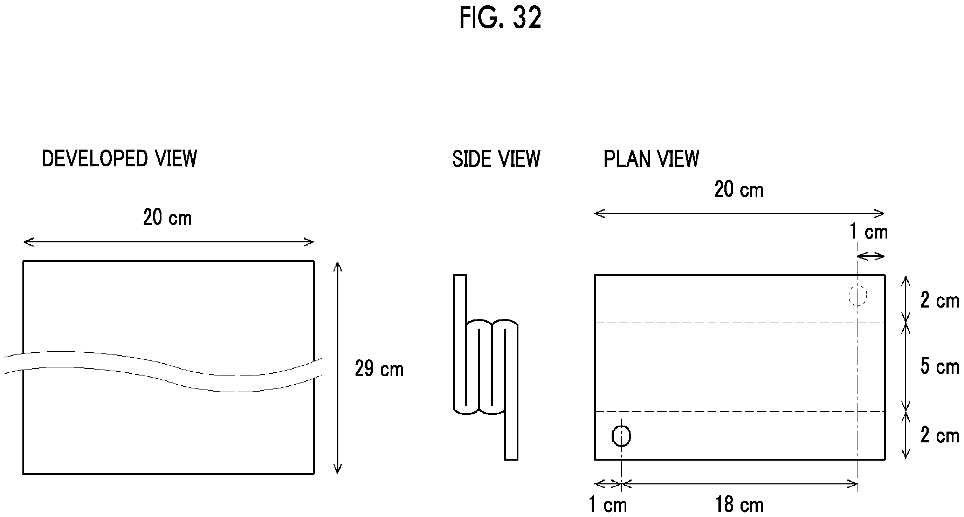

Fig. 32 conceptually illustrates a side view and a plan view of the shape (developed view) of the cut piezoelectric film and the prepared piezoelectric element.

The sound pressure of the prepared piezoelectric element was measured in the same manner as described above. The results are listed in Table 5. Table 5 also shows the sound pressure measurement results of Example 3 for reference.

[Table 5]

| | | | Frequency | | | | |
|---|---|---|---|---|---|---|---|
| | | Protruding portion | 2 kHz | 5 kHz | 10 kHz | 15 kHz | 20 kHz |
| Sound pressure [dB] | Example 4 | Long side | 86 | 75 | 73 | 87 | 83 |
| | Example 3 | Long side | 86 | 75 | 73 | 84 | 83 |

As listed in Table 5, a piezoelectric element capable of outputting a high sound pressure can be obtained by providing protruding portions on long sides even in a case where the sides where the protruding portions are formed are are changed to different sides of the planar shape.

[Example 5]

A piezoelectric element was prepared, a connecting portion was formed on a protruding portion, and copper foil tape was bonded to the connecting portion as a lead-out wire in the same manner as in Example 3 except that except that the 20 cm side was cut in half, the piezoelectric film was cut into a size of 10 × 27 cm, and the film was folded in a direction of 27 cm at intervals of 5 cm in Example 3. Therefore, the piezoelectric element has a rectangular planar shape with a size of 10 × 5 cm and has 2 cm protruding portions protruding from the long sides.

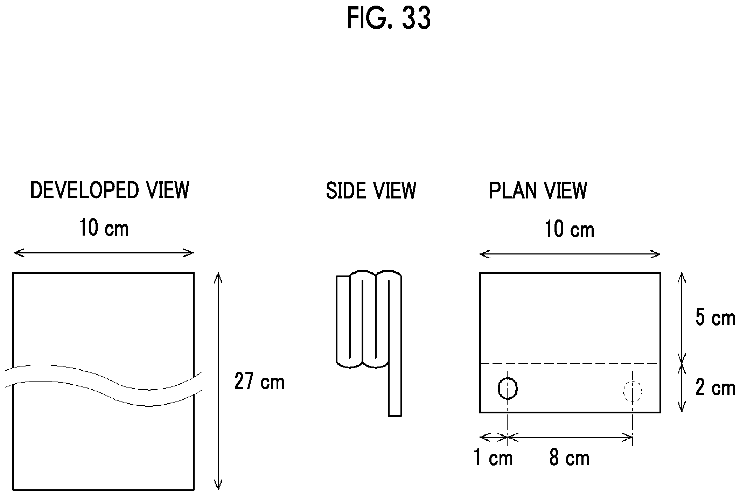

Fig. 33 conceptually illustrates a side view and a plan view of the shape (developed view) of the cut piezoelectric film and the prepared piezoelectric element.

[Comparative Example 5]

A piezoelectric element was prepared, a connecting portion was formed on a protruding portion, and copper foil tape was bonded to the connecting portion as a lead-out wire in the same manner as in Comparative Example 1 except that the piezoelectric film was cut into a size of 52 × 5 cm and folded at half intervals of 10 cm in a direction of 52 cm in Comparative Example 1. Therefore, the piezoelectric element has a rectangular planar shape with a size of 10 × 5 cm and has 2 cm protruding portions protruding from the short sides.

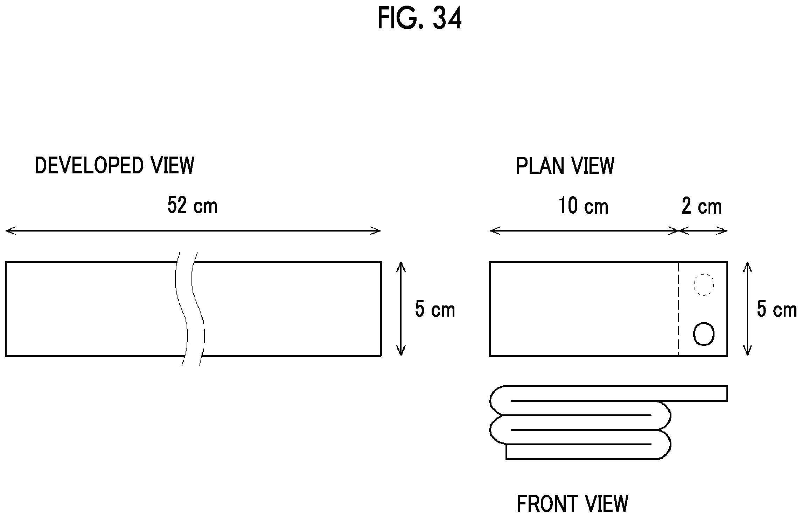

Fig. 34 conceptually illustrates a plan view and a front view of the shape (developed view) of the cut piezoelectric film and the prepared piezoelectric element.

The sound pressures of the piezoelectric elements prepared in Example 5 and Comparative Example 5 were measured in the same manner as described above.

The results are listed in Table 6.

[Table 6]

| | | | Frequency | | | | |
|---|---|---|---|---|---|---|---|
| | | Protruding portion | 2 kHz | 5 kHz | 10 kHz | 15 kHz | 20 kHz |
| Sound | Example 5 | Long side | 90 | 90 | 78 | 84 | 84 |
| pressure [dB] | Comparative Example 5 | Short side | 88 | 88 | 75 | 80 | 82 |

As listed in Table 6, the piezoelectric element of the present invention, which has a protruding portion projecting from the long side and has a connecting portion for connection with an external device, is capable of obtaining a high sound pressure as compared with the piezoelectric element of each comparative example having a protruding portion on a short side for connection with an external device.

[Example 6]

A piezoelectric film was cut into a size of 20 × 7 cm.

A bonding layer with a size of 20 × 5 cm was bonded to the cut piezoelectric film. The bonding layer was bonded such that the 20 cm sides were aligned and the piezoelectric film protruded from the 7 cm sides by 2 cm. Double-sided tape (No. 5603, manufactured by Nitto Denko Corporation) having a thickness of 30 μm was used as the bonding layer.

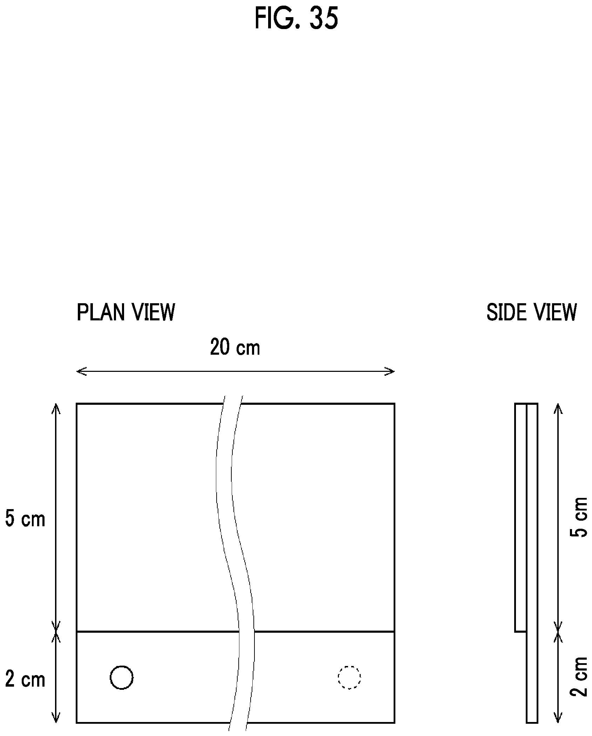

That is, the piezoelectric film had a rectangular planar shape of 20 × 5 cm and 2 cm protruding portions protruding from the long sides. A connecting portion was formed on the protruding portion in the same manner as in Example 3, and copper foil tape was bonded to the connecting portion as a lead-out wire. Fig. 35 conceptually illustrates a plan view and a side view of the laminate of the piezoelectric film and the bonding layer.

A PET film having a thickness of 300 μm and a size of 30 × 70 cm was prepared as a vibration plate. A piezoelectric speaker was prepared by allowing the longitudinal direction and the lateral direction to coincide with each other and bonding the bonding layer to the center of the vibration plate (see Fig. 31).

[Comparative Example 6]

A piezoelectric film was cut into a size of 22 × 5 cm.

A bonding layer with a size of 20 × 5 cm was bonded to the cut piezoelectric film. The bonding layer was bonded such that the 5 cm sides were aligned and the piezoelectric film protruded from the 22 cm sides by 2 cm. The same double-sided tape as described above was used as the bonding layer.

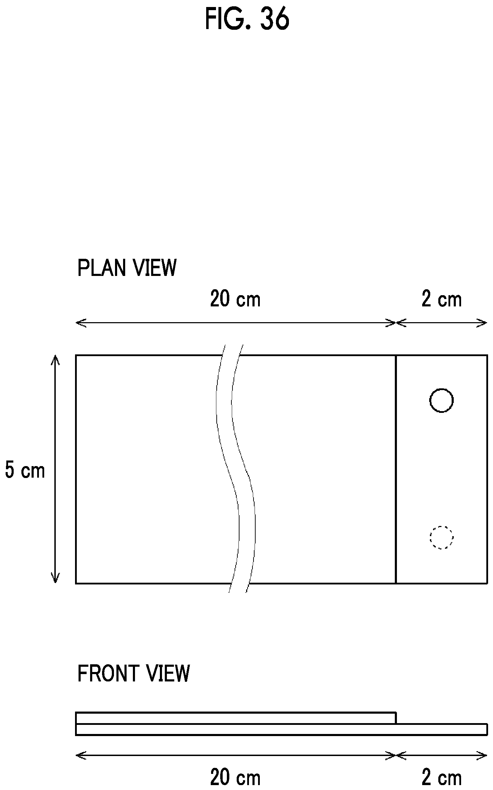

That is, the piezoelectric film had a rectangular planar shape of 20 × 5 cm and 2 cm protruding portions protruding from the short sides. A connecting portion was formed on the protruding portion in the same manner as in Comparative Example 1, and copper foil tape was bonded to the connecting portion as a lead-out wire. Fig. 36 conceptually illustrates a plan view and a side view of the laminate of the piezoelectric film and the bonding layer.

Thereafter, the vibration plate was bonded in the same manner as in Example 6, thereby preparing a piezoelectric speaker.

The sound pressures of the piezoelectric speakers prepared in Example 6 and Comparative Example 6 were measured under the same conditions as described above.

The results are listed in Table 7.

[Table 7]

| | | Protruding portion | Frequency | | | | |
| | | | 2 kHz | 5 kHz | 10 kHz | 15 kHz | 20 kHz |
|---|---|---|---|---|---|---|---|
| Sound | Example 6 | Long side | 85 | 82 | 69 | 82 | 83 |
| pressure [dB] | Comparative Example 6 | Short side | 85 | 82 | 66 | 77 | 76 |

[Example 7]

A piezoelectric film was cut into a size of 10 × 7 cm.

A bonding layer with a size of 10 × 5 cm was bonded to the cut piezoelectric film. The bonding layer was bonded such that the 10 cm sides were aligned and the piezoelectric film protruded from the 7 cm sides by 2 cm. The same double-sided tape as described above was used as the bonding layer.

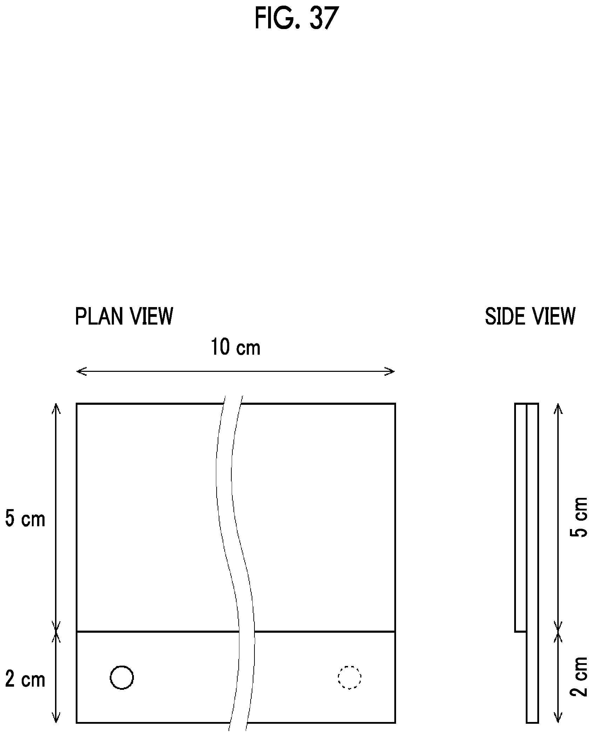

That is, the piezoelectric film had a rectangular planar shape of 10 × 5 cm and 2 cm protruding portions protruding from the long sides. A connecting portion was formed on the protruding portion in the same manner as in Example 3, and copper foil tape was bonded to the connecting portion as a lead-out wire. Fig. 37 conceptually illustrates a plan view and a side view of the laminate of the piezoelectric film and the bonding layer.

Thereafter, the vibration plate was bonded in the same manner as in Example 6, thereby preparing a piezoelectric speaker.

[Comparative Example 7]

A piezoelectric film was cut into a size of 12 × 5 cm.

A bonding layer with a size of 10 × 5 cm was bonded to the cut piezoelectric film. The bonding layer was bonded such that the 5 cm sides were aligned and the piezoelectric film protruded from the 12 cm sides by 2 cm. The same double-sided tape as described above was used as the bonding layer.

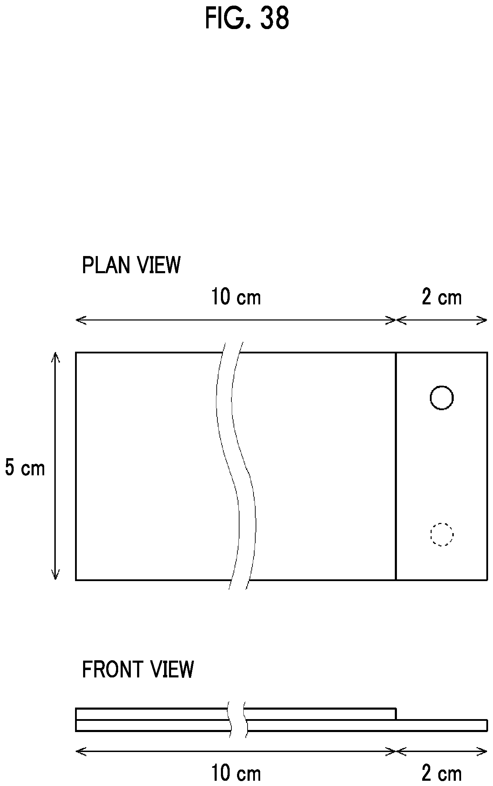

That is, the piezoelectric film had a rectangular planar shape of 10 × 5 cm and 2 cm protruding portions protruding from the short sides. A connecting portion was formed on the protruding portion in the same manner as in Comparative Example 1, and copper foil tape was bonded to the connecting portion as a lead-out wire. Fig. 38 conceptually illustrates a plan view and a front view of the laminate of the piezoelectric film and the bonding layer.

Thereafter, the vibration plate was bonded in the same manner as in Example 6, thereby preparing a piezoelectric speaker.

The sound pressures of the piezoelectric speakers produced in Example 7 and Comparative Example 7 were measured under the same conditions as described above.

The results are listed in Table 8.

[Table 8]

| | | | Frequency | | | | |
|---|---|---|---|---|---|---|---|
| | | Protruding portion | 2 kHz | 5 kHz | 10 kHz | 15 kHz | 20 kHz |
| Sound | Example 7 | Long side | 79 | 76 | 70 | 82 | 80 |
| pressure [dB] | Comparative Example 7 | Short side | 80 | 77 | 64 | 73 | 72 |

As listed in Tables 7 and 8, the piezoelectric speaker of the present invention having a protruding portion projecting from the long side and having a connecting portion for connection with an external device on the protruding portion even in a case where one layer of the piezoelectric film of the piezoelectric speaker is used as an exciter, is capable of obtaining a high sound pressure particularly in a high frequency range of 10 kHz or greater as compared with the piezoelectric speaker of each comparative example having a protruding portion on a short side for connection with an external device.

[Example 8 and Example 9]

A piezoelectric element was prepared in the same manner as in Example 4, a connecting portion was formed on the protruding portion, and copper foil tape was bonded to the connecting portion as a lead-out wire. That is, the piezoelectric element has a rectangular planar shape of 20 × 5 cm and has 2 cm protruding portions protruding from both long sides (see Fig. 32).

The sound pressure of the prepared piezoelectric element was measured by bonding the vibration plate in the same manner as described above.

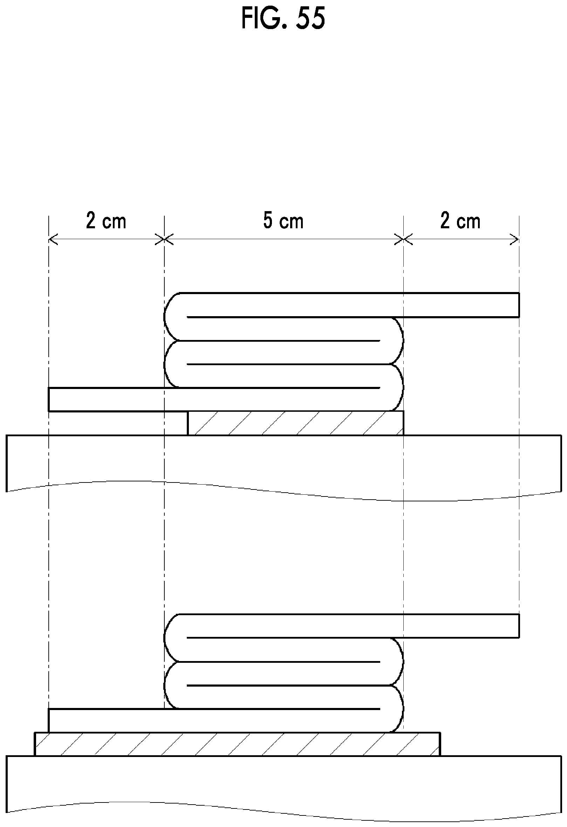

However, in Example 8, as conceptually illustrated in the upper part of Fig. 55, the vibration plate was bonded by providing a bonding layer (hatched portion) so as not to be bonded to the protruding portion. On the contrary, in Example 9, as illustrated in the lower part of Fig. 55, the vibration plate was bonded by providing a bonding layer (hatched portion) on the entire surface of the piezoelectric element including the protruding portion. In Fig. 55, the bonding layer for bonding adjacent layers of the piezoelectric film is not illustrated.

The results are listed in Table 9.

[Table 9]

| | | | Frequency | | | | |
|---|---|---|---|---|---|---|---|
| | | Protruding portion | 2 kHz | 5 kHz | 10 kHz | 15 kHz | 20 kHz |
| Sound | Example 8 | Non-bonding | 86 | 75 | 73 | 87 | 83 |
| pressure [dB] | Comparative Example 8 | Bonding | 86 | 72 | 69 | 82 | 78 |

As listed in Table 9, in Example 8 in which the protruding portion was not bonded to the vibration plate, satisfactory acoustic characteristics were exhibited even in a case where the same piezoelectric element having protruding portions was used, as compared with Example 9 in which the protruding portion was bonded to the vibration plate.

The piezoelectric element can be suitably used as an exciter, an electroacoustic transducer, a vibration sensor, a speaker, or the like which generate a sound by being brought into contact with various members.

Explanation of References

10, 10A, 10B, 42: piezoelectric element
10a, 10a-1, 10a-2, 10Aa, 10Ba: protruding portion
10a-1: first protruding portion
10a-2: second protruding portion
12: piezoelectric film
12a, 12c: sheet-like material
12b: laminate
14, 48: bonding layer
20: piezoelectric layer
24: first (thin film) electrode
26: second (thin film) electrode
28: first protective layer
28a, 30a: through-hole
30: second protective layer
34: matrix
36: piezoelectric particle
40: connecting portion
40a: conductive material
46: vibration plate
50: piezoelectric speaker
52: case
56: viscoelastic support
58: frame
62, 64: lead-out wire
70: piezoelectric speaker
70a: protruding portion

**Claims**

1.  A piezoelectric element which is configured such that a plurality of layers of a piezoelectric film in which a piezoelectric layer containing piezoelectric particles in a matrix containing a polymer material is sandwiched between electrode layers are laminated and that adjacent layers of the piezoelectric film are bonded to each other with a bonding layer,

    wherein a planar shape is a polygon, and
    the piezoelectric film has a protruding portion protruding from a side of a polygon other than a shortest side, and the protruding portion is provided with connecting portions for connecting an external power supply and the electrode layer.

2.  The piezoelectric element according to claim 1,
    wherein the piezoelectric element has a plurality of the protruding portions, and the plurality of the protruding portions protrude from an identical side of the polygon.

3.  The piezoelectric element according to claim 1 or 2,
    wherein the protruding portion protrudes from a longest side of the polygon.

4.  The piezoelectric element according to any one of claims 1 to 3,
    wherein in a case where a capacitance of the piezoelectric film is defined as C [F], an impedance [Ω] at a frequency F [Hz] is less than or equal to

$$[1/(6.28 \times F \times C)] + 1.$$

5.  The piezoelectric element according to any one of claims 1 to 4,

wherein the plurality of layers of the piezoelectric film are laminated by folding the piezoelectric film once or more times.

6. The piezoelectric element according to any one of claims 1 to 5,
wherein at least one layer of the piezoelectric film has a protective layer laminated on at least one of the electrode layers.

7. The piezoelectric element according to any one of claims 1 to 6,
wherein the piezoelectric layer contains the piezoelectric particles in a polymer material containing a cyanoethyl group.

8. The piezoelectric element according to claim 7,
wherein the polymer material is cyanoethylated polyvinyl alcohol.

9. A piezoelectric speaker comprising:

a piezoelectric film in which a piezoelectric layer containing piezoelectric particles in a matrix containing a polymer material is sandwiched between electrode layers and a planar shape is a polygon;
a vibration plate; and
a bonding layer bonding the piezoelectric film and the vibration plate to each other,
wherein the piezoelectric film has a protruding portion protruding from a side of the polygon other than a shortest side, and connecting portions for connecting an external power supply and the electrode layer are provided in the protruding portion.

## FIG. 1

## FIG. 2

# FIG. 3

# FIG. 4

# FIG. 5

# FIG. 6

## FIG. 7

## FIG. 8

## FIG. 9

28

62

24

10a

20

## FIG. 10

12

28(24,20,26,30)

40(40a)

10a-1

10

62

10a-2

40(40a)

64

14

FIG. 11

FIG. 12

# FIG. 13

# FIG. 14

# FIG. 15

## FIG. 16

## FIG. 17

# FIG. 18

**DEVELOPED VIEW**

20 cm

27 cm

**SIDE VIEW**

**PLAN VIEW**

20 cm

5 cm

2 cm

9 cm     2 cm

# FIG. 19

DEVELOPED VIEW

102 cm

5 cm

PLAN VIEW

20 cm

2 cm

5 cm

FRONT VIEW

EP 4 149 118 A1

FIG. 20

PLAN VIEW

SIDE VIEW

FRONT VIEW

DEVELOPED VIEW

5 cm

2 cm

20 cm

22 cm

25 cm

20 cm

5 cm

# FIG. 21

DEVELOPED VIEW

SIDE VIEW

PLAN VIEW

100 cm

20 cm

5 cm

7 cm

5 cm

2 cm

20 cm

9 cm

2 cm

FRONT VIEW

EP 4 149 118 A1

# FIG. 22

DEVELOPED VIEW

20 cm

27 cm

SIDE VIEW

PLAN VIEW

20 cm

5 cm

2 cm

1 cm

18 cm

EP 4 149 118 A1

## FIG. 23

10

62

a

20 cm

b

64

10a

## FIG. 24

10a

62    24    28    10    12

64    26    30    14

# FIG. 25

# FIG. 26

## FIG. 27

10

40

40

40

40

10a

62

64

## FIG. 28

10

40

40

40

40

10a

62

64

## FIG. 29

10

40

40

40

40

10a

62

64

FIG. 30

FIG. 31

# FIG. 32

DEVELOPED VIEW

SIDE VIEW    PLAN VIEW

20 cm

29 cm

20 cm

1 cm

2 cm

5 cm

2 cm

1 cm

18 cm

EP 4 149 118 A1

# FIG. 33

DEVELOPED VIEW

SIDE VIEW

PLAN VIEW

EP 4 149 118 A1

# FIG. 34

DEVELOPED VIEW

52 cm

5 cm

PLAN VIEW

10 cm   2 cm

5 cm

FRONT VIEW

# FIG. 35

PLAN VIEW

SIDE VIEW

20 cm

5 cm

2 cm

5 cm

2 cm

# FIG. 36

PLAN VIEW

20 cm

2 cm

5 cm

FRONT VIEW

20 cm

2 cm

# FIG. 37

PLAN VIEW

SIDE VIEW

10 cm

5 cm

2 cm

5 cm

2 cm

# FIG. 38

PLAN VIEW

10 cm    2 cm

5 cm

FRONT VIEW

10 cm    2 cm

## FIG. 39

## FIG. 40

# FIG. 41

# FIG. 42

12

40a
62

20
10a

40a
64

40a

62

12
10a

64

40a

# FIG. 43

# FIG. 44

# FIG. 45

# FIG. 46

# FIG. 47

# FIG. 48

# FIG. 49

# FIG. 50

64

40a

12

48

# FIG. 51

64

40a

48

12s

12

B

# FIG. 52

# FIG. 53

# FIG. 54

# FIG. 55

## INTERNATIONAL SEARCH REPORT

| International application No. |
| --- |
| PCT/JP2021/015843 |

**A.   CLASSIFICATION OF SUBJECT MATTER**
Int. Cl. H04R17/00(2006.01)i, H01L41/09(2006.01)i, H01L41/18(2006.01)i
FI: H04R17/00, H01L41/09, H01L41/18

According to International Patent Classification (IPC) or to both national classification and IPC

**B.   FIELDS SEARCHED**

Minimum documentation searched (classification system followed by classification symbols)
Int. Cl. H04R17/00, H01L41/09, H01L41/18

Documentation searched other than minimum documentation to the extent that such documents are included in the fields searched
Published examined utility model applications of Japan     1922-1996
Published unexamined utility model applications of Japan   1971-2021
Registered utility model specifications of Japan           1996-2021
Published registered utility model applications of Japan   1994-2021

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
| --- | --- | --- |
| Y<br>A | JP 2014-209724 A (FUJIFILM CORP.) 06 November 2014, paragraphs [0025]-[0072], fig. 1, 2 | 1-3, 5-9<br>4 |
| Y | WO 2018/020887 A1 (FUJIFILM CORP.) 01 February 2018, paragraphs [0029], [0030], fig. 4 | 1-3, 5-8 |
| Y | JP 61-81000 A (TOSHIBA CORP.) 24 April 1986, p. 2, lower left column, line 11 to p. 2, lower right column, line 19, fig. 4 | 1-3, 5-8 |
| Y | JP 2004-343453 A (SONY CORP.) 02 December 2004, paragraphs [0027], [0028], fig. 10 | 9 |
| A | JP 60-54486 A (TOSHIBA CORP.) 28 March 1985, entire text, all drawings | 1-9 |

☒   Further documents are listed in the continuation of Box C.          ☒   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>14.06.2021 | Date of mailing of the international search report<br>22.06.2021 |
| --- | --- |
| Name and mailing address of the ISA/<br>    Japan Patent Office<br>    3-4-3, Kasumigaseki, Chiyoda-ku,<br>    Tokyo 100-8915, Japan | Authorized officer<br><br><br>Telephone No. |

Form PCT/ISA/210 (second sheet) (January 2015)

**INTERNATIONAL SEARCH REPORT**

International application No.

PCT/JP2021/015843

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2015-070110 A (MURATA MANUFACTURING CO., LTD.) 13 April 2015, entire text, all drawings | 1-9 |

Form PCT/ISA/210 (continuation of second sheet) (January 2015)

**INTERNATIONAL SEARCH REPORT**

Information on patent family members

International application No.

PCT/JP2021/015843

| Patent Documents referred to in the Report | Publication Date | Patent Family | Publication Date |
|---|---|---|---|
| JP 2014-209724 A | 06.11.2014 | US 2016/0014527 A1 paragraphs [0077]-[0180], fig. 1-2C WO 2014/157006 A1 | |
| WO 2018/020887 A1 | 01.02.2018 | US 2019/0141433 A1 paragraphs [0102]-[0106], fig. 4 | |
| JP 61-81000 A | 24.04.1986 | (Family: none) | |
| JP 2004-343453 A | 02.12.2004 | (Family: none) | |
| JP 60-54486 A | 28.03.1985 | (Family: none) | |
| JP 2015-070110 A | 13.04.2015 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014014063 A
- JP 2016015354 A
- JP 7199813 A
- JP H7199813 A
- JP 2006023348 A